# EUROPEAN PATENT SPECIFICATION

(11) **EP 2 749 412 B1**
(45) Date of publication and mention of the grant of the patent: **14.09.2016**
(21) Application number: 14161363.8
(22) Date of filing: 15.01.2009
(51) Int. Cl.: B32B 37/26, H01L 51/52, B32B 37/10

(54) **Substrate lamination method**
Substratlaminierungsverfahren
Procédé de laminage d'un substrat

(30) Priority: 18.01.2008 US 9375; 18.01.2008 US 9472; 18.01.2008 US 9373; 18.01.2008 US 9393; 18.01.2008 US 9372; 18.01.2008 US 9482
(43) Date of publication of application: 02.07.2014
(62) Divisional of application: 09702309.7
(73) Proprietor: Rockwell Collins, Inc., Cedar Rapids, IA 52498 (US)
(72) Inventor: Barnidge, Tracy J., Marion, Iowa 52302 (US); Nemeth, Paul R., Springfield, Iowa 52403 (US); Sampica, James D., Springville, Iowa 52336 (US); Marzen, Vincent P., Robins, Iowa 52328 (US)
(74) Representative: Uexküll & Stolberg

(56) References cited:
- JP-A- 2006 222 267
- US-A- 5 592 288

## Description

### BACKGROUND

Liquid crystal display (LCD) screens and other monitors may require rigid or semi-rigid substrates to be coupled to the display. These substrates may serve many purposes including optical enhancements, protection from impact, or environmental concerns, or sometimes to improve thermal operating range, such as heating elements. As such, proper lamination of multiple substrates, such as a rigid glass substrate to an LCD screen, may be desirable.

From JP 2006 222267 A and US 5,592,288 a process for laminating substrates is known, the process comprising the steps of disposing a pressure-sensitive adhesive layer between a substantially planar surface of a first substrate and a substantially planar surface of a second substrate, disposing the first substrate, pressure-sensitive adhesive layer and second substrate within a vacuum chamber, evacuating the vacuum chamber, and applying pressure to at least one of the first substrate and the second substrate.

### SUMMARY

The present invention is directed to a process for laminating substrates as defined in claims 1 to 14.

### BRIEF DESCRIPTION OF THE DRAWINGS

The numerous advantages of the subject matter of the present disclosure may be better understood by those skilled in the art by reference to the accompanying figures.
FIG. 1 is an isometric view of a substrate lamination system according to an exemplary embodiment.
FIG. 2 is a cross-sectional view of a substrate lamination system according to an exemplary embodiment.
FIG. 3 top view of a substrate lamination system according to an exemplary embodiment.
FIG. 4 is an isometric view of a substrate lamination system according to an exemplary embodiment.
FIG. 5 is an isometric view of a substrate alignment insert according to an exemplary embodiment.
FIG. 6 is a top view of a substrate mask according to an exemplary embodiment.
FIG. 7 is a schematic view of a substrate lamination system according to an exemplary embodiment.
FIG. 8 is a high-level logic flowchart of a process according to an exemplary embodiment.
FIG. 9 is a high-level logic flowchart of a process depicting alternate implementations of FIG. 8 according to an exemplary embodiment.
FIG. 10 is a high-level logic flowchart of a process depicting alternate implementations of FIG. 8 according to an exemplary embodiment.
FIG. 11 is a high-level logic flowchart of a process depicting alternate implementations of FIG. 8 according to an exemplary embodiment.
FIG. 12 is a high-level logic flowchart of a process depicting alternate implementations of FIG. 8 according to an exemplary embodiment.
FIG. 13 is a high-level logic flowchart of a process depicting alternate implementations of FIG. 8 according to an exemplary embodiment.
FIG. 14 is a high-level logic flowchart of a process depicting alternate implementations of FIG. 8 according to an exemplary embodiment.
FIG. 15 is a high-level logic flowchart of a process depicting alternate implementations of FIG. 8 according to an exemplary embodiment.
FIG. 16 is a high-level logic flowchart of a process according to an exemplary embodiment.
FIG. 17 is a high-level logic flowchart of a process according to an exemplary embodiment.
FIG. 18 is a cross-sectional view of an apparatus/system for performing rigid-to-rigid substrate lamination processes implementing pressure-sensitive adhesive (PSA), said apparatus implementing a single flexible membrane applying pressure to multiple, discreet laminate assembly stacks in accordance with an exemplary embodiment.
FIG. 19 is a cross-sectional view of the apparatus shown in FIG. 1, said apparatus implementing a single flexible membrane applying pressure to multiple laminate assembly stacks, said multiple laminate assembly stacks having a common/shared substrate in accordance with an exemplary embodiment.
FIG. 20 is a cross-sectional view of an apparatus for performing rigid-to-rigid substrate lamination processes implementing pressure-sensitive adhesive (PSA), said apparatus having a plurality of sealed sub-cavities/pressure zones and a plurality of base receptacles in accordance with an alternative exemplary embodiment.
FIG. 21 is a cross-sectional view of an apparatus for performing rigid-to-rigid substrate lamination processes implementing pressure-sensitive adhesive (PSA), said apparatus having a plurality of sealed sub-cavities/pressure zones, said apparatus applying pressure(s) created within said sub-cavities/pressure zones to a plurality of laminate assembly stacks positioned within a sealed cavity formed by the base and the flexible membrane in accordance with an exemplary embodiment.
FIG. 22 is a cross-sectional view of the apparatus shown in FIG. 21, said view depicting application of pressure to a single laminate assembly stack in accordance with an exemplary embodiment.
FIG. 23 is a cross-sectional view of an apparatus for performing rigid-to-rigid substrate lamination processes implementing pressure-sensitive adhesive (PSA), said apparatus implementing multiple flexible membranes for applying pressure(s) to multiple, discreet (no shared layers between stacks) laminate assembly stacks in accordance with an exemplary embodiment.
FIG. 24 is a cross-sectional view of the apparatus shown in FIG. 23, said apparatus applying pressure(s) to a single laminate assembly stack in accordance with an exemplary embodiment.
FIG. 25 is a cross-sectional view of an apparatus for performing rigid-to-rigid substrate lamination processes implementing pressure-sensitive adhesive (PSA), said apparatus not implementing flexible membrane-applied pressure, but rather relying at least substantially on substrate weight and gas evacuation for applying pressure and for providing intimate substrate contact during said lamination processes in accordance with an exemplary embodiment.
FIGS 26A and 26B are cross-sectional views of an apparatus for performing rigid-to-rigid substrate lamination processes implementing pressure-sensitive adhesive (PSA), said apparatus including retractable pins, rods or the like for selectively providing separation between substrates/layers (FIG. 26A) and non-separation between substrates/layers (e.g., pins are retracted, as in FIG. 26B) in accordance with an exemplary embodiment.
FIG. 27 is a cross-sectional view of an apparatus for performing rigid-to-rigid substrate lamination processes implementing pressure-sensitive adhesive (PSA), said apparatus including retractable pins for providing selective separation between substrates/layers, said apparatus further including equalization ports for allowing selective pressure establishment (e.g., via slow leak) within the sealed sub-cavities in accordance with an exemplary embodiment.
FIG. 28 is a cross-sectional view of an apparatus for performing rigid-to-rigid substrate lamination processes implementing pressure-sensitive adhesive (PSA), said apparatus being oriented such that pressure(s) is/are applied along a horizontal plane/axis to multiple laminate assembly stacks in accordance with an exemplary embodiment.
FIG. 29 is a top view of an apparatus for performing rigid-to-rigid substrate lamination processes implementing pressure-sensitive adhesive (PSA), said apparatus including a plurality of sealed sub-cavities/pressure zones in accordance with an exemplary embodiment.
FIG. 30 is a cross-sectional view of an apparatus for performing rigid-to-rigid substrate lamination processes implementing pressure-sensitive adhesive (PSA), said apparatus being oriented such that pressures are applied in opposing directions against a laminate assembly stack via dual flexible membranes in accordance with an exemplary embodiment.
FIG. 31 is a flowchart illustrating a process for performing rigid-to-rigid substrate lamination implementing pressure-sensitive adhesive (PSA) in accordance with an exemplary embodiment.
FIG. 32 is a flowchart illustrating a process for performing rigid-to-rigid substrate lamination implementing pressure-sensitive adhesive (PSA) in accordance with an exemplary embodiment.
FIG. 33 is a flowchart illustrating a process for performing rigid-to-rigid substrate lamination implementing pressure-sensitive adhesive (PSA) in accordance with an exemplary embodiment.
FIG. 34 is a flowchart illustrating a process for performing rigid-to-rigid substrate lamination implementing pressure-sensitive adhesive (PSA) in accordance with an exemplary embodiment.
FIG. 35 is a flowchart illustrating a process for performing rigid-to-rigid substrate lamination implementing pressure-sensitive adhesive (PSA) in accordance with an exemplary embodiment.
FIG. 36A is an exploded isometric view illustrating a plurality of substrates utilized to form a display according to an exemplary embodiment.
FIG. 36B is an isometric view illustrating a display according to an exemplary embodiment.
FIG. 37 is a block diagram illustrating an alignment system according to an exemplary embodiment.
FIG. 38 is a block diagram illustrating an alignment system according to an exemplary embodiment.
FIG. 39 is a block diagram illustrating an alignment system according to an exemplary embodiment.
FIG. 40 is a method diagram illustrating a method for alignment according to an exemplary embodiment.
FIG. 41 is a method diagram illustrating a method for alignment according to an exemplary embodiment.
FIG. 42 is a partial isometric view illustrating a vertical planar substrate lamination apparatus according to an exemplary embodiment.
FIG. 43 is a cross-sectional side view illustrating a vertical planar substrate lamination apparatus according to an exemplary embodiment.
FIG. 44 is a partial cross-sectional side view illustrating a vertical planar substrate lamination apparatus according to an exemplary embodiment.
FIG. 45 is an isometric view illustrating a horizontal planar substrate lamination apparatus according to an exemplary embodiment.
FIG. 46 is a partial top view of a horizontal planar substrate lamination apparatus with an insert holder according to an exemplary embodiment.
FIG. 47A is an isometric view illustrating an insert holder for a horizontal planar substrate lamination apparatus according to an exemplary embodiment.
FIG. 47B is an isometric view illustrating an insert holder and a mask for a horizontal planar substrate lamination apparatus according to an exemplary embodiment.
FIG. 48 is a top view of an alignment aid for a planar substrate lamination apparatus according to an exemplary embodiment.
FIG. 49 is a top view of an alignment aid for a planar substrate lamination apparatus according to an exemplary embodiment.
FIG. 50 is a front view of a plurality of fiducial alignment markers according to an exemplary embodiment.
FIG. 51 is a view of a system for performing planarization treatment of pressure-sensitive adhesive (PSA) in accordance with an exemplary embodiment.
FIG. 52 is an exploded view of the planarization tool in accordance with an exemplary embodiment.
FIG. 53 is an exploded view of a PSA block which may be supported by the planarization tool in accordance with an exemplary embodiment.
FIG. 54 is a cutaway view illustrating the flexible membrane positioned on the planarization tool, said planarization tool supporting a plurality of PSA blocks in accordance with an exemplary embodiment.
FIG. 55 is a cross-sectional view of the planarization tool, PSA block(s) and flexible membrane when implemented with a pressurization tool, said view depicting the pressurization tool and flexible membrane in a non-contact position, in accordance with an exemplary embodiment.
FIG. 56 is a cross-sectional view of the planarization tool, PSA block(s) and flexible membrane when implemented with a pressurization tool, said view depicting the pressurization tool and flexible membrane in contact with each other during planarization of the PSA, said view further depicting the pressurization of the sealed cavity formed by the flexible membrane and the pressurization tool, said view still further depicting the vacuum being pulled from the sealed cavity formed by the flexible membrane and the planarization tool according to an exemplary embodiment.
FIG. 57 is a flow chart depicting a process for performing a planarization treatment of pressure-sensitive adhesive (PSA) in accordance with an exemplary embodiment.
FIG. 58 is a flow chart depicting a process for performing a planarization treatment of pressure-sensitive adhesive (PSA) in accordance with an alternative exemplary embodiment.
FIG. 59 is an isometric view of an apparatus for separating laminated substrates according to an exemplary embodiment.
FIG. 60 is an additional isometric view of an apparatus for separating laminated substrates according to an exemplary embodiment.
FIG. 61 is a further additional isometric view of an apparatus for separating laminated substrates according to an exemplary embodiment.
FIG. 62 is a side view of an apparatus for separating laminated substrates according to an exemplary embodiment.
FIG. 63 is a top view of an apparatus for separating laminated substrates according to an exemplary embodiment.
FIG. 64 is an isometric illustration of laminated substrates separated via the apparatus for separating laminated substrates according to an exemplary embodiment.
FIG. 65 is a block diagram of a system for separating laminated substrates according to an exemplary embodiment.
FIG. 66 is a flow diagram of a method for separating laminated substrates according to an exemplary embodiment.
FIG. 67 is an additional flow diagram of a method for separating laminated substrates according to an exemplary embodiment.
FIG. 68 is an isometric view of a portion of an adhesive layer and an insert configured to at least partially compress and deform the adhesive layer according to an exemplary embodiment.
FIG. 69 is an isometric view of a deformed adhesive layer coupled to a substrate according to an exemplary embodiment.
FIG. 70 is a side elevational view of portions of an OLED display manufactured according to an exemplary embodiment.
FIG. 71 is a perspective view of a fixture used according to an exemplary embodiment.
FIG. 72 is a sectional view taken along line 72-72 in FIG 70 during a manufacturing step according to an exemplary embodiment.
FIG. 73 is a detail view of FIG. 71 according to an exemplary embodiment.
FIG. 74 is a sectional view of the fixture during another manufacturing step according to an exemplary embodiment.
FIG. 75 is a sectional view of the fixture during still another manufacturing step according to an exemplary embodiment.
FIG. 76 is a perspective view of a plenum according to an exemplary embodiment.
FIG. 77 is a sectional view of the fixture and plenum during yet another manufacturing step according to an exemplary embodiment.
FIG. 78 is a sectional view of the fixture and plenum during another manufacturing step according to an exemplary embodiment.
FIG. 79 is a perspective view of an OLED display according to an exemplary embodiment.
FIG. 80 is a sectional view of a fixture according to an exemplary embodiment.
FIG. 81 is a sectional view of a fixture according to an exemplary embodiment.
FIG. 82 is a flowchart of a method according to an exemplary embodiment.

### DETAILED DESCRIPTION OF EXEMPLARY EMBODIMENTS

In the following detailed description, reference is made to the accompanying drawings, which form a part hereof. In the drawings, similar symbols typically identify similar components, unless context dictates otherwise. The illustrative embodiments described in the detailed description, drawings, and claims are not meant to be limiting. Other embodiments may be utilized, and other changes may be made, without departing from the spirit or scope of the subject matter presented here.

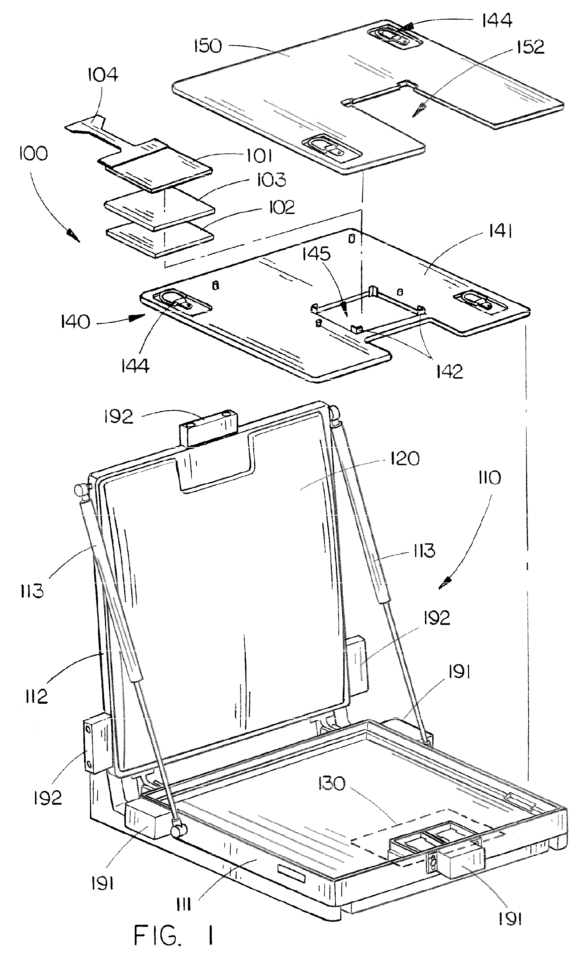

Referring now to FIGS. 1-17, FIG. 1 illustrates an example system in which one or more technologies may be implemented. A lamination system 100 may comprise a vacuum chamber 110, at least one flexible membrane 120, and a substrate support 130.

The vacuum chamber 110 may be any container which is capable of being sealed so as to separate a space interior to the vacuum chamber 110 from a space exterior to the vacuum chamber 110. For example, the vacuum chamber 110 may be a generally rectangular structure having a vacuum chamber body 111 and a vacuum chamber lid 112. The vacuum chamber 110 may be constructed of any number of materials having sufficient strength so as to maintain a vacuum such as aluminum, steel, carbon fiber, plastics, and the like.

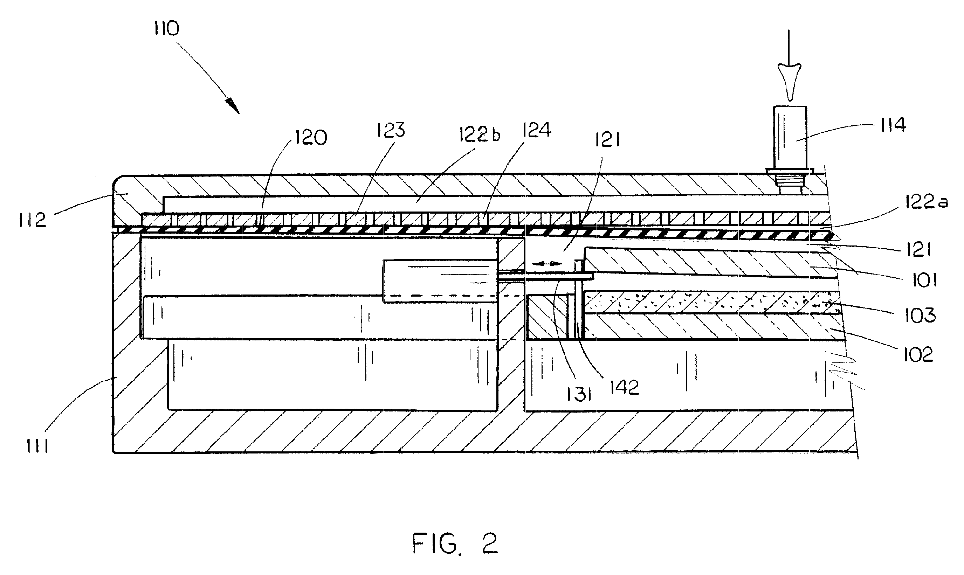

Referring now to FIG. 2, the flexible membrane 120 may be disposed within the vacuum chamber 110 so as to partition the vacuum chamber 110 into at least a first compartment 121 and a second compartment 122. For example, the flexible membrane 120 may be affixed to an underside of the vacuum chamber lid 112 by sealing the flexible membrane 120 about the periphery of the vacuum chamber lid 112 so as to partition the vacuum chamber 110 into a first compartment 121 formed by the flexible membrane 120 and the vacuum chamber body 111 and a second compartment 122 formed by the flexible membrane 120 and the vacuum chamber lid 112.

The second compartment 122 may comprise an expansion portion 122A and a plenum portion 122B separated by a perforated plenum diffuser screen 123. The perforated plenum diffuser screen 123 may serve to provide uniform distribution of airflow from the plenum portion 122B into the expansion portion 122A.

The flexible membrane 120 may be constructed from any flexible material capable of partitioning two compartments into separate pressure zones. For example, the flexible membrane 120 may be constructed of silicone rubber. The flexible membrane 120 may have one or more of the following physical characteristics: an elongation capacity of at least 100%; a tear strength of at least 30 psi; anti-static properties and/or an anti-static liner (e.g., polyester or polyethylene) disposed on one or more surfaces of the flexible membrane 120.

In other exemplary embodiments, the lamination system 100 may comprise at least one lid positioning mechanism 113. The lid positioning mechanism 113 may serve to maintain the vacuum chamber lid 112 in an open position with respect to the vacuum chamber body 111. The lid positioning mechanism 113 may comprise a gas cylinder mechanism as depicted in FIG. 1. In still further exemplary embodiments, the lid positioning mechanism 113 may comprise an actuated mechanism (e.g., a pneumatically actuated system, [not shown]) which may be extended or retracted manually or as part of an automated system controlled by a processing unit.

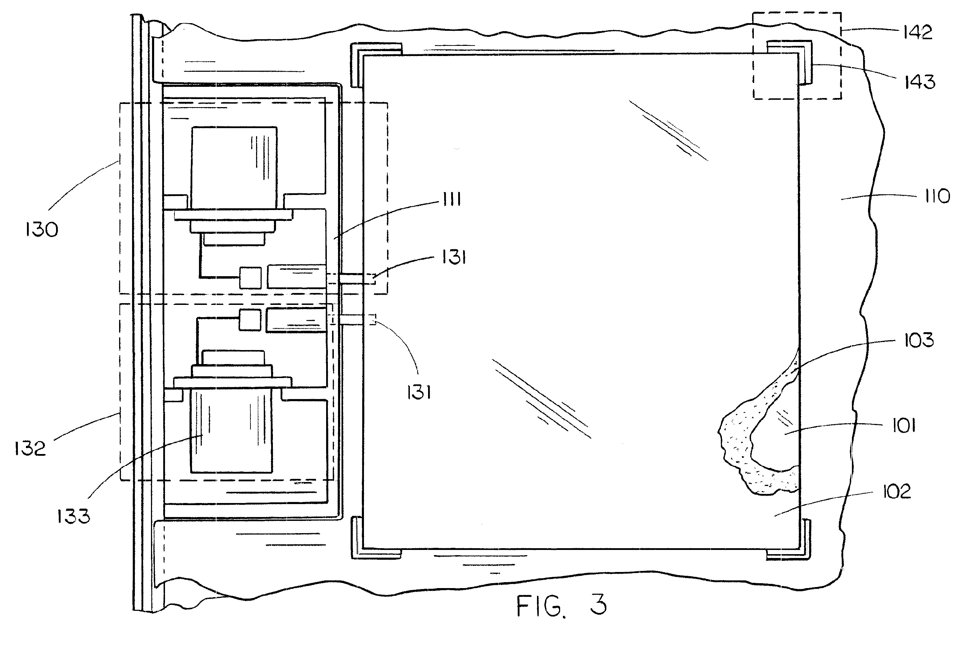

Referring now to FIGS. 3-17, the substrate support 130 may be any device/structure capable of maintaining a first substrate 101 and a second substrate 102 in spatial separation when disposed within the vacuum chamber 110. The substrate support 130 may maintain the first substrate 101 and/or the second substrate 102 in semi-horizontal positions as in FIG. 2. For example, the substrate support 130 may comprise at least one retractable support pin 131. The retractable support pin 131 may be disposed within and project from a wall of the vacuum chamber body 111. The retractable support pin 131 may be operably coupled to an actuating mechanism 132. Further, the use of any number of substrate supports 130 supporting any number of substrates is fully contemplated by the presently described embodiments.

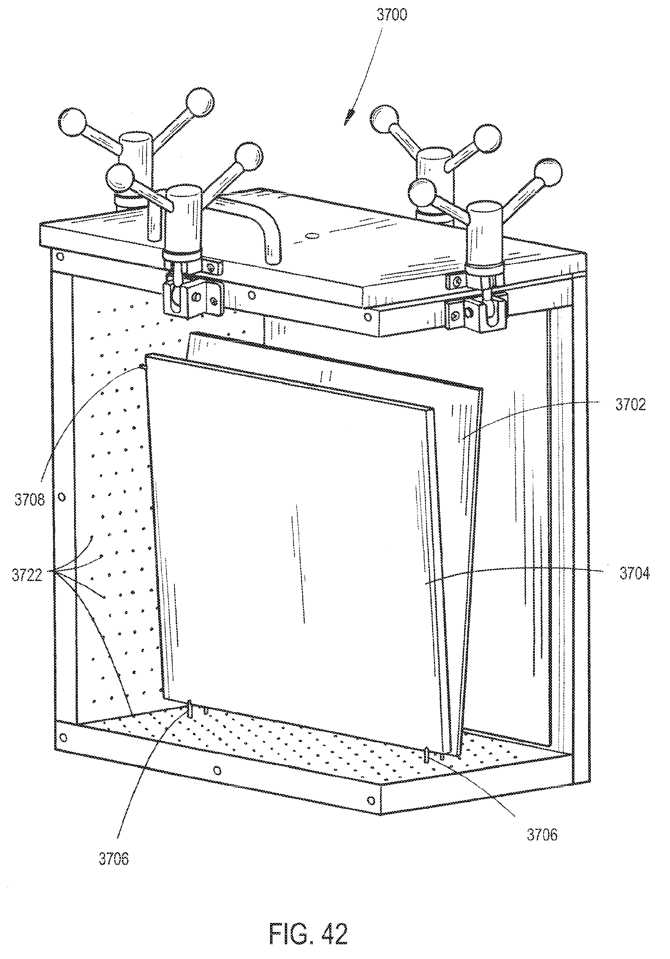

According to another exemplary embodiment, as shown in FIGS. 42-44, the substrate support 130 may maintain the first substrate and/or the second substrate in semi-vertical positions.

The cross-geometry of the tip of the retractable support pin 131 may be selected from any number of geometries including, but not limited to: cylindrical, square, hemispherical, trapezoidal, and the like. The geometry may be selected so as to minimize contact with a substrate while providing adequate substrate support.

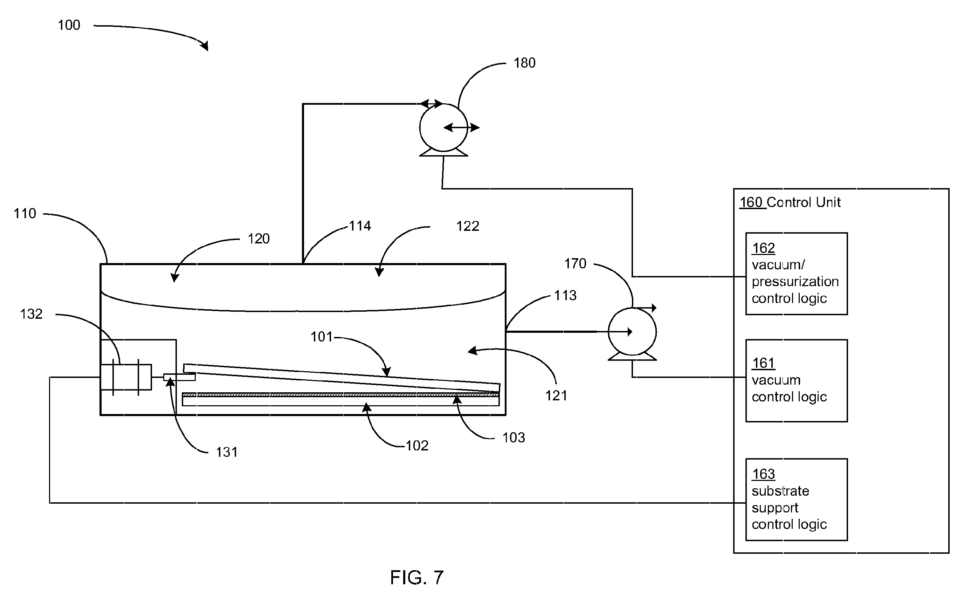

The actuating mechanism 132 may comprise a motor 133 configured to translate the retractable support pin 131 in and out of the vacuum chamber 110. The operation of the motor 133 and the corresponding insertion or retraction of the retractable support pin 131 may be controlled by a control unit 160, as shown in FIG. 7.

In other exemplary embodiments, the substrate support 130 may comprise a deformable support (e.g., a foam or putty structure; a spring structure) an electromagnetic support (e.g., an electromagnet operably couplable to a metallic element), retractable air cylinder or solenoid.

The first substrate 101 and/or second substrate 102 may be rigid or semi-rigid in nature such that, when supported by the substrate support 130, the first substrate 101 and/or second substrate 102 do not deform to a degree such that they contact a layer disposed in a horizontal plane beneath the first substrate 101 and/or second substrate 102, such as a pressure-sensitive adhesive layer 103. For example, the first substrate 101 may comprise a display monitor (e.g., an LCD, LCoS, or LED screen). The second substrate 102 may comprise an opaque rigid or semi-rigid reinforcing layer (e.g., glass, plastic). The pressure-sensitive adhesive layer 103 may comprise commonly known acrylic or silicone based polymers.

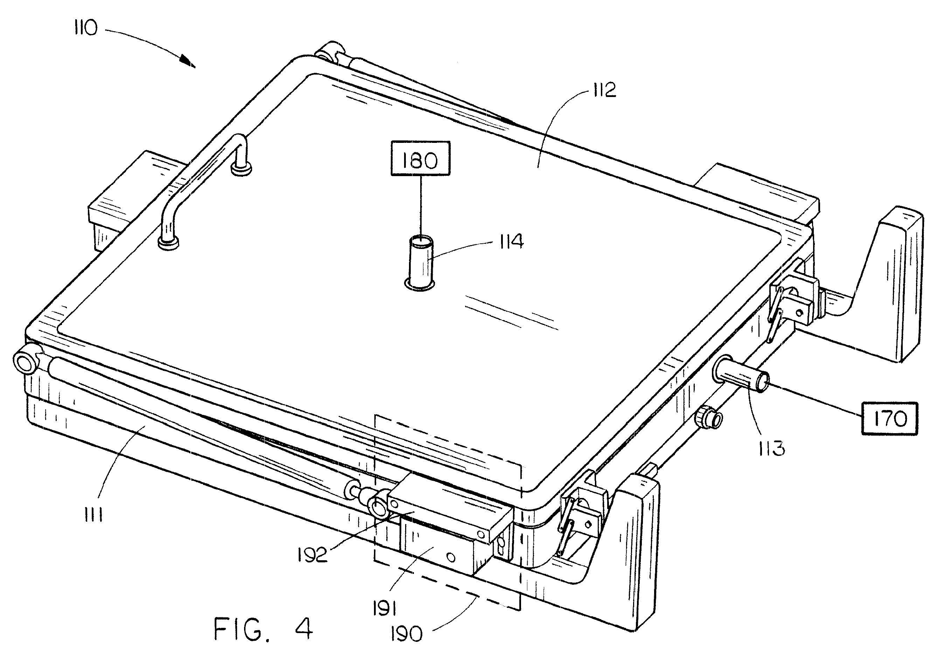

Referring to FIG. 4, the vacuum chamber 110 may further comprise a vacuum port 115 so as to provide a connection for a vacuum line (not shown) operably coupled to a vacuum pump 170. The vacuum port 115 may be operably coupled to the vacuum chamber body 111 to provide a conduit between the first compartment 121 and the vacuum pump 170.

The vacuum chamber 110 may further comprise a vacuum/pressurization port 114 so as to provide a connection for a vacuum/compressor line (not shown) operably coupled to a vacuum pump/compressor 180. The vacuum/pressurization port 114 may be operably coupled to the vacuum chamber lid 112 to provide a conduit between the second compartment 122 and the vacuum pump/compressor 180.

In still another exemplary embodiment, the lamination system 100 may comprise at least one locking mechanism 190. The locking mechanism 190 may serve to secure the vacuum chamber lid 112 to the vacuum chamber body 111 so that the interior of the vacuum chamber 110 may be evacuated. For example, locking mechanism 190 may comprise an electromagnetic lock having an electromagnet 191 and a metal element 192 operably couplable to the electromagnet so as to maintain the vacuum chamber lid 112 and the vacuum chamber body 111 in a locked position, thereby creating an adequate seal via the flexible membrane 120.

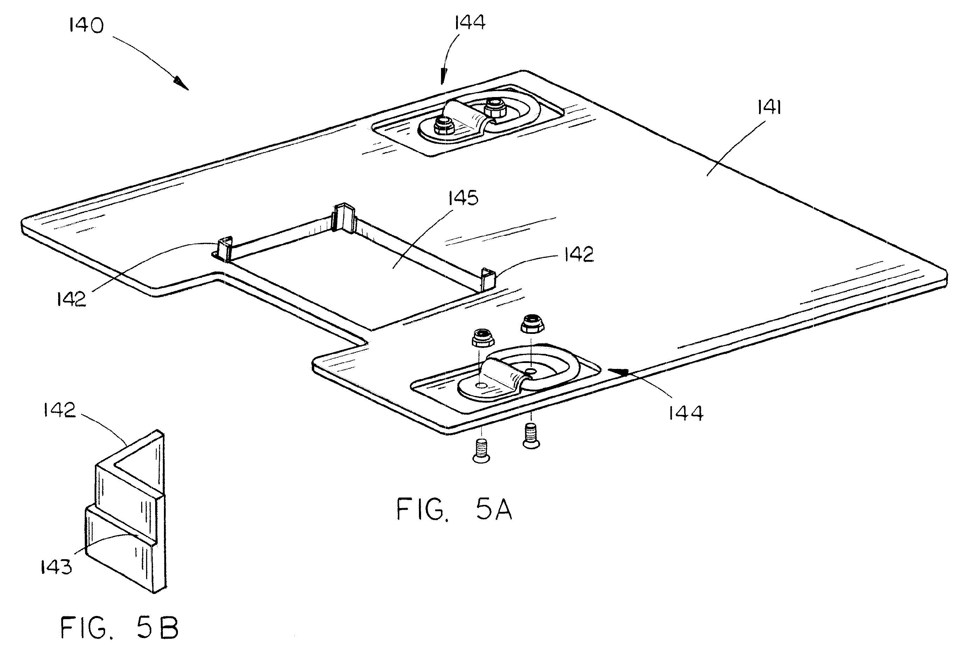

Referring again to FIG. 5, the lamination system 100 may further comprise a substrate alignment insert 140. The substrate alignment insert 140 may serve to align at least one of the first substrate 101 and the second substrate 102 within the vacuum chamber 110. The substrate alignment insert 140 may comprise a base portion 141 (e.g., the floor of the vacuum chamber body 111 or a separate base layer) and at least one substrate alignment guide 142. For example, the substrate alignment guide 142 may comprise two substantially adjacent wall portions configured at a 90 degree angle with respect to one another and projecting from the base portion 141 so as to receive at least one substrate within the space defined by the angle of the wall portions.

In alternate exemplary embodiments, the substrate alignment guide 142 may be selected from brackets, pegs, grooves, bumps, slots, a recessed space within a body, and/or any other suitable mechanism for specifically positioning a substrate within the vacuum chamber 110.

In an alternate exemplary embodiment, the base portion 141 of the substrate alignment insert 140 may further comprise a recessed region 145 suitable for receiving at least one of the first substrate 101 and the second substrate 102.

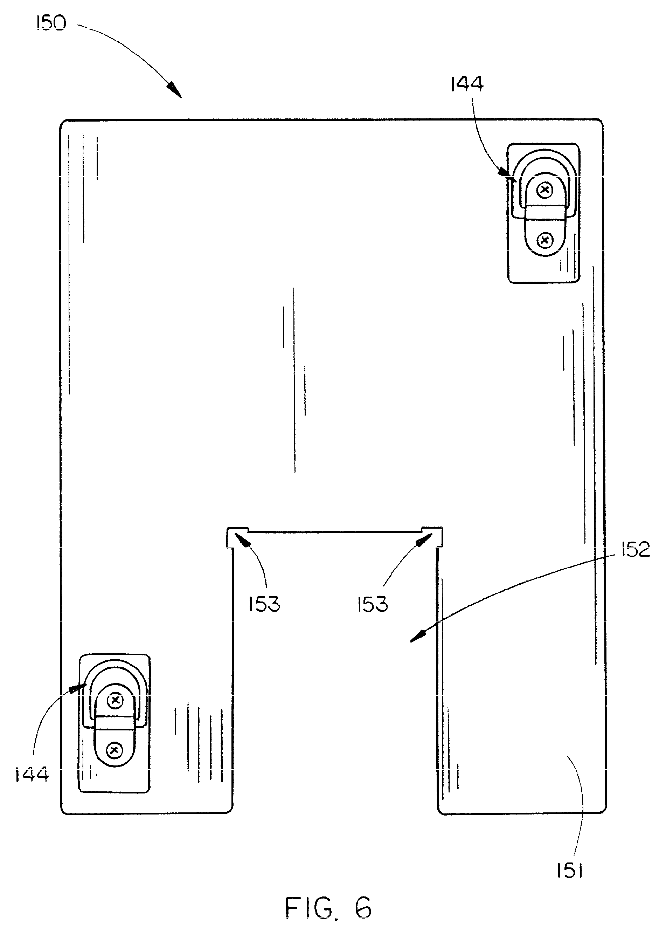

Referring to FIG. 6, the lamination system 100 may further comprise a carriage or substrate mask 150. The substrate mask 150 may comprise a substantially planar mask body 151 defining a mask aperture 152. The mask aperture 152 may be configured so as to fit around at least one substrate alignment guide 142. For example, the mask aperture 152 may comprise alignment guide aperture portions 153 which may allow the substrate mask 150 to be secured around at least one substrate alignment guide 142. The substrate mask 150 may serve to protect portions of the second substrate 102 which are outside the periphery of the mask aperture 152, such as flexible circuitry 104 coupled to the first substrate 101.

Referring again to FIG. 5, in an alternate exemplary embodiment, the at least one substrate alignment guide 142 may comprise a substrate mask support portion 143. The substrate mask support portion 143 may allow the substrate alignment guide 142 to support the substrate mask 150 in spatial separation from the base portion 141 when the substrate mask 150 is disposed atop the substrate alignment insert 140.

In still another exemplary embodiment, the substrate alignment insert 140 and/or the substrate mask 150 may be removable from the lamination system 100 so as to allow for the lamination of different sizes of substrates. To effectuate the removal of the substrate alignment insert 140 and/or the substrate mask 150, at least one handle member 144 may be provided.

In still further exemplary embodiments, lamination system 100 components may incorporate electrostatic discharge (ESD) prevention technologies. For example, the substrate alignment insert 140 and/or the substrate mask 150 may be constructed from materials having desirable ESD properties. Further, the substrate alignment insert 140, the substrate mask 150 and/or any other lamination system 100 component may be connected to electrical ground via ground lines. Further, the lamination system 100 components may be subjected to ionization such that charged surfaces will dissipate that charge through controlled methods. Such ionization may be conducted prior to bringing sensitive substrates, such as sensitive electronic substrates into close proximity with the lamination system 100.

Referring to FIG. 7, the lamination system 100 may further comprise a control unit 160. The control unit 160 unit may comprise vacuum control logic 161, vacuum/pressurization control logic 162 and/or substrate support control logic 163. The vacuum control logic 161, vacuum/pressurization control logic 162, and/or substrate support control logic 163 may comprise integrated logic (e.g., application specific integrated circuitry (ASIC), field programmable gate arrays (FPGA), digital signal processors (DSP)), a programmable logic controller (PLC) or one or more programs (e.g., firmware or software) configured to run on one or more processors (e.g., processors marketed by Intel® and AMD® integrated into personal computers (PCs)).

The vacuum control logic 161 may be configured to provide control signals to a vacuum pump 170 operably coupled to the vacuum chamber 110 via vacuum port 115 to create a vacuum within the first compartment 121.

The vacuum/pressurization control logic 162 may be configured to provide control signals to vacuum pump/compressor 180 operably coupled to the vacuum chamber 110 via vacuum/pressurization port 114 to create a vacuum or pressurization within the second compartment 122.

The substrate support control logic 163 may be configured to provide control signals to the actuating mechanism 132 to either insert or retract the retractable support pin 131.

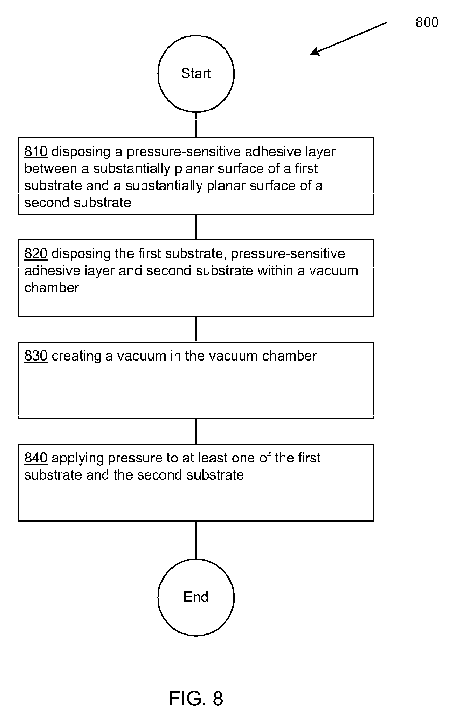

FIG. 8 illustrates an operational flow 800 representing example operations related to lamination of one or more substrates with a pressure sensitive adhesive. In FIG. 8 and in the following figures that include various examples of operational flows, discussion and explanation may be provided with respect to the above-described examples of FIGS. 1 through 7, and/or with respect to other examples and contexts. However, it should be understood that the operational flows may be executed in a number of other environments and contexts, and/or in modified versions of FIGS. 1 through 7. Also, although the various operational flows are presented in the sequence(s) illustrated, it should be understood that the various operations may be performed in other orders than those which are illustrated, or may be performed concurrently.

After a start operation, the operational flow 800 moves to a disposing operation 810, where disposing a pressure-sensitive adhesive layer between a substantially planar surface of a first substrate and a substantially planar surface of a second substrate may occur. For example, as shown in FIGS. 1 through 7, the pressure-sensitive adhesive layer 103 may be disposed between the first substrate 101 and the second substrate 102. Disposing operation 810 may be conducted in either a manual fashion (e.g., by an operator) or an automated fashion whereby an automated disposing apparatus (e.g., a robotic arm configured to dispose the pressure-sensitive adhesive layer 103 between the first substrate 101 and the second substrate 102) such as those commonly found in the manufacturing arts may be employed.

Then, in a disposing operation 820, disposing the first substrate, pressure-sensitive adhesive layer and second substrate within a vacuum chamber may occur. For example, as shown in FIGS. 1 through 7, the first substrate 101, the second substrate 102, and the pressure-sensitive adhesive layer 103 may be disposed within the vacuum chamber 110. Disposing operation 820 may be conducted in either a manual fashion (e.g., by an operator) or an automated fashion whereby an automated disposing apparatus (e.g., a robot arm configured to dispose the pressure-sensitive adhesive layer 103 between the first substrate 101 and the second substrate 102) such as those commonly found in the manufacturing arts may be employed.

Then, in an evacuation operation 830, evacuating the vacuum chamber may occur. For example, as shown in FIGS. 1 through 7, the vacuum control logic 161 may cause the vacuum pump 170 to evacuate the first compartment 121 of the vacuum chamber 110 via vacuum port 115. During vacuum operation 830, the vacuum/pressurization port 114 or the inlet of the vacuum pump/compressor 180 may be sealed so as to limit any deformation of the flexible membrane 120 during the evacuation of the vacuum chamber 110.

Then, in a pressure application operation 840, applying pressure to at least one of the first substrate and the second substrate may occur. For example, as shown in FIGS. 1 through 7, the vacuum/pressurization control logic 162 may cause the vacuum pump/compressor 180 to pressurize the second compartment 122 of the vacuum chamber 110 via vacuum/pressurization port 114. The pressurization of the second compartment 122 may induce a deformation of the flexible membrane 120 in at least the general direction of the first substrate 101, the second substrate 102, and the pressure-sensitive adhesive layer 103. Such a deformation may press the first substrate 101, the second substrate 102, and the pressure-sensitive adhesive layer 103 together, thereby attaching the pressure-sensitive adhesive layer 103 so as to laminate the first substrate 101 and the second substrate 102 to one another.

In other exemplary embodiments, the flexible membrane 120 may comprise a vacuum bag (not shown) which may be disposed within the vacuum chamber 110, thereby defining the first compartment 121 inside the vacuum bag and the second compartment 122 outside the bag. The vacuum bag may at least substantially surround the first substrate 101, the second substrate 102, and the pressure-sensitive adhesive layer 103 within the first compartment 121.

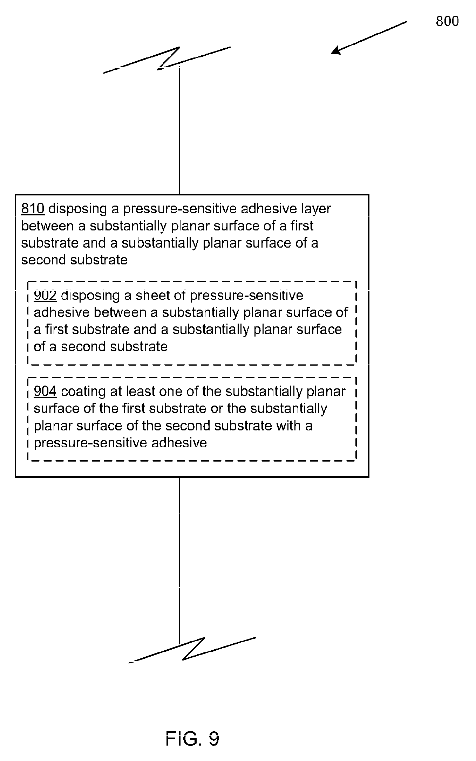

FIG. 9 illustrates alternative embodiments of the example operational flow 800 of FIG. 8. FIG. 9 illustrates example embodiments where the disposing operation 810 may include at least one additional operation. Additional operations may include an operation 902, and/or an operation 904.

At the operation 902, disposing a sheet of pressure-sensitive adhesive between a substantially planar surface of a first substrate and a substantially planar surface of a second substrate may occur. For example, as shown in FIGS. 1 through 7, the pressure-sensitive adhesive layer 103 may be a preformed adhesive sheet which may be mechanically disposed between the first substrate 101 and the second substrate 102.

At the operation 904, coating at least a portion of at least one of the substantially planar surface of the first substrate or the substantially planar surface of the second substrate with a pressure-sensitive adhesive may occur. For example, as shown in FIGS. 1 through 7, the pressure-sensitive adhesive layer 103 may be a cured-state polymer-based pressure sensitive adhesive composition which may be coated on a surface of at least one of the first substrate 101 and the second substrate 102.

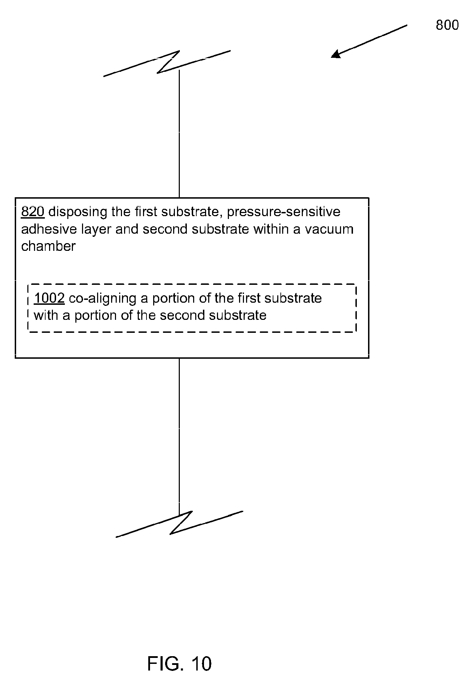

FIG. 10 illustrates alternative embodiments of the example operational flow 800 of FIG. 8. FIG. 10 illustrates example embodiments where the disposing operation 820 may include at least one additional operation. Additional operations may include an operation 1002.

At the operation 1002, co-aligning a portion of the first substrate 101 with a portion of the second substrate 102 may occur. For example, as shown in FIGS. 1 through 7, the at least one of the first substrate 101 and the second substrate 102 may be placed within the substrate alignment insert 140 so as to maintain the substrate in a substantially static position during the vacuum creation operation 830 or the pressure application operation 840. Such alignment may ensure that desired portions of at least one of the first substrate 101 and the second substrate 102 are contacted with the pressure-sensitive adhesive layer 103 while minimizing contact with undesired portions of the first substrate 101 and/or the second substrate 102.

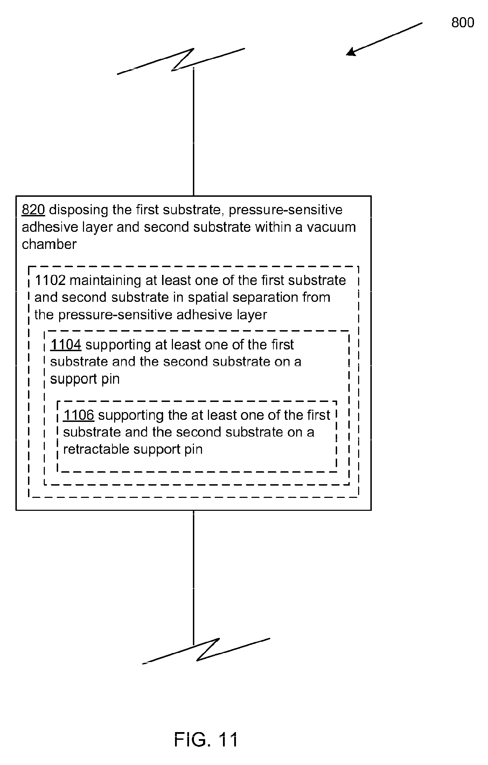

FIG. 11 illustrates alternative embodiments of the example operational flow 800 of FIG. 8. FIG. 11 illustrates example embodiments where the disposing operation 820 may include at least one additional operation. Additional operations may include an operation 1102, an operation 1104, and/or an operation 1106.

At the operation 1102, maintaining at least a portion of at least one of the first substrate and second substrate in spatial separation from the pressure-sensitive adhesive layer may occur. For example, as shown in FIGS. 1 through 7, during the vacuum creation operation 830, portions of at least one of the first substrate 101 and the second substrate 102 are maintained in spatial separation from the pressure-sensitive adhesive layer 103 by the substrate support 130 so as to allow for a substantially complete evacuation of air between the substrate and the pressure-sensitive adhesive, thereby limiting the entrainment of air between the first substrate 101 and the second substrate 102. Further, at the operations 1104 and 1106, supporting at least one of the first substrate and the second substrate on a support pin may occur. For example, as shown in FIGS. 1 through 7, a retractable support pin 131 may maintain at least one of the first substrate 101 and the second substrate 102 in spatial separation from the pressure-sensitive adhesive layer 103.

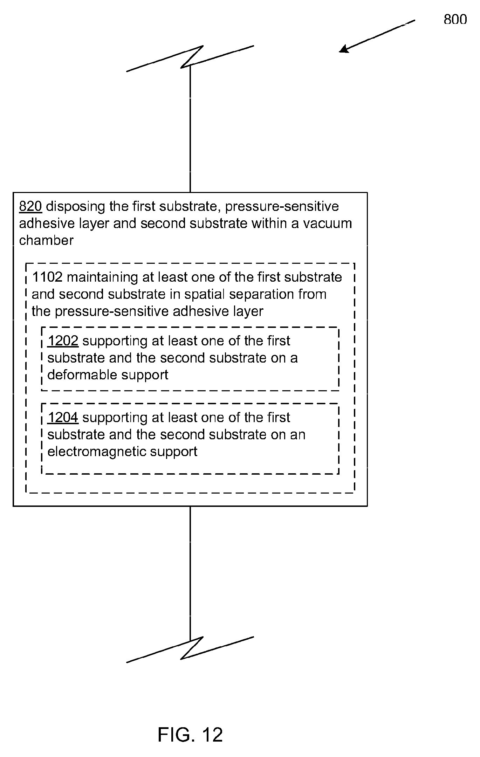

FIG. 12 illustrates alternative embodiments of the example operational flow 800 of FIG. 8. FIG. 12 illustrates example embodiments where the disposing operation 820 may include at least one additional operation. Additional operations may include an operation 1202, and/or an operation 1204. Further, at the operation 1202, supporting at least one of the first substrate 101 and the second substrate 102 on a deformable support may occur. For example, as shown in FIGS. 1 through 7, the substrate support 130 may include a deformable support such as a foam, putty structure or a spring having sufficient spring forces such that the substrate support 130 remains in an expanded configuration until a pressure is applied to at least one of the first substrate 101 and the second substrate 102, such as by the expansion of the flexible membrane 120. Further, at the operation 1204, supporting at least one of the first substrate and the second substrate on an electromagnetic support may occur. For example, as shown in FIGS. 1 through 7, the at least one of the first substrate 101 and the second substrate 102 may be operably coupled to a metal element which may be contacted to an electromagnet disposed within the vacuum chamber 110, such as to the vacuum chamber lid 112. Upon the application of power to the electromagnet, the metal element operably coupled to the at least one of the first substrate 101 and the second substrate 102 may be magnetically attracted to the electromagnet, thereby supporting the at least one of the first substrate 101 and the second substrate 102 is spatial separation from the pressure-sensitive adhesive layer 103.

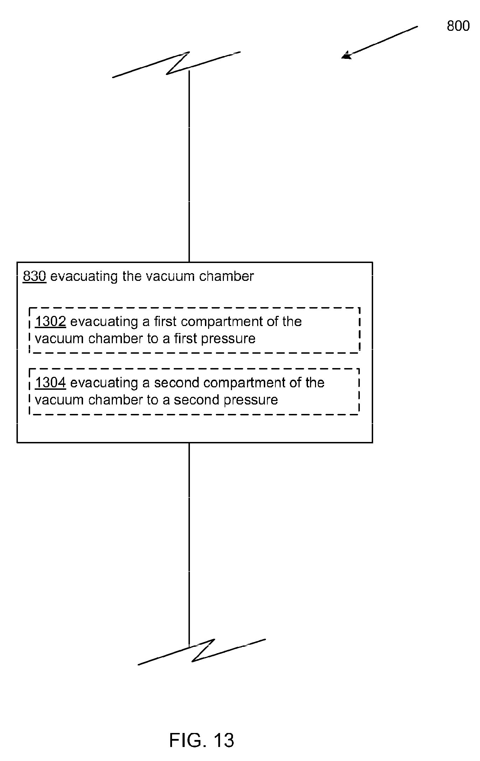

FIG. 13 illustrates alternative embodiments of the example operational flow 800 of FIG. 8. FIG. 13 illustrates example embodiments where the evacuation operation 830 may include at least one additional operation. Additional operations may include an operation 1302, and/or an operation 1304.

At the operation 1302, evacuating a first portion of the vacuum chamber to a first pressure may occur. For example, as shown in FIGS. 1-7, the second compartment 122 may be evacuated via vacuum/pressurization port 114. The evacuation of the second compartment 122 may occur prior to closing the vacuum chamber lid 112 atop the vacuum chamber body 111 so as to maintain the flexible membrane 120 in close proximity to the vacuum chamber lid 112 and avoid contact between the flexible membrane 120 and at least one of the first substrate 101 and the second substrate 102 prior to pressure application operation 840.

At the operation 1304, evacuating a second portion of the vacuum chamber to a second pressure may occur. For example, as shown in FIGS. 1-7, the first compartment 121 may be evacuated via vacuum port 115. The evacuation of the first compartment 121 may occur after closing the vacuum chamber lid 112 atop the vacuum chamber body 111 so as to remove substantially all air from the interior of the first compartment 121. During evacuation operation 1304, a pressure differential may be maintained between the first compartment 121 and the second compartment 122 where the first pressure in the second compartment 122 is lower than the second pressure than the first compartment 121.

During evacuation operation 1304, a pressure differential may be maintained between the first compartment 121 and the second compartment 122 where the first pressure in the second compartment 122 is lower than the second pressure than the first compartment 121.

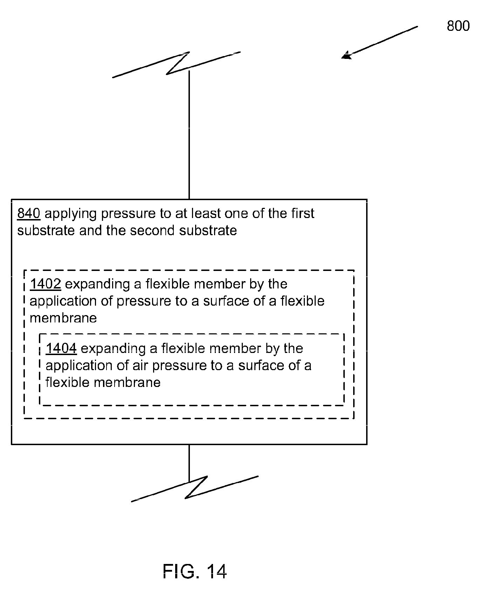

FIG. 14 illustrates alternative embodiments of the example operational flow 800 of FIG. 8. FIG. 14 illustrates example embodiments where the pressure application operation 840 may include at least one additional operation. Additional operations may include an operation 1402, and/or an operation 1404.

At the operation 1402, expanding a flexible membrane by the application of pressure to a surface of the flexible membrane may occur. For example, as shown in FIGS. 1 through 7, a pressure may be exerted on the surface of the flexible membrane 120 facing the second compartment 122. Further, at the operation 1404, expanding a flexible membrane by the application of air pressure to a surface of the flexible membrane may occur. For example, as shown in FIGS. 1 through 7, the vacuum/pressurization control logic 162 of the control unit 160 may cause the vacuum pump/compressor 180 to pressurize the second compartment 122 of the vacuum chamber 110 via the vacuum/pressurization port 114. Pressurization of the second compartment 122 may cause the flexible membrane 120 to expand, thereby contacting at least one of the first substrate 101 and the second substrate 102 and pressing the first substrate 101, the pressure-sensitive adhesive layer 103 and the second substrate 102 together to attach to the pressure-sensitive adhesive layer 103 and laminate the first substrate 101 to the second substrate 102.

In particular applications, a differential pressure between an evacuated first compartment 121 and a pressurized second compartment 122 of from about 20 to 57600 torr and, more particularly, about 5760 torr may be desirable. However, the amount of pressure applied to the second compartment 122 and the corresponding expansion of the flexible membrane 120 may be a function of the pressure required to effectively attach a selected pressure-sensitive adhesive layer 103 or the sensitivity of the first substrate 101 and the second substrate 102, as would be determinable by one of skill in the art. As such, any range of differential pressures between the first compartment 121 and the second compartment 122 is fully contemplated by this disclosure.

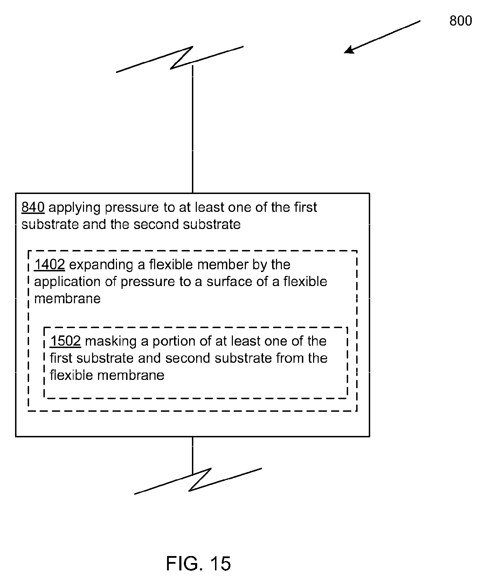

FIG. 15 illustrates alternative embodiments of the example operational flow 800 of FIG. 8. FIG. 15 illustrates example embodiments where the pressure application operation 840 may include at least one additional operation. Additional operations may include an operation 1502. Further, at the operation 1502, masking a portion of at least one of the first substrate and second substrate from contact with the flexible membrane may occur. For example, as shown in FIGS. 1 through 7, the substrate mask 150 may be affixed to the substrate alignment insert 140 such that it provides a barrier between the flexible membrane 120 and at least one of the first substrate 101 and the second substrate 102. Such a configuration may limit the contact area of the flexible membrane 120 to particular portions of at least one of the first substrate 101 and the second substrate 102 within the area defined by the mask aperture 152 during flexible membrane 120 expansion.

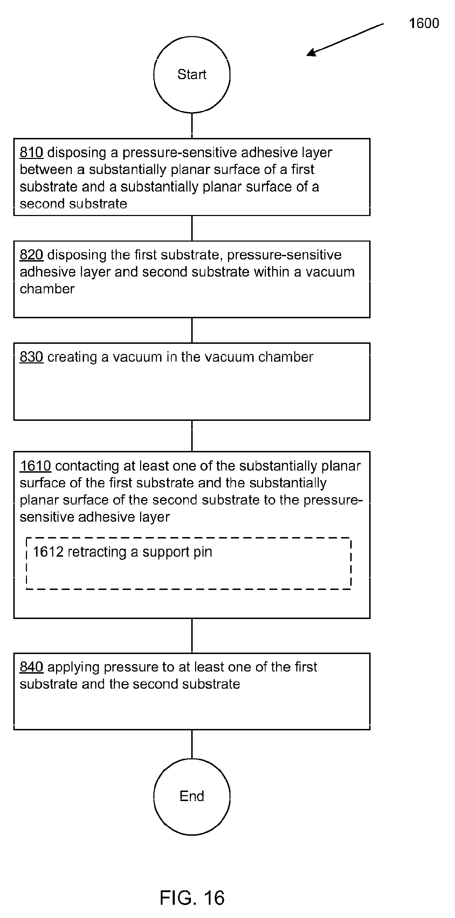

FIG. 16 illustrates an operational flow 1600 representing example operations related to lamination of one or more substrates with a pressure sensitive adhesive. FIG. 16 illustrates an example embodiment where the example operational flow 800 of FIG. 8 may include at least one additional operation. Additional operations may include an operation 1610, and/or an operation 1612.

After a start operation, a disposing operation 810, a disposing operation 820, and a vacuum creation operation 830, , the operational flow 1600 moves to a contacting operation 1610, where contacting at least one of the substantially planar surface of the first substrate and the substantially planar surface of the second substrate to the pressure-sensitive adhesive layer may occur. For example, as shown in FIGS. 1 through 7, at least one of the first substrate 101 and the second substrate 102 may be moved from a supported position where at least one of the first substrate 101 and the second substrate 102 is maintained in spatial separation from the pressure-sensitive adhesive layer 103 to a contacted position where at least one of the first substrate 101 and the second substrate 102 is brought into physical contact with the pressure-sensitive adhesive layer 103. Further, at the operation 1612, retracting a support pin may occur. For example, as shown in FIGS. 1 through 7, the retractable support pin 131 of the substrate support 130 which may support at least one of the first substrate 101 and the second substrate 102 in spatial separation from the pressure-sensitive adhesive layer 103 may be retracted so as to allow at least one of the first substrate 101 and the second substrate 102 to be brought into physical contact with the pressure-sensitive adhesive layer 103.

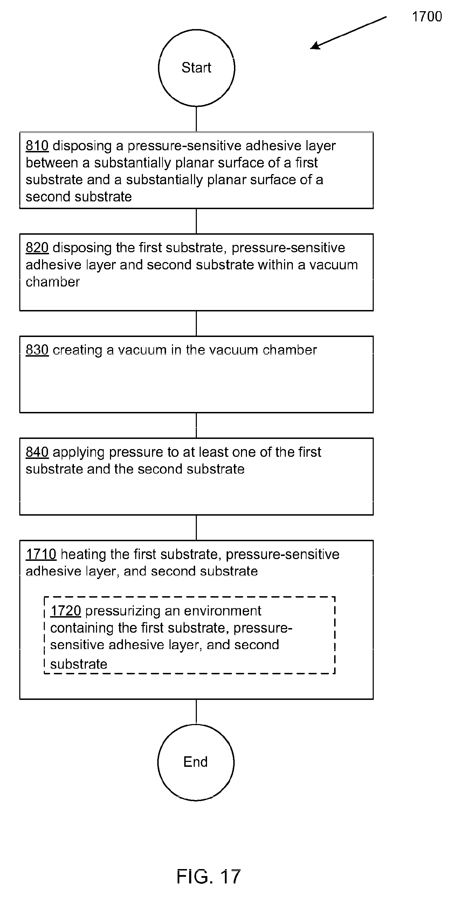

FIG. 17 illustrates an operational flow 1700 representing example operations related to lamination of one or more substrates with a pressure sensitive adhesive. FIG. 17 illustrates an example embodiment where the example operational flow 800 of FIG. 8 may include at least one additional operation. Additional operations may include an operation 1710 and/or an operation 1720.

After a start operation, a disposing operation 810, a disposing operation 820, a vacuum creation operation 830, and a pressure application operation 840, the operational flow 1700 moves to a heating operation 1710, where heating at least one of the first substrate, pressure-sensitive adhesive layer, and second substrate may occur. For example, as shown in FIGS. 1 through 7, the first substrate 101, the second substrate 102 and the pressure-sensitive adhesive layer 103 may be heated by a heating element internal to the vacuum chamber 110 or disposed within an external heating apparatus, such as an autoclave. Such heating may serve to further set the pressure-sensitive adhesive layer 103. In particular applications, the heating may occur in an environment having a temperature of from about ambient to 200 degrees Celsius and, more particularly, about 80 degrees Celsius.

Further, at operation 1720, pressurizing an environment containing the first substrate, pressure-sensitive adhesive layer, and second substrate may occur. For example, the first substrate 101, pressure-sensitive adhesive layer 103 and the second substrate 102 may be disposed in a pressure vessel in which the pressure may be elevated above ambient pressures. The elevated pressure may be from about 5760 torr to about 57600 torr and, more particularly about 1520 torr.

Operations 1710 and 1720 may be conducted over a period of time of from about 2 to 5 hours. However, the amount of heat and pressure applied and the timing therefore may be a function of the heat and pressure required to effectively attach a selected pressure-sensitive adhesive layer 103 or the sensitivity of the first substrate 101 and the second substrate 102 to heat and/or pressure, as would be determinable by one of skill in the art. As such, any range of temperatures and pressures is fully contemplated by this disclosure.

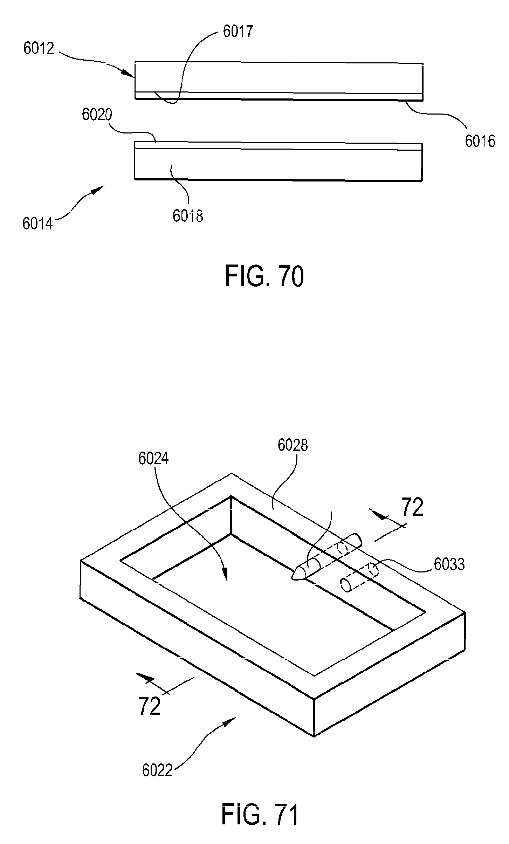

Referring now to FIGS. 70-76, a reliable method of applying a protective cover 6012 to an OLED assembly 6014 is described. Protective cover 6012, which may also be called a capping layer, is made of substantially transparent glass or plastic. A transparent dry film adhesive 6016 is applied to a substantial portion of a face 6017 of protective cover 6012. Preferably dry film adhesive 6016 covers all or virtually all of face 6017. Dry film adhesive 6016 may be securely adhered to face 6017 using a roller (not shown) or other suitable technique. An exemplary type of dry film adhesive is #9483 manufactured by 3M Corp. of Minneapolis, Minnesota, although other dry film adhesives may alternatively be used.

OLED assembly 6014 includes a back pane or substrate 6018, which may be plastic, glass, stainless steel, or other suitable material. OLED materials 6020 are disposed upon substrate 6018 using any suitable manufacturing method.

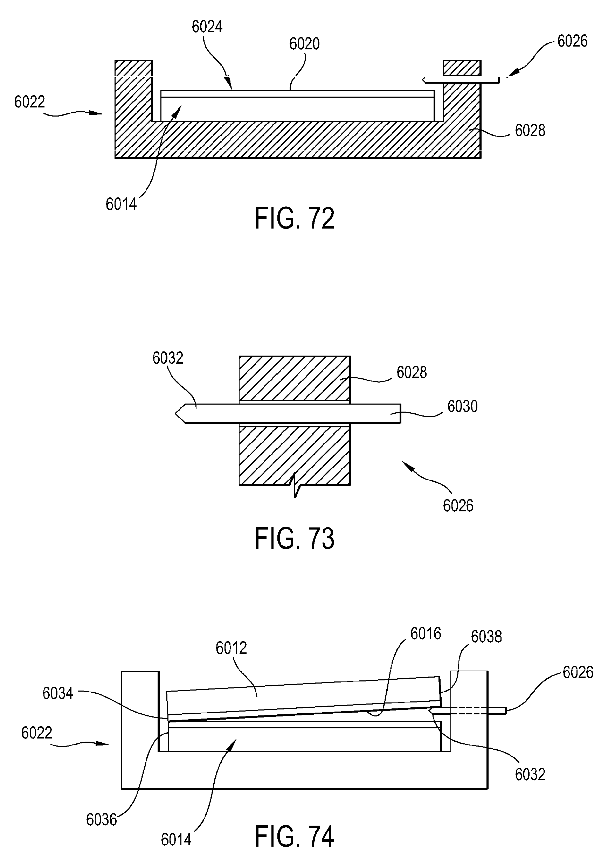

A manufacturing fixture 6022 used with the invented process is shown in FIG. 71. Fixture 6022 includes a recessed portion or cavity 6024 having dimensions at least as great as OLED assembly 6014. Along one side of cavity 6024 is a retractable pin 6026, which is depicted in greater detail in FIGS. 72 and 73. In a preferred embodiment, retractable pin 6026 has a cylindrical cross-section that passes through a sealed wall 6028 of fixture 6022. Pin 6026 has an actuating end 6030 that may be attached to a mechanical actuating mechanism such as a servo (not shown) or the like. Alternatively, actuating end 6030 may be manually moved by an operator. Pin 6026 also has a spherical contact head 6032 that supports an edge of protective cover 6012 during a portion of the invented process, as will be further described. A passage 6033 is disposed along a wall of cavity 6024 (such as wall 6028). Passage 6033 is connected to a vacuum pump or other apparatus (not shown) capable of reducing the air pressure within cavity 6024 to below atmospheric pressure.

To attach protective cover 6012 to OLED assembly 6014, OLED assembly 6014 is placed in cavity 6024 of fixture 6022 so that OLED materials 6020 are facing the open end of the cavity (FIG. 72). Protective cover 6012 is placed in the cavity with dry film adhesive 6016 facing OLED materials 6020. As shown in FIG. 74, a first edge 6034 of protective cover 6012 contacts a first edge 6036 of OLED assembly 6014, and a second edge 6038 of protective cover 6012 rests upon contact head 6032 of retractable pin 6026.

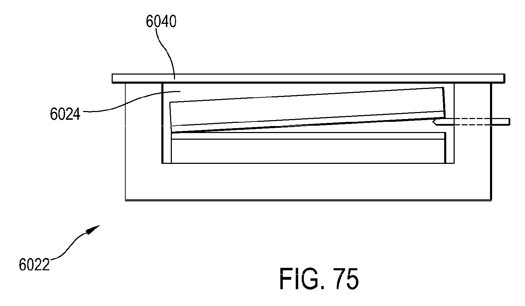

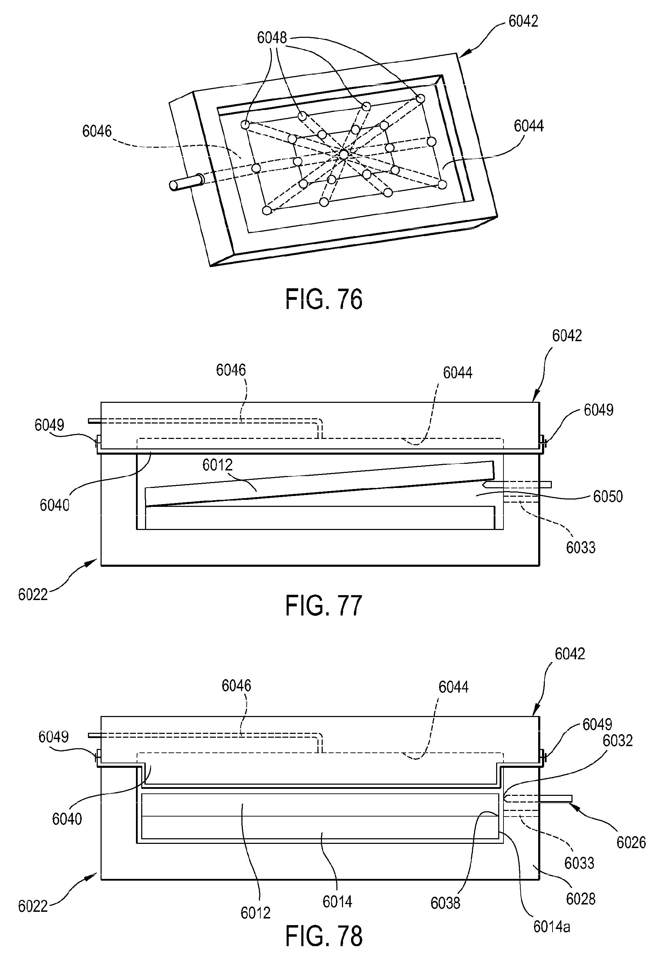

An air-impermeable flexible element, such as an elastomeric bladder 6040, is placed upon fixture 6022 so that cavity 6024 is completely enclosed (FIG. 75) and isolated from the atmosphere. Bladder 6040 has a variable volume and can be selectively expanded or contracted as desired to achieve a desirable pressure on the OLED assembly and the protective cover. Preferably, bladder 6040 is mounted on or otherwise held fast by a pressing structure or plenum 6042 (FIG. 76). Plenum 6042 is designed to hold bladder 6040 taut while enclosing cavity 6024. Plenum 6042 has a recessed portion 6044 over which the bladder is stretched. An internal air passage 6046 communicates with a plurality of outlets 6048 distributed throughout recessed portion 6044. A perforated screen, preferably made of metal, can be bonded to recessed portion 6044 to optimize uniformity of vacuum and pressure. A vacuum pump (not shown) is operationally connected to the internal air passage 6046 and the outlets 6048. Selective operation of the vacuum pump causes pressure to be placed upon or removed from bladder 6040 when the bladder covers recessed portion 6044. FIG. 77 shows bladder 6040 being positioned between fixture 6022 and plenum 6042. Bladder 6040 may be attached to plenum 6042 using a plurality of hooks 6049 or other means of attachment, or as previously mentioned may simply be held taut between the plenum and the fixture by applying pressure or force to the plenum and/or the fixture.

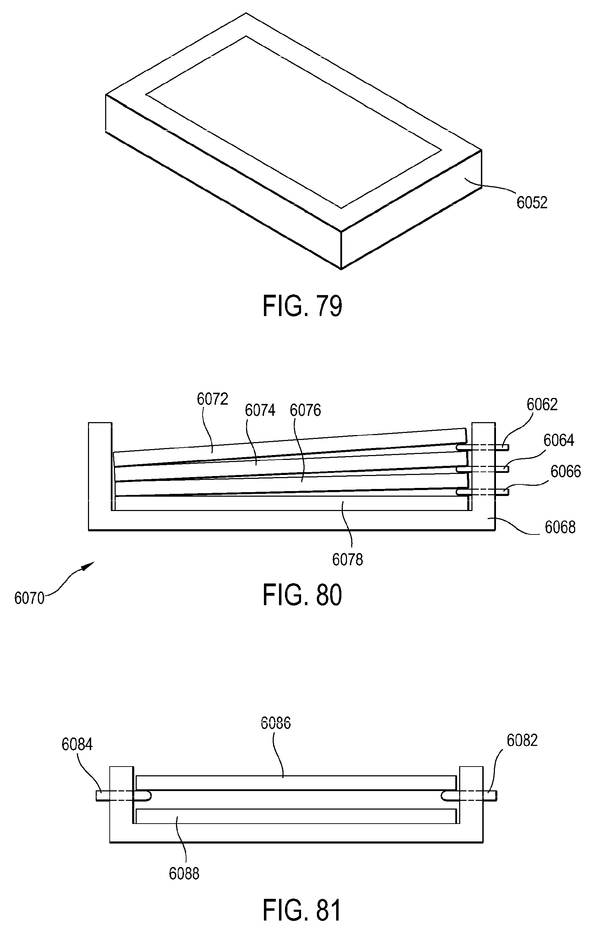

To ensure an effective contact between OLED assembly 6014 and protective cover 6012, the air pressure above bladder 6040 is reduced. In the embodiment depicted in FIG. 77, this means that the vacuum pump (not shown) associated with plenum 6042 reduces the pressure within recessed portion 6044 of the plenum. Next, the air pressure in the region 6050 between the protective cover and the OLED assembly is evacuated or reduced through passage 6033 such that the air pressure in region 6050 is substantially less than ambient air pressure. Retractable pin 6026 is then retracted into wall 6028 so that contact head 6032 is substantially within wall 6028. Second edge 6038 of protective cover 6012 drops to contact a second edge 6014a of OLED assembly 6014, as shown in FIG. 78. Bladder 6040 is expanded, for example by supplying a positive pressure through internal air passage 6046 to recessed portion 6044 of plenum, the bladder thereby applying a predetermined amount of pressure to the protective cover and the OLED assembly for a predetermined period of time, such as 30 to 60 minutes. If necessary to improve optical clarity and reduce defects of dry film adhesive 6016, the temperature surrounding fixture 6022 and bladder 6040 may be increased. Finally, the plenum and bladder are removed from the fixture and the combined OLED assembly and cover plate are removed from cavity 6024. If the OLED assembly is to be used in extreme or severe environments, the edges of the combined OLED assembly and cover plate could be further sealed from moisture if needed by applying an edge seal tape 6052 thereto as shown in FIG. 79.

As described above, a single pin may be used to hold one edge of a protective cover prior to a controlled drop onto an OLED assembly. FIG. 80 depicts another embodiment in which a plurality of pins 6062, 6064, 6066 are mounted within a wall 6068 of a fixture 6070. Fixture 6070 may be used to simultaneously affix multiple layers 6072, 6074, 6076 to a substrate 6078 (such as an OLED assembly) by having an edge of each layer leaning against one of pins 6062, 6064, 6066. Sequentially retracting pins 6066, 6064, 6062 would cause the multiple layers 6076, 6074, 6072 to drop, in turn, onto the substrate.

FIG. 81 depicts another embodiment in which a plurality of pins 6082, 6084 are positioned to hold a protective cover 6086 completely separate from an OLED assembly 6088. Sequentially or simultaneously retracting pins 6082, 6084 causes protective cover 6086 to be dropped onto the OLED assembly as desired.

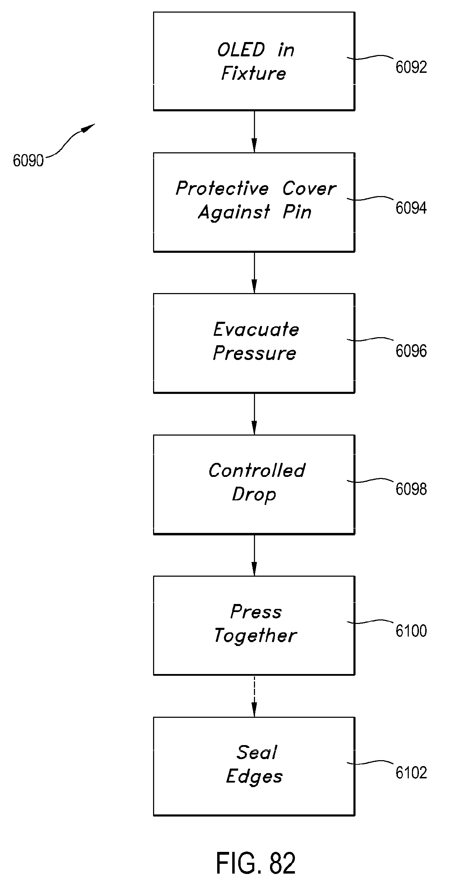

FIG. 82 is a flowchart showing steps of a method 6090 according to an exemplary embodiment. In step 6092 an OLED assembly is placed in a cavity of a fixture, such as fixture 6022. In step 6094 an edge of a protective cover is placed upon an end of a retractable element such as pin 6026. In step 6096 the pressure between the protective cover and the OLED assembly is evacuated or reduced. In step 6098 the pin is retracted so that the protective cover drops onto the OLED assembly. In step 6100 the OLED assembly and the protective cover are pressed together at a predetermined pressure, time, and temperature. In step 6102 the edges of the combined OLED assembly and protective cover are sealed using, for example, a humidity-proof edge seal tape, if needed for use in severe environments.

The mechanism and method may be further varied in many ways without departing from the inventive concepts. For example, substrate 6018 may be made of a flexible material. If so, extra measures may be required to immobilize OLED assembly 6014 during the manufacturing process. Also, protective cover 6012 may be made of any transparent and stiff or semi-rigid material such as plastic. Furthermore, if dry film adhesive 6016 is a dual-stage type adhesive and could contain a photo-initiator or a thermal initiator, the dry-film adhesive may be further cured by exposing the combined assembly to ultraviolet light or heat once the combined assembly has been removed from cavity 6024 of fixture 6022. Also, bladder 6040 may be actuated by or be part of a completely enclosed, balloon-like structure that imposes pressure on the protective cover 6012. Finally, pin 6026 may be retracted at variable rates as desired, and may be retracted horizontally or vertically with respect to the OLED assembly.

The controlled drop of the protective cover in a vacuum environment advantageously substantially reduces air bubbles and non-conformities between the protective cover and the OLED assembly.

The use of the expandable bladder advantageously permits the evacuation of air between the protective cover and the OLED assembly prior to the controlled drop, and also provides pressure isolation to hold together the protective cover and the OLED assembly while the dry film adhesive is bonding the two parts together under a vacuum.

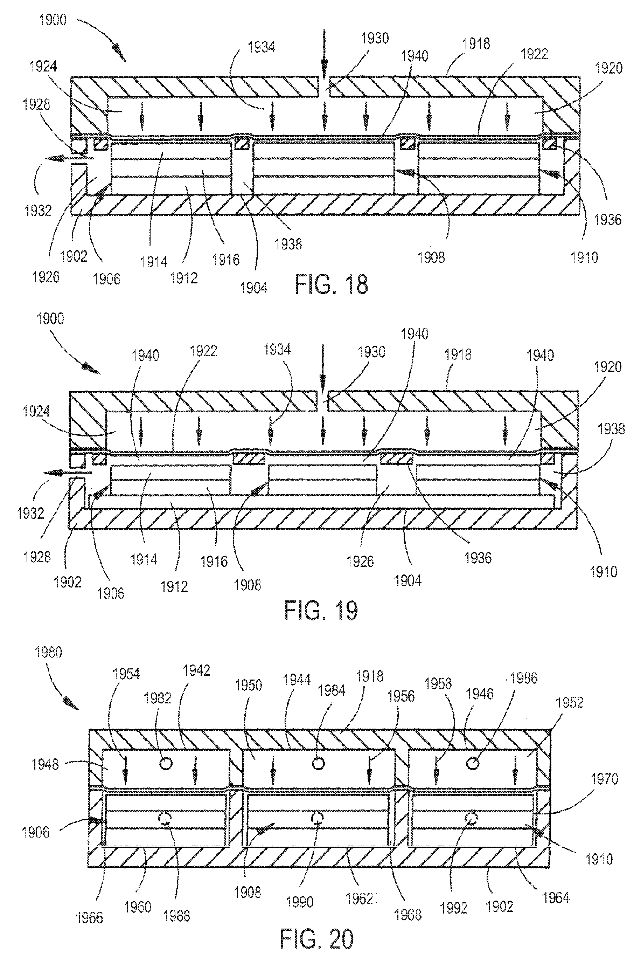

Referring now generally to FIGS. 18-30, various embodiments of an apparatus for performing rigid-to-rigid substrate lamination processes implementing pressure-sensitive adhesive (PSA) are shown in accordance with various exemplary embodiments. For example, the apparatus may be a lamination tool, such as for laminating display assemblies. Further, PSA may encompass commercially available PSA (e.g., dry film pressure-sensitive adhesive, acrylic lamination material), which has undergone planarization treatment as described herein. In exemplary embodiments, rigid-to-rigid lamination processes may encompass processes as shown and described herein, where rigid substrates are joined/secured together via the PSA, said substrates may be display assembly components, such as optical or non-optical substrates, or sheet-like assemblies (e.g., Liquid Crystal Displays (LCDs)/LCD modules, Organic Light-Emitting Diodes (OLEDs), Circuit Boards, Heat Sinks, cover glass for LCD modules, etc.). The rigid-to-rigid lamination processes may involve applying pressure to the substrates in a controlled or selective manner so as to promote minimization of gas entrapment/air bubbles between substrates during assembly/lamination, thereby promoting reduced occurrences of the appearance of undesirable optical effects or visual anomalies in the laminated assembly (e.g., blotches or voids on a display).

Currently existing lamination processes, such as manual, liquid lamination processes, may be used for rigid-to-rigid substrate lamination. However, such processes may be time-consuming, inefficient, expensive and/or capital intensive. Alternatively, other currently existing lamination processes, such as dry-film lamination processes, may not be suitable for use in rigid-to-rigid substrate lamination because said dry-film lamination processes may produce laminated assemblies in which voids or bubbles (due to gas entrapment occurring during the lamination process) are present therein. For example, if the laminated assembly is a display assembly, said voids or bubbles may cause the appearance of undesirable optical effects or visual anomalies, such as visible blotches in the display. Further, said dry-film lamination processes may result in/may produce one or more of the following: substrate breakage; laminated assemblies having poor performance; and/or laminated assemblies having poor repairability. The above-referenced shortcomings of the dry-film lamination processes may be due at least in part to lack of intimate substrate contact via the adhesive material during lamination. Thus, it would be desirable to provide a system and method for performing rigid-to-rigid substrate lamination which obviates the problems associated with current solutions.

Referring to FIGS. 18 and 19, an apparatus 1900 for performing rigid-to-rigid substrate lamination processes implementing pressure-sensitive adhesive (PSA) is shown. The apparatus 1900 may include a base portion 1902. For instance, the base portion 1902 may be a rectilinearly-shaped, tray-like device. Further, the base portion 1902 may include a support surface 1904 configured for supporting one or more laminate assembly stacks 1906, 1908, 1910. In exemplary embodiments, each laminate assembly stack (1906, 1908, 1910) may include a first substrate 1912 (which may be positioned directly on/in direct physical contact with the support surface 1904), a second substrate 1914, and one or more PSA layers 1916 positioned or "sandwiched" between the first substrate 1912 and the second substrate 1914. For example, the first substrate 1912 maybe a cover glass layer for an LCD module, while the second substrate 1914 may be an LCD module. Further, the one or more PSA layers 1916 maybe pre-adhered to the first substrate 1912 and/or second substrate 1914 prior to lamination (e.g., prior to placement on the support surface 1904). As shown in FIG. 19, one or more substrates and/or layers, such as the first substrate 1912 of each laminate assembly stack (1906, 1908, 1910) may be shared between/may be common to each of the stacks. For example, the first substrate 1912 may be a single sheet of cover glass having multiple second substrates 1914 (e.g., LCD modules) and multiple PSA layers 1916 stacked upon it so that multiple LCD modules may be laminated to the single sheet of cover glass.

In an exemplary embodiment, the apparatus 1900 may include a cover portion 1918. Further, the cover portion 1918 may be connected to/configured for being connected with the base portion 1902. For instance, the cover portion 1918 may be attached to base portion 1902 in a clamshell-style configuration. In further embodiments, the cover portion 1918 is configured for forming an enclosure 1920 with the base portion 1902 when the apparatus 1900 is in a closed position (e.g., if the assembly 1900 is a clamshell-style configuration, the closed position (shown in FIGS. 18, 19) is when the cover portion 1918 is "flipped down" onto/over the base portion 1902 and/or secured against the base portion, thereby closing or sealing the enclosure 1920).

In some embodiments, the apparatus 1900 may include a flexible membrane 1922. The flexible membrane 1922 may be configured for being: a.) connected to the cover portion 1918, b.) connected to the base portion 1902 and/or c.) positioned (e.g., "sandwiched") between the base portion 1902 and the cover portion 1918. In further embodiments, the flexible membrane 1922 may be connected/positioned in such a manner that the flexible membrane 1922 and the cover portion 1918 form a first sealed cavity 1924 when the apparatus 1900 is in the closed position. In additional embodiments, the flexible membrane 1922 may be connected/positioned in such a manner that the flexible membrane 1922 and the base portion 1902 form a second sealed cavity 1926 when the apparatus 1900 is in the closed position.

In an exemplary embodiment, the base portion 1902 may be configured with a vacuum port 1928 for allowing the base portion 1902 of the apparatus 1900 to be connected with a vacuum pump. In further embodiments, the cover portion 1918 may be configured with a pressurization port 1930 for allowing the cover portion 1918 of the apparatus 1900 to be connected with a pressurization source. In additional embodiments, when the vacuum port 1928 is connected with the vacuum pump, a vacuum 1932 may be created within the second sealed cavity 1926, thereby subjecting the laminate assembly stacks (1906, 1908, 1910) to vacuum/vacuum pressure. In still further embodiments, when the pressurization port 1930 is connected with the pressurization source, a pressure 1934 may be created within the first sealed cavity 1924. In additional embodiments, the pressure 1934 created within the first sealed cavity 1924 exerts against the flexible membrane 1922 (e.g., creates a backpressure on the flexible membrane 1922), thereby causing the flexible membrane 1922 to apply the created pressure to the laminate assembly stack(s) (1906, 1908, 1910) by expanding against the second substrate(s) 1914 of the laminate assembly stacks, said laminate assembly stacks being supported on the support surface 1904 of the base portion 1902. In exemplary embodiments, the flexible membrane 1922 may be formed of an elastic material, such as silicone. Still further, the material forming the flexible membrane 1922 may be chosen based on properties such as electrostatic discharge (ESD) properties, tear strength, elongational properties, or the like. Further, the flexible membrane 1922 may be coated with one or more layers of plastic (e.g., polyethylene) or other like material, the surface of which won't hold an electric charge (e.g., an electric charge won't be created on its surface) when said material is peeled/pulled away/removed from another material/surface.

In some embodiments, the laminate assembly stacks (1906, 1908, 1910) may be concurrently subjected to the created pressure within the first sealed cavity/flexible membrane-applied pressure 1934 and the vacuum 1932 created within the second sealed cavity 1926. By concurrently subjecting the laminate assembly stacks (1906, 1908, 1910) to the flexible membrane-applied pressure 1934 and the vacuum 1932, intimate substrate (1912, 1914) contact via the PSA 1916 may be promoted, such that entrapment of air/gas bubbles between the substrates (1912, 1914) is reduced or minimized, thereby reducing the likelihood that voids, optical anomalies/non-uniformities, or the like will appear in laminated display assemblies produced via rigid-to-rigid lamination processes implementing the apparatus 1900.

In exemplary embodiments, the apparatus 1900 may include a protective carriage, mask, or insert 1936. The protective carriage 1936 may be configured for being removably placed upon the support surface 1904. For instance, the protective carriage 1936 may be a rectilinearly-shaped lid or cover-like structure which may be seated within or on a correspondingly-shaped/sized tray-like or pan-like base portion 1902 and upon the support surface 1904. In further embodiments, when the protective carriage 1936 is seated upon the support surface 1904, the protective carriage 1936 and the support surface 1904 form a partial enclosure 1938. The protective carriage 1936 may function to protect sensitive components of the substrate(s) (1912, 1914), such as boards and flex circuits of an LCD module, from being subjected to physical contact with and/or pressure applied by the flexible membrane 1922.

In further embodiments, a surface of the carriage 1936 may form one or more apertures 1940/may have one or more apertures 1940 formed therethrough. Further, the apertures 1940 may be shaped/sized for allowing physical access to the laminate assembly stacks (1906, 1908, 1910) positioned on the support surface 1904. As previously discussed, when the carriage 1936 is seated upon the support surface 1904 and within the base portion 1902, the support surface 1904 and the carriage 1936 form a partial enclosure 1938. Still further, the apertures 1940 formed by the carriage 1936 may allow physical access to the laminate assembly stacks (1906, 1908, 1910) (e.g., access to the second/top substrates 1914 of the stacks) when the laminate assembly stacks are positioned on the support surface 1904. For instance, the apertures 1940 may be formed such that when the carriage 1936 is positioned on the support surface 1904 and within or on the base portion 1902, said apertures 1940 may be aligned, shaped and sized so as to promote ease of physical access to laminate assembly stacks (1906, 1908, 1910) positioned on the support surface 1904. For example, the pressure 1934 (e.g., positive pressure) created within the first sealed cavity 1924 may cause the flexible membrane 1922 to expand and be directed through/via the apertures 1940 of the carriage 1936 and against the second substrates 1914 (e.g., LCD module(s)) of the laminate assembly stacks (1906, 1908, 1910), thereby squeezing the laminate assembly stacks between the flexible membrane 1922 and the support surface 1904 and causing intimate contact between the substrates 1912, 1914 via the PSA 1916. Further, the number of apertures 1940 of the carriage 1936 may be equivalent to the number of laminate assembly stacks (1906, 1908, 1910) positioned on the support surface 1904.

In exemplary embodiments, the pressure 1934 applied by the flexible membrane 1922 may be selectably controlled, such that the magnitude of said pressure 1934 may be ramped or varied over time, and/or held at a uniform level for a duration of time for promoting intimate contact (e.g., minimized air/gas entrapment) between the substrates (1912, 1914) via the PSA 1916. In further embodiments, the pressure 1934 applied by the flexible membrane may be selectably controlled to be applied for a selected or desired duration of time for promoting intimate contact between the substrates (1912, 1914).

FIG. 20 illustrates an alternative embodiment of an apparatus for performing rigid-to-rigid substrate lamination processes implementing pressure-sensitive adhesive (PSA). In the illustrated embodiment, the cover portion 1918 of the apparatus 1980 may form a plurality of cover partitions 1942, 1944, 1946. For example, a first cover partition 1942 may be configured for forming a first sealed sub-cavity 1948 with the flexible membrane 1922 when the apparatus 1980 is in the closed position. Further, a second cover partition 1944 may be configured for forming a second sealed sub-cavity 1950 with the flexible membrane 1922 when the apparatus 1980 is in the closed position. Still further, a third cover partition 1946 may be configured for forming a third sealed sub-cavity 1952 with the flexible membrane 1922 when the apparatus 1980 is in the closed position. Further, the apparatus 1980 may include multiple pressurization ports (1982, 1984, 1986) for allowing the cover portion 1918 to be connected with multiple corresponding pressurization sources. In some embodiments, a first pressurization port 1982 may be connected to a first pressurization source for pressurizing the first sealed sub-cavity 1948 to a first pressure 1954, a second pressurization port 1984 may be connected to a second pressurization source for pressurizing the second sealed sub-cavity 1950 to a second pressure 1956, and a third pressurization port 1986 may be connected to a third pressurization source for pressurizing the third sealed sub-cavity 1952 to a third pressure 1958.

The apparatus 1980 of FIG. 20 does not implement a carriage 1936, but rather, the support surface 1904 of the apparatus 1980 is formed/contoured to include a plurality of base receptacles (1960, 1962, 1964). The laminate assembly stacks (1906, 1908, 1910) may be placed in the base receptacles (1960, 1962, 1964) and/on the support surface 1904. Each of the receptacles (1960, 1962, 1964) is configured for forming a sealed base sub-cavity with the flexible membrane 1922 when the apparatus 1980 is established in the closed position. For example, a first receptacle 1960 may form a first sealed base sub-cavity 1966 with the flexible membrane 1922, a second receptacle 1962, may form a second sealed base sub-cavity 1968 with the flexible membrane 1922 and a third receptacle 1964 may form a third sealed base sub-cavity 1970 with the flexible membrane 1922. Further, each base receptacle (1960, 1962, 1964) may be configured so that the flexible membrane 1922 may expand into each of the sealed base sub-cavities (1966, 1968, 1970) to apply pressure to/contact the laminate assembly stack(s) (1906, 1908, 1910).

In further embodiments, the base portion 1902 of the apparatus 1980 includes a plurality of vacuum ports (1988, 1990, 1992) which may be connected to a plurality of corresponding vacuum pumps for creating a vacuum within each of the sealed base sub-cavities (1966, 1968, 1970). The flexible membrane 1922 may exert the first pressure 1954 upon the first laminate assembly stack 1906, the flexible membrane 1922 may exert the second pressure 1956 upon the second laminate assembly stack 1908, and the flexible membrane 1922 may exert the third pressure 1958 upon the third laminate assembly stack 1910. The first, second, and third pressures (1954, 1956, 1958) may differ in magnitude from one another and may be selectably established/chosen based upon substrate (1912, 1914) characteristics, such as thickness, etc., for promoting intimate contact between the substrates (1912, 1914).

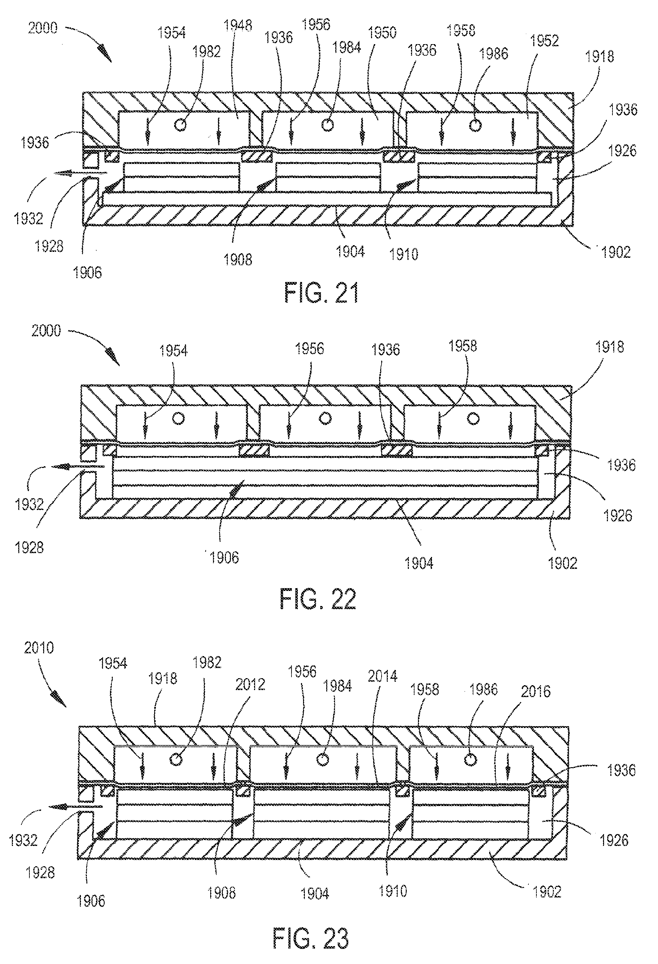

FIGS. 21 and 22 illustrate a further alternative embodiment of an apparatus for performing rigid-to-rigid substrate lamination processes implementing pressure-sensitive adhesive (PSA). The apparatus 2000 allows for a first pressure 1954 created within the first sealed sub-cavity 1948 to be applied via the flexible membrane 1922 to the first laminate assembly stack 1906, a second pressure 1956 created within the second sealed sub-cavity 1950 to be applied via the flexible membrane 1922 to the second laminate assembly stack 1908, and a third pressure 1958 created within the third sealed sub-cavity 1952 to be applied via the flexible membrane 1922 to the third laminate assembly stack 1910. Further, the vacuum port 1928 may be connected to a vacuum source for concurrently applying a vacuum 1932 to the laminate assembly stacks (1906, 1908, 1910), said stacks being positioned within the sealed cavity 1926 formed by the base portion 1902 and the flexible membrane 1922 for promoting intimate contact between the substrates (1912, 1914). Alternatively, (as shown in FIG. 22) the first, second, and third pressures (1954, 1956, 1958) may be applied by the flexible membrane 1922 to a single laminate assembly stack 1906. As previously described, the first, second, and third pressures may be different magnitudes/values from each other, may be the same magnitude/value, may be applied for varying durations, at varying intensities, may be applied in a uniform manner, or the like.

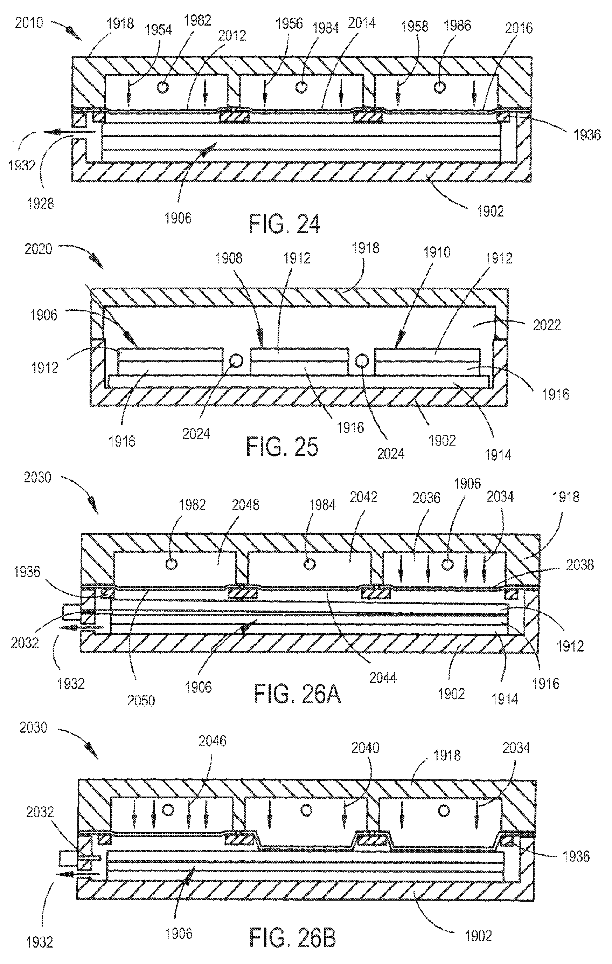

FIGS. 23 and 24 illustrate a further alternative embodiment of an apparatus for performing rigid-to-rigid substrate lamination processes implementing pressure-sensitive adhesive (PSA) in which the apparatus 2010 includes multiple flexible membranes (2012, 2014, 2016) for applying a first pressure 1954, a second pressure 1956, and a third pressure 1958 to one or more laminate assembly stacks (1906, 1908, 1910), while concurrently applying a vacuum 1932 to the one or more stacks. For instance, as shown in FIG. 23, a first flexible membrane 2012 applies the first pressure 1954 to a first stack 1906, a second flexible membrane 2014 applies the second pressure 1956 to a second stack 1908, and a third flexible membrane 2016 applies the third pressure 1958 to a third stack 1910. Alternatively, in FIG. 24, the first, second and third flexible membranes (2012, 2014, 2016) apply the first, second and third pressures (1954, 1956, 1958) respectively, to a single laminate assembly stack 1906 (such as when laminating larger substrates for providing a larger display assembly).

FIG. 25 illustrates a further alternative embodiment of an apparatus for performing rigid-to-rigid substrate lamination processes implementing pressure-sensitive adhesive (PSA) in which the laminate assembly stacks (1906, 1908, 1910) are supported on the support surface 1904 of the apparatus 2020. Further, the base portion 1902 and the cover portion 1918 form a sealed enclosure 2022 when the apparatus 2020 is in the closed position. The apparatus 2020 includes one or more vacuum ports 2024 configured for connection to vacuum source(s) for applying a vacuum to/creating a vacuum within the sealed enclosure 2022. In the illustrated embodiment, the apparatus 2020 relies on the weight of the substrates 1912 rather than flexible membrane-applied pressure to create the force for creating intimate substrate contact. Said vacuum may also be concurrently applied to promote intimate substrate contact. Said apparatus 2020 may be suitable for lamination of heavier/larger display device substrates (1912, 1914).

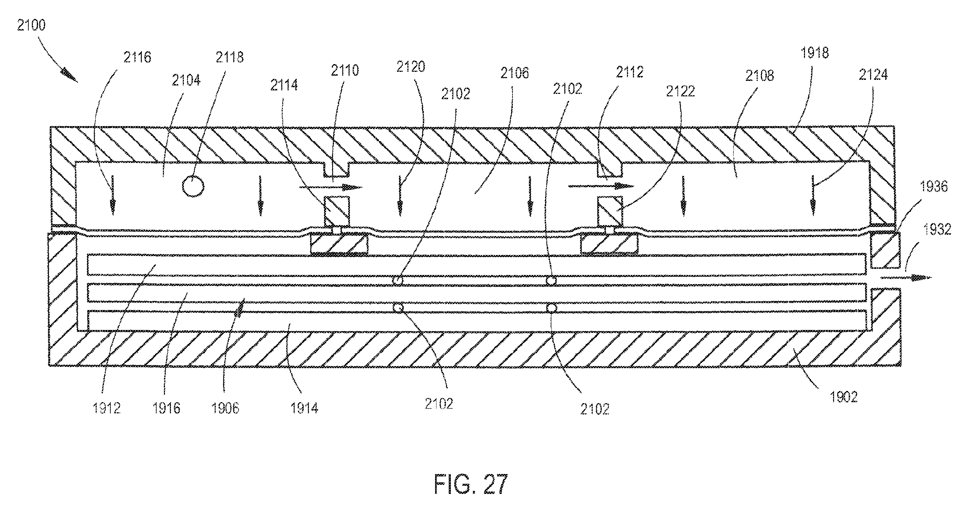

In further embodiments, as shown in FIGS. 26A, 26B, and 27, the apparatus (2030, 2100) may be configured for allowing the substrates/layers (1912, 1914, 1916) to contact each other in a gradual manner. In exemplary embodiments, the apparatus may be configured with a separating mechanism, such as one or more retractable pins, rods or the like (2032, 2102) for maintaining spacing or separation between the substrates/layers (1912, 1914, 1916). For instance, prior to application of pressure, such as via a flexible membrane 1922, one or more of the substrates/layers 1912, 1914, 1916 positioned within the apparatus (2030, 2100) may be separated by the retractable pins (2032, 2102). For example, one or more of the substrates/layers (1912, 1914, 1916) may be completely separated from another of the substrates/layers (1912, 1914, 1916), as shown in FIG. 27. Alternatively, one or more of the substrates/layers (1912, 1914, 1916) may be only partially separated from another of the substrates/layers (1912, 1914, 1916), as shown in FIG. 26A. In further embodiments, said pins (2032, 2102) may be gradually/selectively retracted for allowing the substrates/layers (1912, 1914, 1916) to come into contact/come into further (e.g., greater surface area) contact with one another. During such separation and/or during such time as the substrates/layers (1912, 1914, 1916) come into contact/come into further contact with one another, a vacuum may be applied for promoting prevention of gas entrapment between substrates and allowing intimate substrate contact. Further, during such time as the substrates/layers (1912, 1914, 1916) come into contact/come into further contact with one another, pressure(s) may be applied for promoting intimate substrate (1912, 1914) contact and gas bubble-free adhesion/lamination via the PSA 1916. Further, the pressure(s) may be applied sequentially and/or at different regions/locations along a surface of the first/top substrate 1912, or gradually (such as via a pressure wave or gradient along/across/over a surface of the first/top substrate 1912), the pressure wave allowing for a gradual squeezing together of substrates, such as in a wave-like manner, for providing intimate substrate (1912, 1914) contact via the PSA 1916.

For instance, FIG. 26A illustrates partial separation between the first/top substrate 1912 and the PSA layer 1916 as maintained by the retractable pin. Further, pressure may be applied gradually/in a wave-like manner (e.g., via a pressure gradient) to the laminate assembly stack 1906. For example, a first pressure 2034 created within a first sealed sub-cavity 2036 may initially be applied to the laminate assembly stack 1906 via a first flexible membrane 2038 (either during initial separation, as shown in FIG. 26A, or after retraction of the pins 2032. Further, a second pressure 2040 created within a second sealed sub-cavity 2042 may then be applied to the laminate assembly stack 1906 via a second flexible membrane 2044, as shown in FIG. 26B. For instance, the second pressure 2040 may be the same magnitude or a different magnitude/value/amount than the first pressure 2034 and may be applied in conjunction with/concurrently with the first pressure 2034 (as shown in FIG. 26B) and after retraction of the pins 2032, (also shown in FIG. 26B). Still further, a third pressure 2046 created within a third sealed sub-cavity 2048 may then be applied to the laminate assembly stack 1906 via a third flexible membrane 2050. (see FIG. 26B). For example, the third pressure 2046 may be applied in conjunction with/concurrently with the first pressure 2034 and/or second pressure 2040 (as shown in FIG. 26B) and after retraction of the pins 2032 (also shown in FIG. 26B). Such sequential application of pressure, such as in the gradually increasing wave-like gradient shown in FIGS. 26A & 26B, in conjunction with the applied vacuum 1932 may promote intimate (e.g., bubble-free) contact between substrates/layers (1912, 1914, 1916). It is contemplated by the present invention that the pressures (2034, 2040, 2046) may be selectably applied in various combinations (e.g., one at a time or in combination), at various magnitudes, points in time, and for varying durations along various portions/at various locations along a surface (top substrate 1912) of the laminated substrate assembly 1906

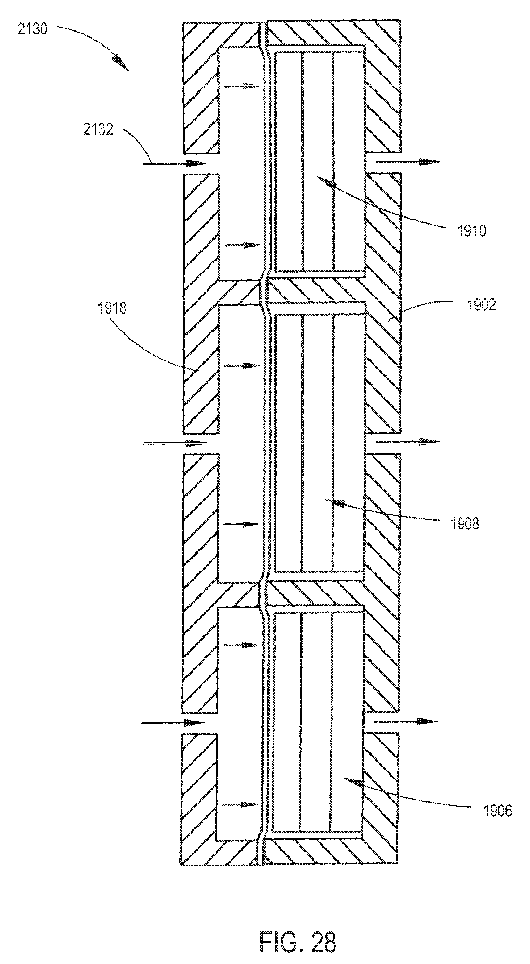

In FIG. 27, the cover portion 1918 of the apparatus is partitioned into a plurality of sealed sub-cavities (2104, 2106, 2108). The cover portion 1918 is further configured with one or more equalizing ports (2110, 2112). Each equalizing port (2110, 2112) may be configured to allow for selective establishment of pressure equalization and/or variation between the sealed sub-cavities (2104, 2106, 2108). For example, a first equalizing port 2110 (e.g., a one-way valve) may be configured through a first wall 2114, said first wall 2114 physically separating a first sealed sub-cavity 2104 and the second sealed sub-cavity 2106. Further, the first equalizing port 2110 may be selectively actuated (e.g., opened) to allow a first pressure 2116 created within the first sealed sub-cavity 2104 (via a pressurization port 2118 configured through the cover portion 1918) to be at least partially released or bled into a second sealed sub-cavity 2106 for creating a second pressure 2120 within the second sealed sub-cavity 2106. Once the second pressure 2120 is established at a desired level/magnitude, the first equalizing port 2110 may be further actuated (e.g., closed) to prevent further pressure release from the first sealed sub-cavity 2104 to the second sealed sub-cavity 2106. Still further, a second equalizing port 2112 may be established through a second wall 2122, said second wall 2122 physically separating the second sealed sub-cavity 2106 and a third sealed sub-cavity 2108. Further, the second equalizing port 2112 may be selectively actuated to allow the second pressure 2120 to be at least partially released or bled into the third sealed sub-cavity 2108 for creating a third pressure 2124 within the third sealed sub-cavity 2108. Once the third pressure 2124 is established at a desire level/magnitude, the second equalization port 2112 may be further actuated to prevent further pressure release from the second sealed sub-cavity 2106 to the third sealed sub-cavity 2108. The equalizing ports 2110, 2112 may be implemented for providing a slow leak effect, which allows for multiple and/or varying pressures to be applied (such as via the flexible membranes 1922) to a laminate assembly stack 1906 in a localized and/or sequential and/or gradient like manner without having to connect the apparatus 2100 with multiple pressure sources. Further, a vacuum 1932 may be applied to said laminate assembly stack 1906 for promoting intimate substrate (1912, 1914) contact via the PSA 1916. In further embodiments, a single, continuous, flexible membrane 1922 (as shown in FIG. 28) rather than multiple flexible membranes (2038, 2044, 2050) may be implemented with the embodiments of the apparatus (2030, 2100) shown in FIGS. 26A, 26B, and 27.

In further embodiments, as shown in FIG. 28, an apparatus 2130 for performing rigid-to-rigid substrate lamination processes implementing pressure-sensitive adhesive (PSA) is shown, said apparatus 2130 may be oriented along a vertical axis, such that pressure 2132 may be applied along a horizontal axis to laminate assembly stacks (1906, 1908, 1910).

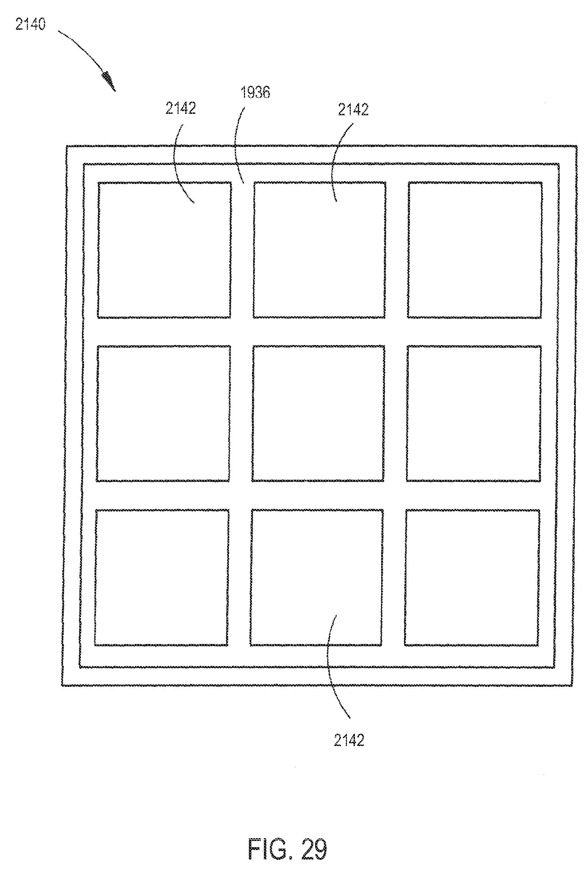

In additional embodiments, as shown in FIG. 29, a top view of an apparatus 2140 for performing rigid-to-rigid substrate lamination processes implementing pressure-sensitive adhesive (PSA) is shown as having a plurality of sealed sub-cavities or pressure zones 2142 in which varying pressures may be created and applied, such as via flexible membranes 1922 at various locations on/along substrate surfaces of one or more laminate substrate assemblies (1906, 1908, 1910).

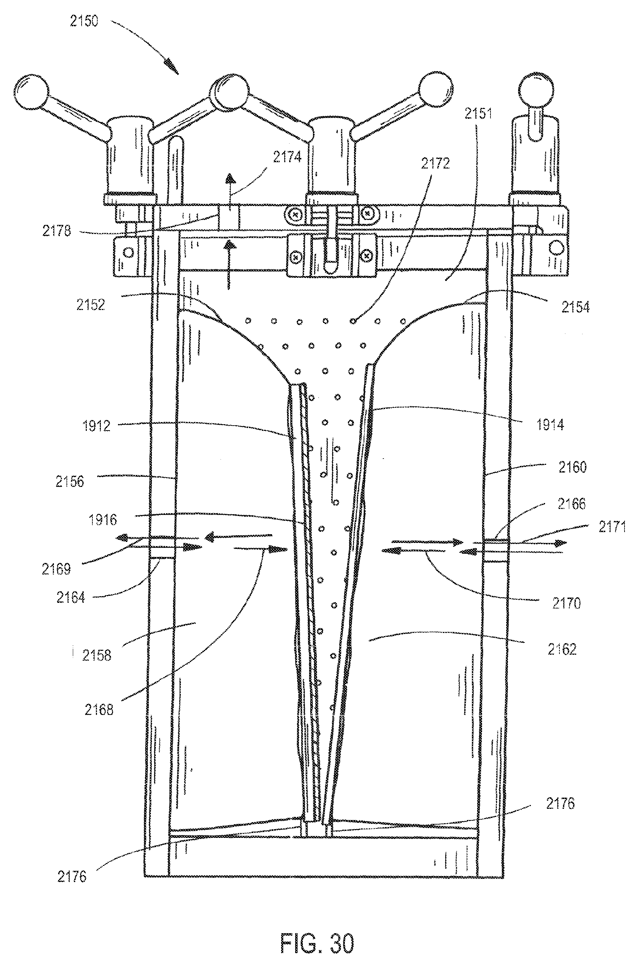

In an alternative embodiment, as shown in FIG. 30, an apparatus 2150 for performing rigid-to-rigid substrate lamination processes implementing pressure-sensitive adhesive (PSA) is shown, said apparatus 2150 may be oriented along a vertical axis (as in FIG. 28). The apparatus 2150 may form a sealed enclosure 2151 and may include a first flexible membrane 2152 and a second flexible membrane 2154. The first flexible membrane 2152 and a first interior surface 2156 of the apparatus 2150 may be connected so as to form a first sealed cavity 2158. The second flexible membrane 2154 and a second interior surface 2160 of the apparatus 2150 may be connected so as to form a second sealed cavity 2162.

Further, the apparatus 2150 may be configured with a first pressurization port 2164, said first pressurization/vacuum port 2164 configured for being connected to a pressurization source for pressurizing the first sealed cavity 2158, said first pressurization/vacuum port 2164 further configured for being connected to a vacuum pump for creating a vacuum within the first sealed cavity 2158. The apparatus 2150 may also be configured with a second pressurization/vacuum port 2166, said second pressurization/vacuum port 2166 configured for being connected to a pressurization source for pressurizing the second sealed cavity 2162, said second pressurization/vacuum port 2166 further configured for being connected to a vacuum pump for creating a vacuum within the second sealed cavity 2162. A first pressure 2168 may be created within the first sealed cavity 2158 via the first pressurization/vacuum port 2164. Further, a second pressure 2170 may be created within the second sealed cavity 2162 via the second pressurization/vacuum port 2166. The first pressure 2168 may be applied via the first flexible membrane 2152 against a laminate assembly stack 1906 which is positioned within the apparatus 2150. The second pressure 2170 may also be applied via the second flexible membrane 2154 against the laminate assembly stack 1906. In additional embodiments, prior to creating the first pressure 2168 within the first sealed cavity 2158 and prior to creating the second pressure 2170 within the second sealed cavity 2162, a first vacuum 2169 may be created within the first sealed cavity 2158 via the first pressurization/vacuum port 2164 and a second vacuum 2171 may be created within the second sealed cavity 2162 via the second pressurization/vacuum port 2166. Creating said vacuums 2169, 2171 prior to creating said pressures 2168, 2170 may be done to prevent stress or damage to the first and second flexible membranes 2152, 2154.

As shown in FIG. 30, the first pressure 2168 may be applied in a first direction along a horizontal axis and the second pressure 2170 may be applied in a second direction along a horizontal axis, the second direction being a generally opposite direction from the first direction. Applying pressure to the laminate assembly stack 1906 in such a manner causes the laminate assembly stack 1906 to be squeezed between the flexible membranes (2152, 2154) for promoting intimate substrate (1912, 1914) contact via the PSA 116 for the laminate assembly stack 1906. Further, the apparatus 2150 may be configured with one or more vacuum ports 2178 via which a vacuum 2174 may be created within the apparatus 2150. Said vacuum 2174 may be concurrently applied to said laminate assembly stack for promoting intimate substrate contact. The first pressure 2168 and the second pressure 2170 may be the same or different magnitudes, may be applied for the same or varying durations, may be applied in a ramped or uniform manner, as a pressure gradient, in such a manner as to gradually cause substrates/layers (1912, 1914, 1916) to come into contact, such as when standoffs/pegs/retractable pins 2176 are implemented, or in any variations as described in the embodiments herein. For instance, the apparatus 2150 may be configured with one or more of a plurality of positioning ports 2172, said positioning ports 2172 being configured for receiving one or more of the retractable pins/pegs 2176 to allow said pins/pegs 2176 to be selectively positioned for supporting/separating the substrates/layers (1912, 1914, 1916). Further, said positioning ports 2172 may be threaded for receiving correspondingly threaded pins/pegs 2176.

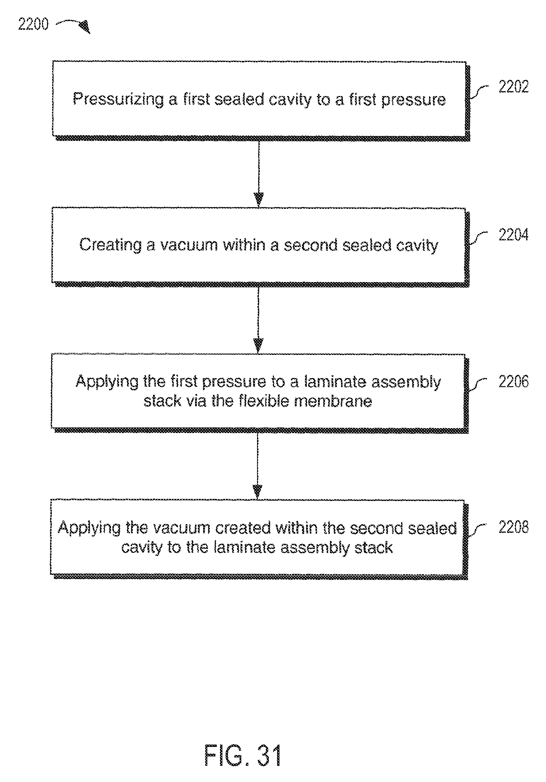

Referring generally to FIGS. 31-35, processes for performing rigid-to-rigid substrate lamination implementing pressure-sensitive adhesive (PSA) are shown in accordance with exemplary embodiments. In FIG. 31, a process 2200 for performing rigid-to-rigid substrate lamination implementing pressure-sensitive adhesive (PSA) may include the steps of: pressurizing a first sealed cavity to a first pressure 2202; creating a vacuum within a second sealed cavity, the second sealed cavity being sealed from the first sealed cavity by a flexible membrane 2204; applying the first pressure to a laminate assembly stack via the flexible membrane, the laminate assembly stack including a first substrate, a second substrate, and a PSA layer, the PSA layer being positioned between the first substrate and the second substrate 2206; and applying the vacuum created within the second sealed cavity to the laminate assembly stack 2208. The applied first pressure and the applied vacuum promote intimate contact between the first substrate and the second substrate of the laminate assembly stack via the PSA layer.

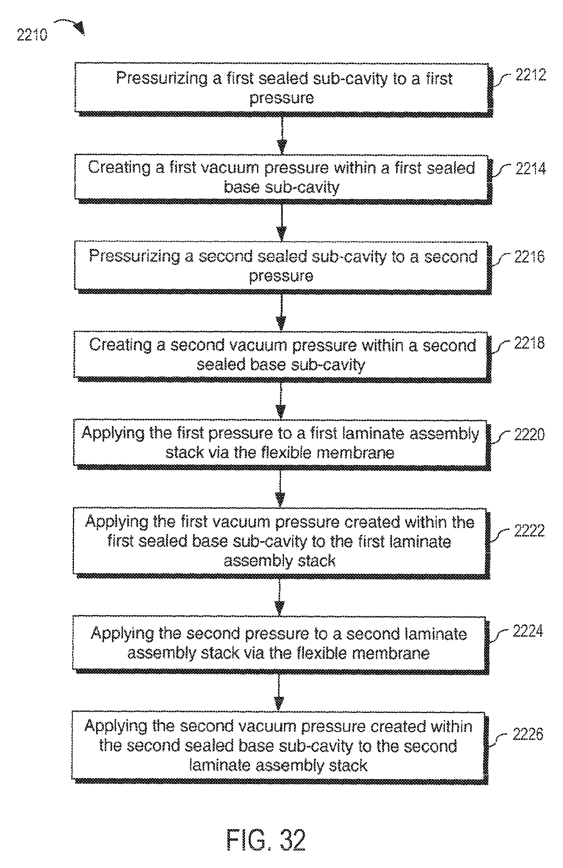

In FIG. 32, a process 2210 for performing rigid-to-rigid substrate lamination implementing pressure-sensitive adhesive (PSA) is shown which may include the steps of: pressurizing a first sealed sub-cavity to a first pressure 2212; creating a first vacuum pressure within a first sealed base sub-cavity, the first sealed base sub-cavity being sealed from the first sealed sub-cavity by a flexible membrane 2214; pressurizing a second sealed sub-cavity to a second pressure 2216; creating a second vacuum pressure within a second sealed base sub-cavity, the second sealed base sub-cavity being sealed from the second sealed sub-cavity by the flexible membrane 2218; applying the first pressure to a first laminate assembly stack via the flexible membrane, the first laminate assembly stack including a first substrate, a second substrate, and a PSA layer, the PSA layer being positioned between the first substrate and the second substrate 2220; applying the first vacuum pressure created within the first sealed base sub-cavity to the first laminate assembly stack 2222; applying the second pressure to a second laminate assembly stack via the flexible membrane, the second laminate assembly stack including a first substrate, a second substrate, and a PSA layer, the PSA layer being positioned between the first substrate and the second substrate 2224; and applying the second vacuum pressure created within the second sealed base sub-cavity to the second laminate assembly stack 2226. The applied first pressure and the applied first vacuum pressure promote intimate contact between the first substrate and the second substrate of the first laminate assembly stack via the PSA layer of the first laminate assembly stack, wherein the applied second pressure and the applied second vacuum pressure promote intimate contact between the first substrate and the second substrate of the second laminate assembly stack via the PSA layer of the second laminate assembly stack.

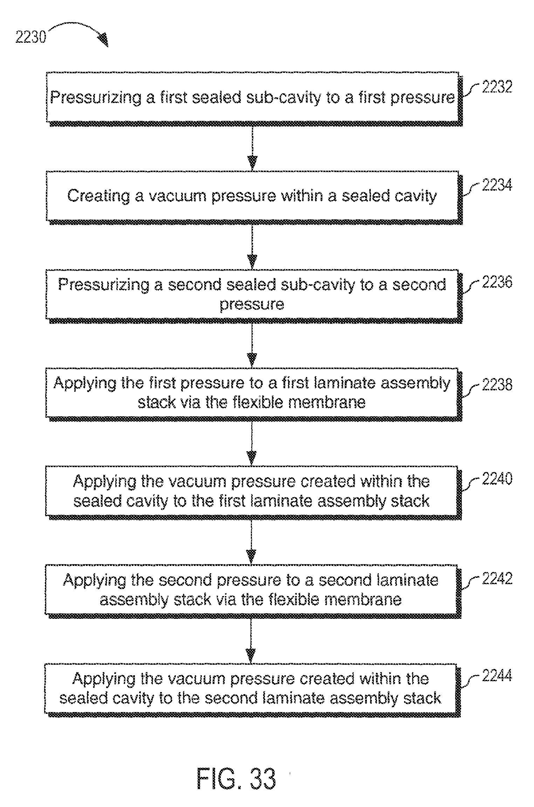

In FIG. 33, a process 2230 for performing rigid-to-rigid substrate lamination implementing pressure-sensitive adhesive (PSA) is shown which may include the steps of: pressurizing a first sealed sub-cavity to a first pressure 2232; creating a vacuum pressure within a sealed cavity, the sealed cavity being sealed from the first sealed sub-cavity by a flexible membrane 2234; pressurizing a second sealed sub-cavity to a second pressure, the second sealed sub-cavity being sealed from the sealed cavity by the flexible membrane 2236; applying the first pressure to a first laminate assembly stack via the flexible membrane, the first laminate assembly stack including a first substrate, a second substrate, and a PSA layer, the PSA layer being positioned between the first substrate and the second substrate 2238; applying the vacuum pressure created within the sealed cavity to the first laminate assembly stack 2240; applying the second pressure to a second laminate assembly stack via the flexible membrane, the second laminate assembly stack including a first substrate, a second substrate, and a PSA layer, the PSA layer being positioned between the first substrate and the second substrate 2242; and applying the vacuum pressure created within the sealed cavity to the second laminate assembly stack 2244. The applied first pressure and the applied vacuum pressure promote intimate contact between the first substrate and the second substrate of the first laminate assembly stack via the PSA layer of the first laminate assembly stack, wherein the applied second pressure and the applied vacuum pressure promote intimate contact between the first substrate and the second substrate of the second laminate assembly stack via the PSA layer of the second laminate assembly stack.

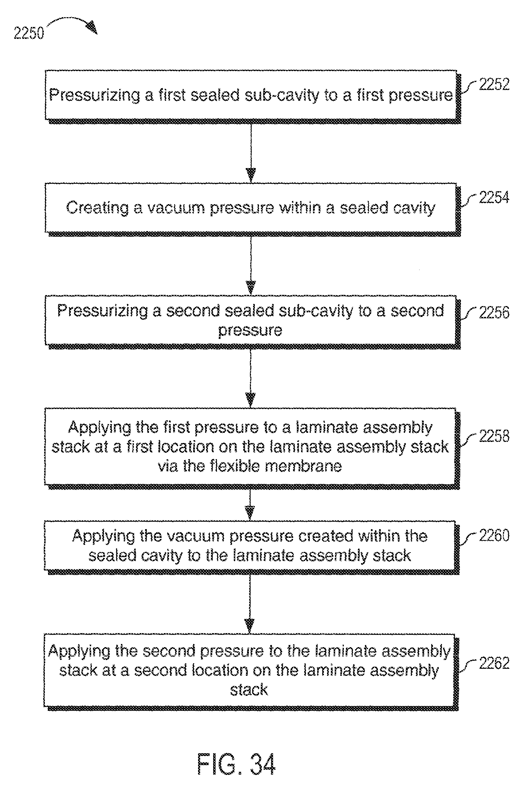

In FIG. 34, a process 2250 for performing rigid-to-rigid substrate lamination implementing pressure-sensitive adhesive (PSA) is shown which may include the steps of: pressurizing a first sealed sub-cavity to a first pressure 2252; creating a vacuum pressure within a sealed cavity, the sealed cavity being sealed from the first sealed sub-cavity by a flexible membrane 2254; pressurizing a second sealed sub-cavity to a second pressure, the second sealed sub-cavity being sealed from the sealed cavity by the flexible membrane 2256; applying the first pressure to a laminate assembly stack at a first location on the laminate assembly stack via the flexible membrane, the laminate assembly stack including a first substrate, a second substrate, and a PSA layer, the PSA layer being positioned between the first substrate and the second substrate 2258; applying the vacuum pressure created within the sealed cavity to the laminate assembly stack 2260; and applying the second pressure to the laminate assembly stack at a second location on the laminate assembly stack via the flexible membrane, the second location being different than the first location 2262. The applied first pressure, the applied second pressure, and the applied vacuum pressure promote intimate contact between the first substrate and the second substrate of the laminate assembly stack via the PSA layer of the laminate assembly stack.

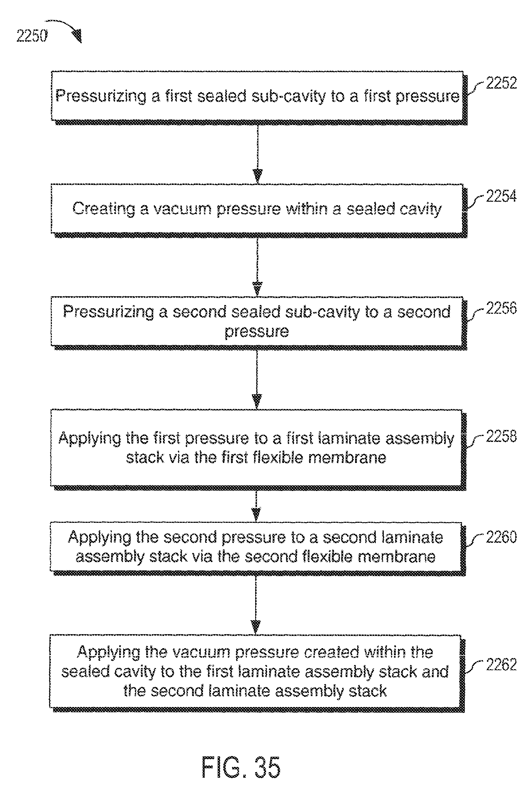

In FIG. 35, a process 2270 for performing rigid-to-rigid substrate lamination implementing pressure-sensitive adhesive (PSA) is shown which may include the steps of: pressurizing a first sealed sub-cavity to a first pressure 2272; creating a vacuum pressure within a sealed cavity, the sealed cavity being sealed from the first sealed sub-cavity by a first flexible membrane 2274; pressurizing a second sealed sub-cavity to a second pressure, the second sealed sub-cavity being sealed from the sealed cavity by a second flexible membrane 2276; applying the first pressure to a first laminate assembly stack via the first flexible membrane, the first laminate assembly stack including a first substrate, a second substrate, and a PSA layer, the PSA layer being positioned between the first substrate and the second substrate 2278; applying the second pressure to a second laminate assembly stack via the second flexible membrane, the second laminate assembly stack including a first substrate, a second substrate, and a PSA layer, the PSA layer being positioned between the first substrate and the second substrate 2280; and applying the vacuum pressure created within the sealed cavity to the first laminate assembly stack and the second laminate assembly stack 2282. The applied first pressure and the applied vacuum pressure promote intimate contact between the first substrate and the second substrate of the first laminate assembly stack via the PSA layer of the first laminate assembly stack, wherein the applied second pressure and the applied vacuum pressure promote intimate contact between the first substrate and the second substrate of the second laminate assembly stack via the PSA layer of the second laminate assembly stack.

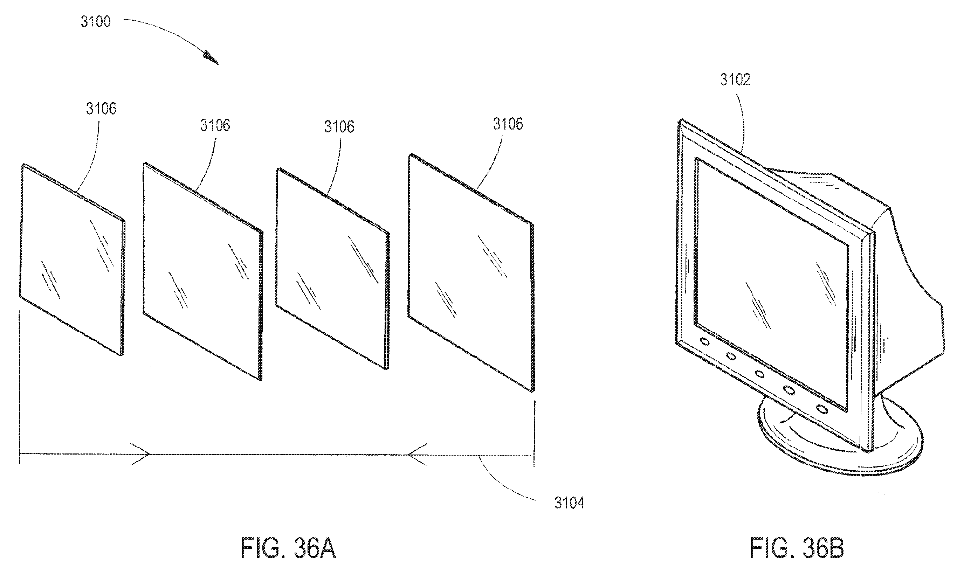

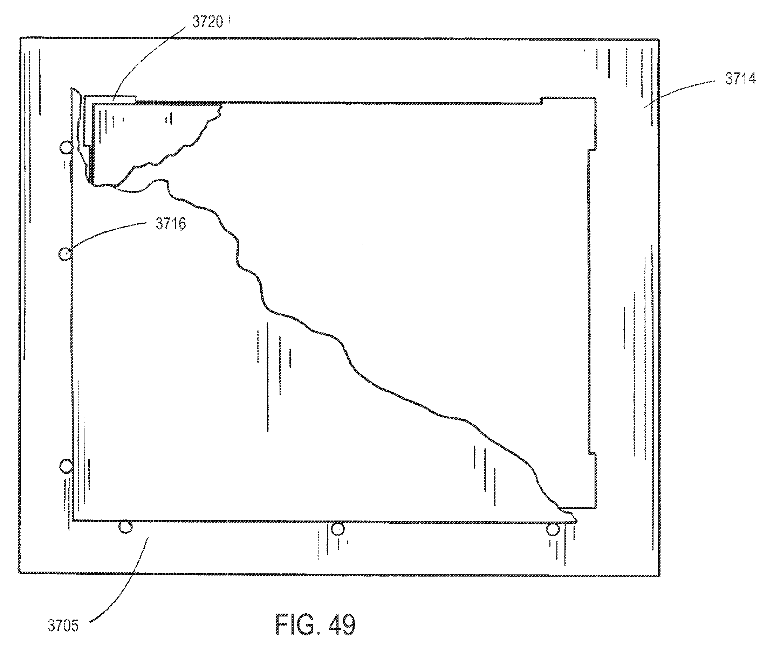

Referring now generally to FIGS. 36A-50, a system and method for providing proper alignment of lamination components is illustrated according to various exemplary embodiments. Liquid crystal display (LCD) devices and displays often require substrates to be optically coupled to a display surface. Further, LCD devices and other displays may utilize additional substrates to be optically coupled to the already formed display surface. These additional substrates can serve many purposes including optical enhancements, protection from impact, or environmental concerns, or sometimes to improve thermal operating range, such as heating elements. Display components such as modules, cover glass, heater glass, and adhesives generally require proper alignment for lamination. Specifically, proper alignment may be required within a mechanical structure, housing, or bezel, or, in some instances, for display feature alignment. Many times, however, these components may not share a common datum or equal edge lengths. Referring to FIG. 36A, an exploded isometric view of a plurality of substrates utilized to form a display 3100 is shown. Referring to FIG. 36B, an isometric view of a display monitor 3102 is shown. A "substrate" as used herein refers to any rigid or semi-rigid planar surface of glass, plastic, film, and/or metal. A "substrate" as used herein may further refer to any rigid or semi-rigid planar surface of glass, plastic, film, and/or metal coated with an adhesive. The substrates 3106 are aligned, brought together 3104, and then laminated to form a display 3102. A laminated display 3102 may comprise an anti-reflective/anti-glare substrate, a touch panel, a glass substrate, a polarizing film substrate, an LCD, an electrode plane including a conductive coating (e.g., indium-tin oxide) substrate, another glass substrate, and/or another polarizing film substrate. The substrates 3106 may be different materials, different shapes, different thickness, and/or different sizes. The different substrates 3106 may be aligned for lamination to form the display 3102.

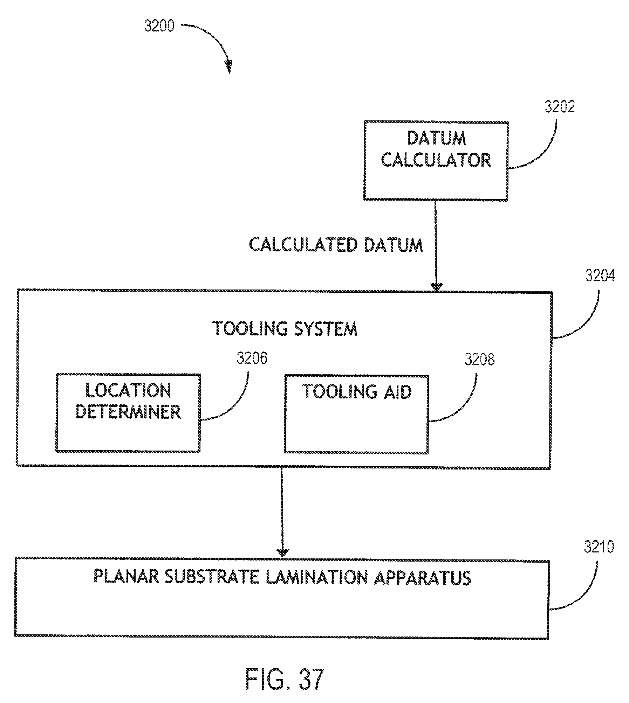

Referring to FIGS. 37 through 39, a block diagram of an alignment system is shown. The alignment system may be utilized to form a display or to add additional substrates to an already formed display. As used herein a "planar item" refers to a substrate or a display. The display is formed by the lamination of multiple substrates. Additional substrates are added to an already formed display by lamination also. The planar items are aligned before lamination. The number and/or types of substrates vary depending upon the desired display. Three different alignment systems 3200, 3300, and 3400 may be utilized to align the planar items for lamination to form a display or to add an additional substrate to an already formed display.

Referring to FIG. 37 a block diagram of an alignment system 3200 is shown. A datum calculator 3202 may calculate a datum of a planar item. The term "datum" as used herein refers to a reference edge length on each planar item. The datum calculator may calculate a plurality of datum for each planar item. The datum calculator 3202 may mechanically, optically, and/or manually calculate one or more datum. The number and type of substrates vary depending upon the desired display. At least two planar items must be present to utilize the alignment system 3200. A calculated datum may be provided to the tooling system 3204. The calculated datum may be provided to the tooling system electronically, mechanically, and/or manually. The datum may be entered manually and/or robotically through a keyboard or electronically via an electronic signal and/or a communication system.

The tooling system utilizes a location determiner 3206 to calculate a proper alignment position for the planar items. The location determiner 3206 may utilize computing systems, environments, and/or configurations that may be suitable for utilization with location software and/or hardware, such as personal computers, server computers, hand-held or laptop devices, multiprocessor systems, microprocessor-based systems, set top boxes, programmable consumer electronics, network PCs, minicomputers, mainframe computers, distributed computing environments that include any of the above systems or devices, and the like. This list is not restrictive. It is contemplated that any suitable computing systems, environments, and/or configurations may be utilized without departing from the scope and intent of the disclosure. The location determiner 3206 may utilize the calculated datum or the edge lengths to determine the proper alignment position. The location determiner 3206 may utilize a plurality of datum. The multiple datum allow a tooling system 3204 to determine the correct vertical and horizontal alignment position for the planar items. The location determiner 3206 provides instruction to the tooling system 3204 for forming a tooling aid 3208 and/or tooling aids 3208 to properly align the planar items in a planar substrate lamination apparatus 3210 for lamination. The tooling system 3204 utilizes the instructions to form the tooling aids 3208 and/or insert the tooling aids 3208 into the planar substrate lamination apparatus 3210. As used herein "to form tooling aids" or "forming tooling aids" refers to the specific calculated placement of tooling aid(s) inside of a planar substrate lamination apparatus, to the calculated design of a tooling aid(s), and/or the proper selection of an already formed tooling aid(s).

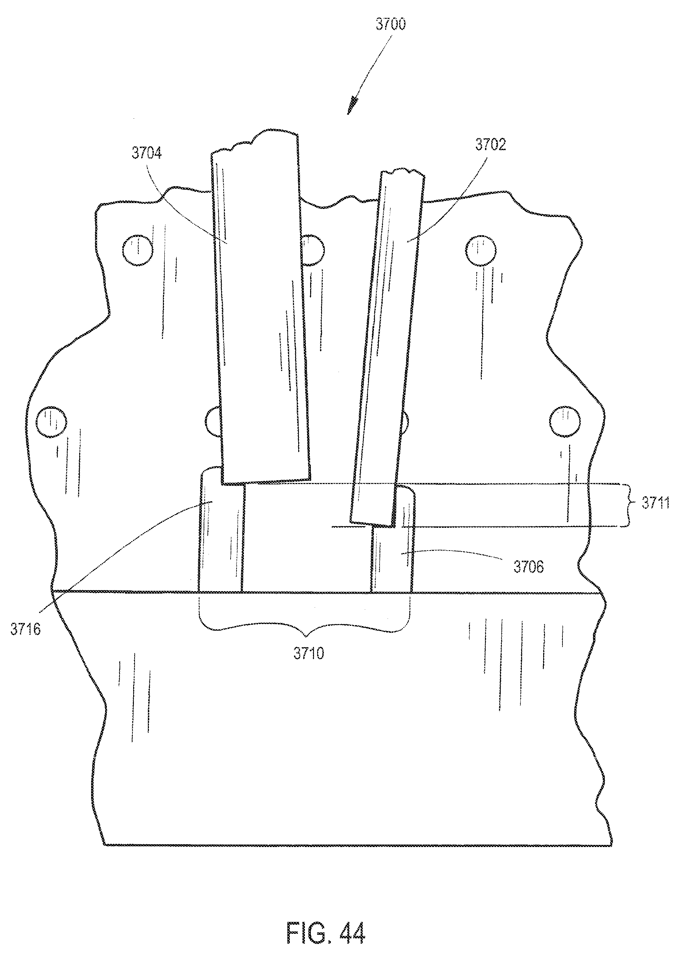

Referring to FIGS. 42, 43, and 44, a planar substrate lamination apparatus 3700 is shown. The planar substrate lamination apparatus 3700 may comprise at least one support peg 3708 and at least one stand-off3706. The planar substrate lamination apparatus 3700 may utilize a support peg 3708 and a standoff3706 to align a first substrate 3702 and a second substrate 3704 for lamination. The first substrate 3702 and the second substrate 3704 may be different sizes. The first substrate 3702 and the second substrate 3704 may be formed from the same or different materials. The stand off 3706 may provide a controlled offset 3710 and separation 3711 prior to lamination for the first substrate 3702 and the second substrate 3704, as illustrated in FIG. 44.

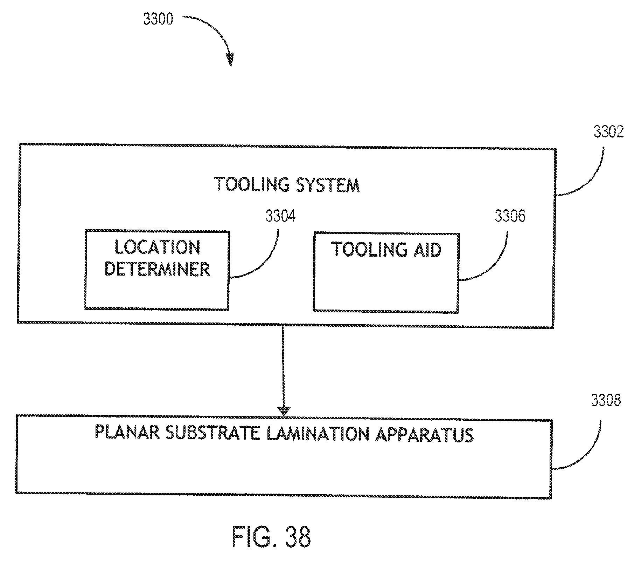

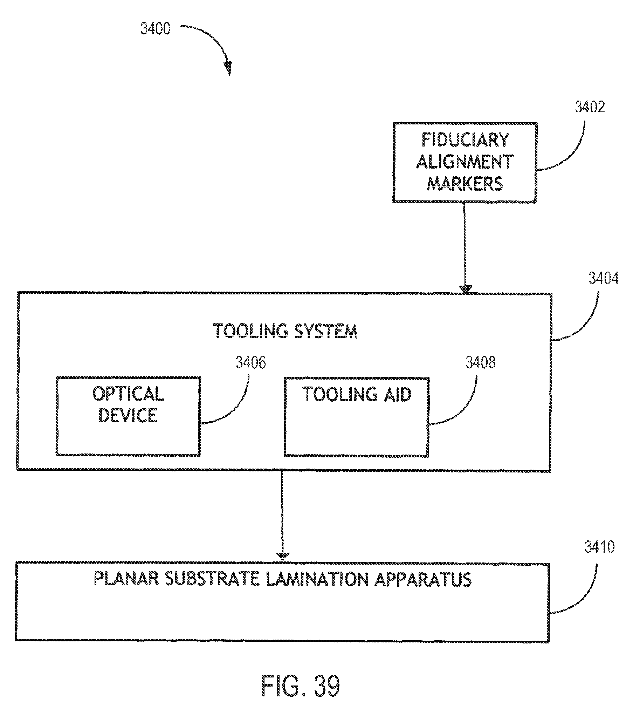

In one embodiment, a tooling aid 3208 may comprise an alignment aid 3714, as illustrated in FIGS. 38 and 39, and/or pegs 3716, as illustrated in FIGS. 42, 43, and 44, depending upon the type of the planar substrate lamination apparatus 3210 utilized. The tooling aid 3208 may offset the uncommon datum of the planar items (if the planar items have uncommon datum) when the planar items are placed inside the planar substrate lamination apparatus 3210 for lamination. Tooling aid 3705 may be utilized as an edge support for a substrate 3702, 3704. A single tooling aid 3706 or multiple tooling aids 3706, 3716 may be utilized to provide the proper alignment of planar items for lamination. The tooling aid 3208 may offset the different sizes, shapes, or thicknesses of the planar items by utilizing pegs 3706, 3716, bumps 3718, and/or any other suitable mechanism for specifically positioning a planar item within the planar substrate lamination apparatus. The tooling aid 3705 may be inserted and/or positioned inside the planar substrate lamination apparatus for specifically providing angular support for a planar item within the planar substrate lamination apparatus. The tooling aid 3706, 3716 may be adaptable to required electrostatic discharge (ESD) thresholds for sensitive electronics. For example, at least a portion of a tooling aid may be composed of a static dissipative material configured to conduct static charge away from the planar substrate lamination apparatus 3700.

The tooling aid 3705 permits adaptation for multiple planar items with one common tool. Specifically, as mentioned, tooling aid 3705 may be utilized as an edge support for a substrate 3702, 3704.

Tooling aid 3720 may provide clearance substantially around a corner region of a substrate. Clearance provided by tooling aid 3720 may reduce or substantially prevent damage to a substrate when a substrate is loaded, laminated to at least one additional substrate, removed from an insert or transported within the alignment system.

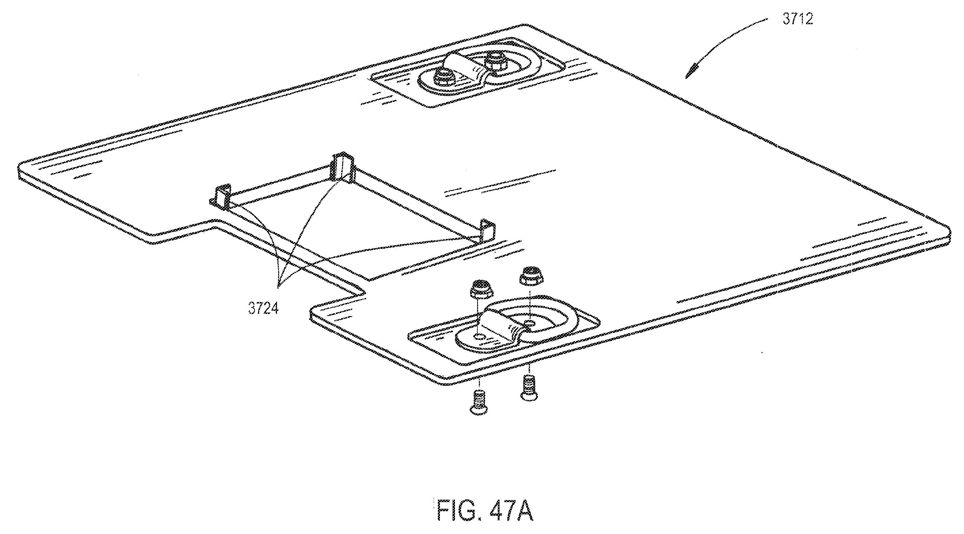

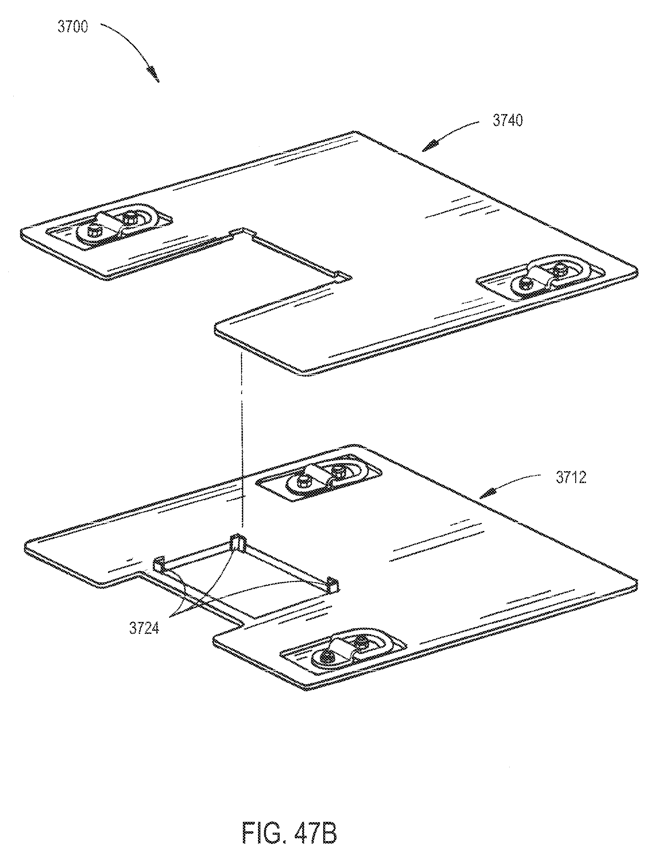

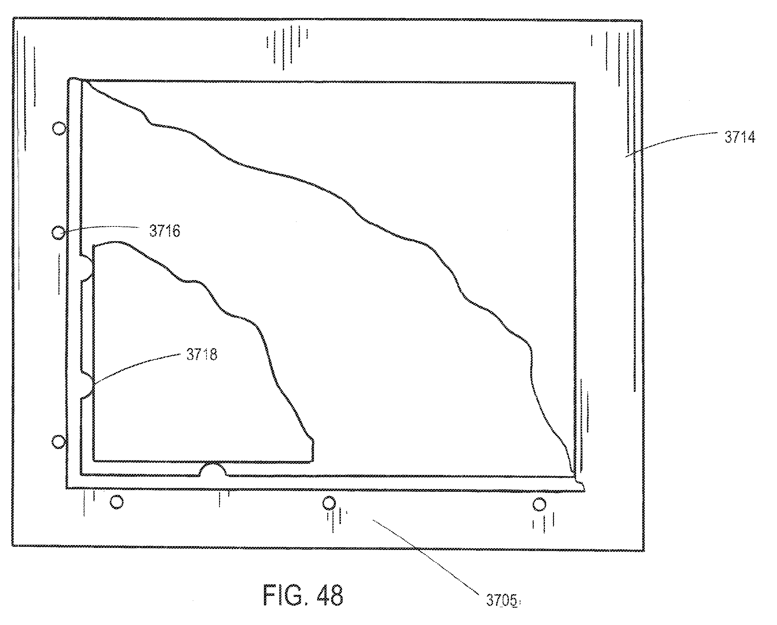

The tooling system may provide the proper alignment position to the planar substrate lamination apparatus by forming a tooling aid, such as an insert 3712, as illustrated in FIGS. 47A, 47B and 48. The insert 3712 may be made of metal, a polymer, and/or multiple polymers. The insert 3712 is designed based upon the specifications provided by the location determiner 3206 to provide for the proper alignment position of the planar items for lamination. The insert 3712 may be inserted and/or positioned inside the planar substrate lamination apparatus. The planar items are placed inside of the insert 3712. The specific placement of the pegs 3716, bumps 3718, and/or any other suitable mechanism for specifically positioning a planar item align the planar items into the proper position for lamination in the insert 3712. The insert 3712 filled with planar items may be inserted into the planar substrate lamination apparatus.

The tooling system may utilize pegs 3706, 3716 in a peg system (e.g., array of apertures 3722) to provide the proper alignment position to the planar items in the planar substrate lamination apparatus 3700, as illustrated in FIGS. 42, 43, and 44. The pegs 3706, 3716 may function as standoffs and/or support pegs. The pegs 3706, 3716 are inserted in the planar substrate lamination apparatus in a specific position to provide the planar items with the proper position for lamination. The pegs 3706, 3716 may also be specifically designed and/or shaped to provide the proper compensation and/or positioning of the planar items. The pegs 3706, 3716 may have different sizes, lengths, and/or cut out notches to align the planar items. The different sizes, lengths, and/or cut out notches may be utilized to offset the different sizes, shapes, and/or thicknesses of the planar items. After the pegs 3706, 3716 are designed and inserted into the planar substrate lamination apparatus 3700 the planar items may be placed in the planar substrate lamination apparatus 3700. The pegs 3706, 3716 place the planar items in the planar substrate lamination apparatus 3700 in the proper position for lamination.

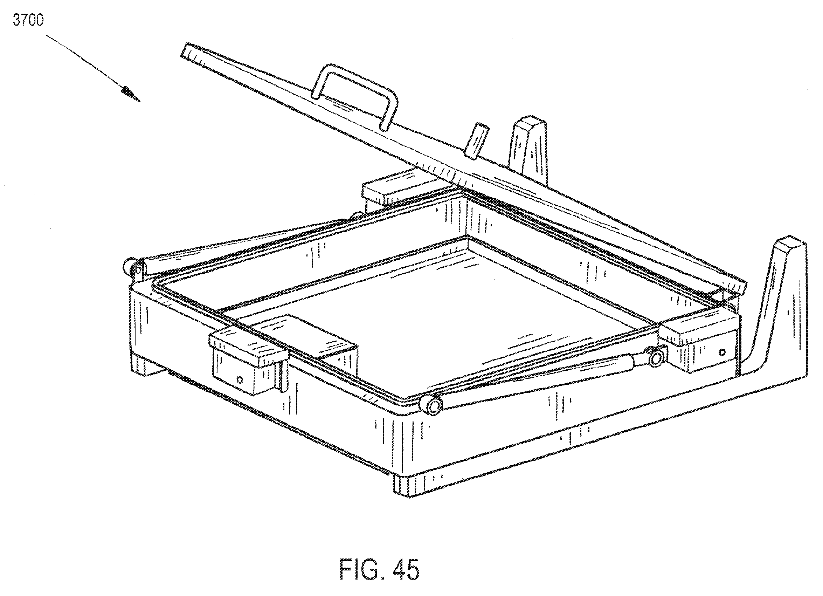

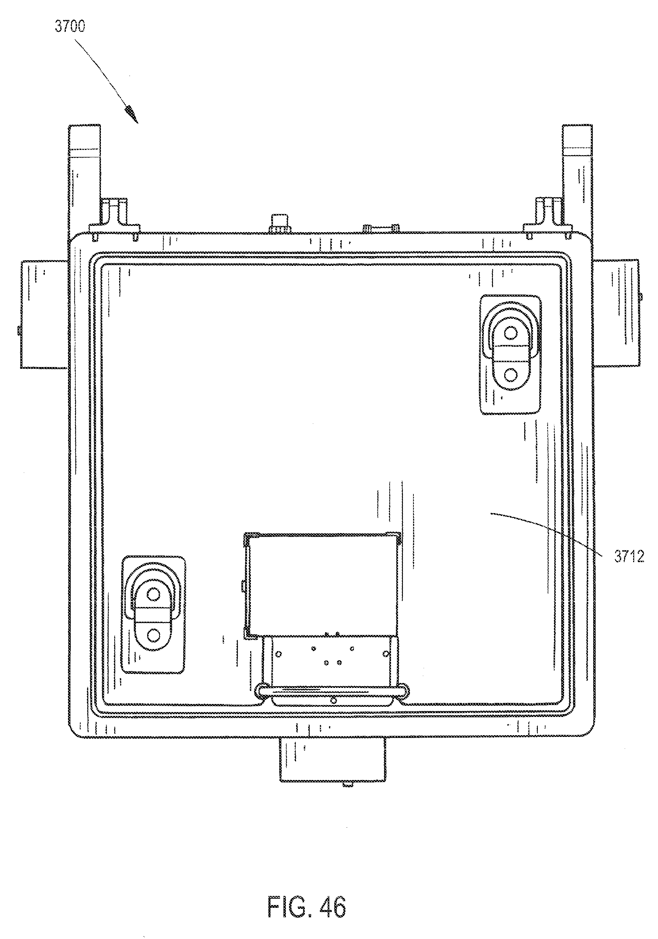

Referring to FIGS. 45 and 46, a horizontal planar substrate lamination apparatus 3700 is shown. The planar substrate lamination apparatus 3700 may comprise an insert 3712, as illustrated in FIGS. 46, 47A, and 47B. It is further contemplated that, in an implementation utilizing, for example, at least one bladder to provide uniform pressure to a laminated substrate assembly, a planar substrate lamination apparatus insert 3712 may be configured to hold a laminated assembly (e.g., display) in place. In such an embodiment, a pressure may be applied to an interior cavity of the horizontal planar substrate lamination apparatus 3700. Such interior cavity pressure may be higher than a pressure applied, for example, to keep one or more substrates in place.

Referring to FIG. 47B, a mask 3740 may provide additional functions, such as protecting peripheral appendages and accessories of the planar substrates from bladder damage (e.g., in a system where pressure may be applied to the system via one or more bladders) during lamination in the planar substrate lamination apparatus 3700. The mask 3740 may be positioned above the insert 3712 within an alignment system. The mask 3740 may comprise a substantially planar mask body defining a mask aperture. The mask aperture may be configured so as to fit around at least one substrate alignment guide 3724. For example, the mask aperture may comprise alignment guide aperture portions which may allow the mask 3740 to be secured substantially about at least one substrate alignment guide 3724. The mask 3740 may serve to protect portions of a substrate that may be beyond the periphery of the mask aperture.

Referring to FIGS. 48 and 39, a front view of an alignment aid 3714 is shown. The alignment aid 3714 offsets the uncommon datum of the planar items when the planar items are placed inside the planar substrate lamination apparatus for alignment 3700. The alignment aid 3714 may offset the different sizes, shapes, and/or thicknesses of the planar items by utilizing pegs 3716, bumps 3718, and/or any other suitable mechanism for specifically positioning a planar item within the planar substrate lamination apparatus.

The planar items may be placed in the tooling aid, such as an alignment aid prior to inserting the alignment aid into the alignment aid holder in the planar substrate lamination apparatus. The tooling aid 3208 may be placed inside of the planar substrate lamination apparatus 3210 before the planar items may be placed into the planar substrate lamination apparatus 3210 for lamination. The order and/or sequence of configuration may depend upon the type of alignment system utilized, type of tooling aid utilized, and/or the type of planar substrate lamination apparatus utilized.

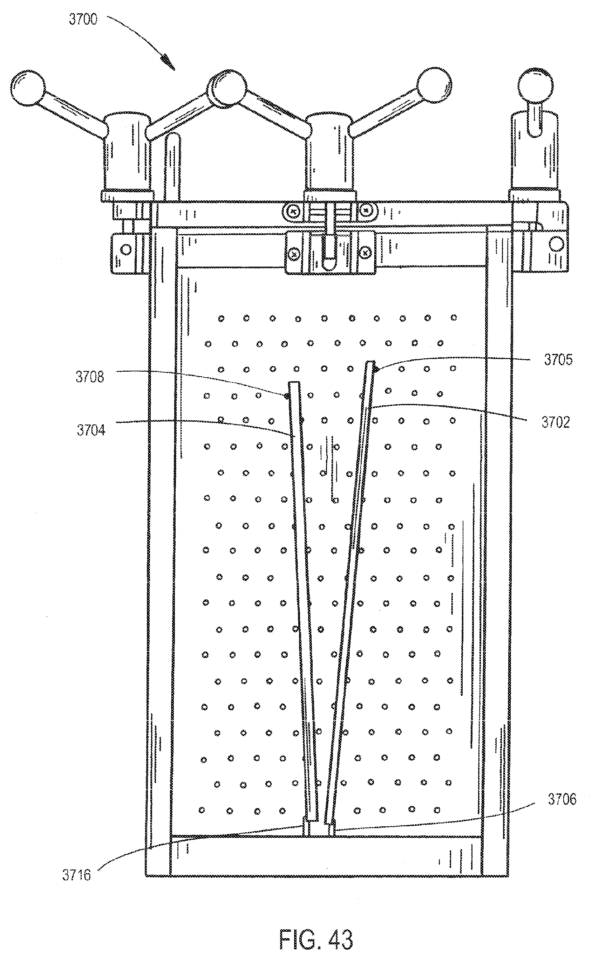

The planar substrate lamination apparatus 3210 may be a vertical planar substrate lamination apparatus 3700, as illustrated in FIGS. 42 and 43. The planar substrate lamination apparatus 3210 may be a horizontal planar substrate lamination apparatus 3700 as illustrated in FIGS. 45 and 46. Both planar substrate lamination apparatuses 3700 (vertical and horizontal) may require the proper vertical and horizontal positioning of the planar items. The planar substrate lamination apparatus 3210 and the tooling system 3204 may utilize robotic handling technology and/or systems. The functions of the planar substrate lamination apparatus 3210 and the tooling system 3204 may also be manually performed. The tooling system 3204 essentially directs the planar substrate lamination apparatus's placement of the planar items. The proper alignment of the substrates may provide for proper registration between mating substrates.

Referring to FIG. 38, a block diagram of an alignment system 3300 is shown. Each type of planar item may be pre-engineered into a desired size, shape, and/or thickness making the datum the same for each planar item of that type. Therefore, the datum is known for each type of planar item. The pre-calculated datum may be sent to a tooling system 3302. The tooling system 3302 utilizes the pre-calculated datum and a location determiner 3304 to determine the proper alignment positions of the planar items. The location determiner 3304 locates the pre-calculated datum and instructs the tooling system how to properly form the tooling aids 3306 to provide the planar substrate lamination apparatus 3308 with the proper alignment position for the planar items.

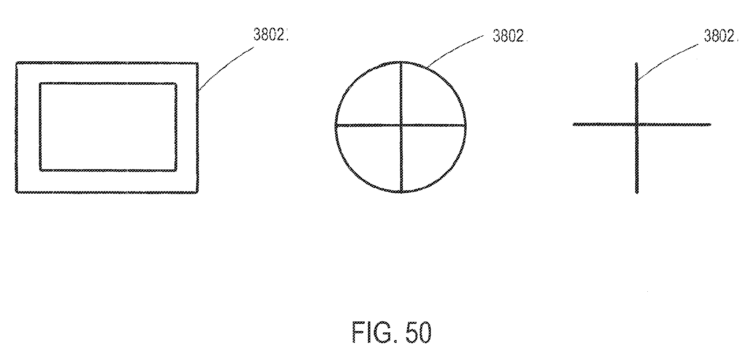

Referring to FIG. 39, a block diagram of an alignment system 3400 is shown. Planar items may be marked with at least one fiducial alignment marker 3402. A fiducial alignment marker 3402 may be any desired shape, symbol, and/or marking. For instance, a fiducial alignment marker 3402 may include, but may not be limited to, at least one of the symbols 802 shown in FIG. 50. It is contemplated that any suitable fiducial alignment symbol may be utilized without departing from the scope and intent of the disclosure. A fiducial alignment marker 3402 may be placed on the planar items to mark a desired reference point. The fiducial alignment marker 3402 may be placed on the planar items in a predetermined position, unlike the datum, which are calculated. The tooling system 3404 may locate a fiducial alignment marker 3402 by utilizing a location determiner, such as the location determiner 3206 as shown in FIG. 37. The fiducial marker may be recognized, and/or read by an optical device 3406 such as a laser, light, or camera sensor. The tooling system 3404 may then determine the proper alignment position for the planar items by aligning the fiducial alignment marker 3402. The tooling system 3404 utilizes the proper alignment position to provide the planar substrate lamination apparatus 3410 with proper alignment position for the planar items by forming the proper tooling aid 3408. The tooling aid is inserted into the planar substrate lamination apparatus 3410 to provide the proper alignment of the planar items in the planar substrate lamination apparatus 3410.

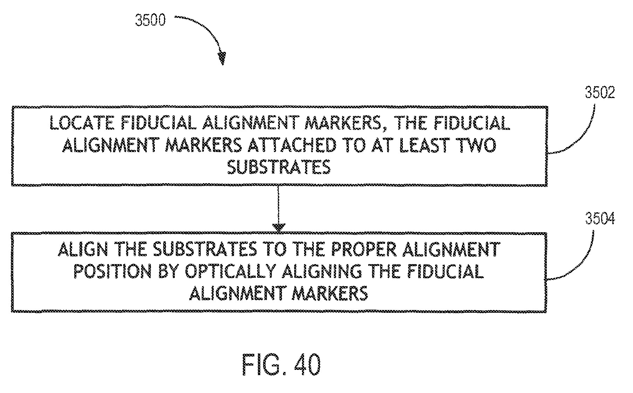

Referring to FIG. 40, a method diagram of a method for alignment 3500 is shown. Method 3500 locates at least one fiducial alignment marker, the at least one fiducial alignment marker may be attached to at least two substrates, (e.g., the plurality of planar items 3502). Method 3500 may align the at least two substrates to the proper alignment position by optically aligning the at least one fiducial alignment marker, 504. Method 3500 may be performed by the system 3400 disclosed above.

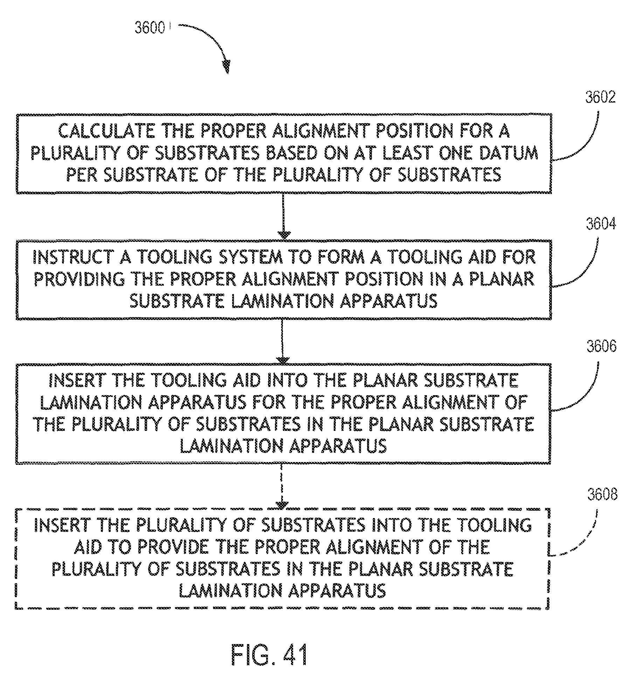

Referring to FIG. 41, a method diagram of a method for alignment 3600 is shown. Method 3600 calculates the proper alignment position for a plurality of planar items based on at least one datum per planar item of the plurality of planar items, 602. Method 3600 instructs a tooling system to form a tooling aid for providing the proper alignment position in a planar substrate lamination apparatus, 604. Method 3600 inserts the tooling aid into the planar substrate lamination apparatus for the proper alignment of the plurality of planar items in the planar substrate lamination apparatus, 606. Method 3600 may further insert the plurality of planar items into the tooling aid to provide the proper alignment of the plurality of planar items in the planar substrate lamination apparatus, 608. Method 3600 may further comprise pre-engineering the plurality of planar items to a desired size. Method 3600 may further comprise mechanically calculating the at least one datum for each of the planar items. Method 3600 may further comprise optically calculating the at least one datum for each of the planar items. Method 3600 may be performed by the systems 3200 and 3300 disclosed above.

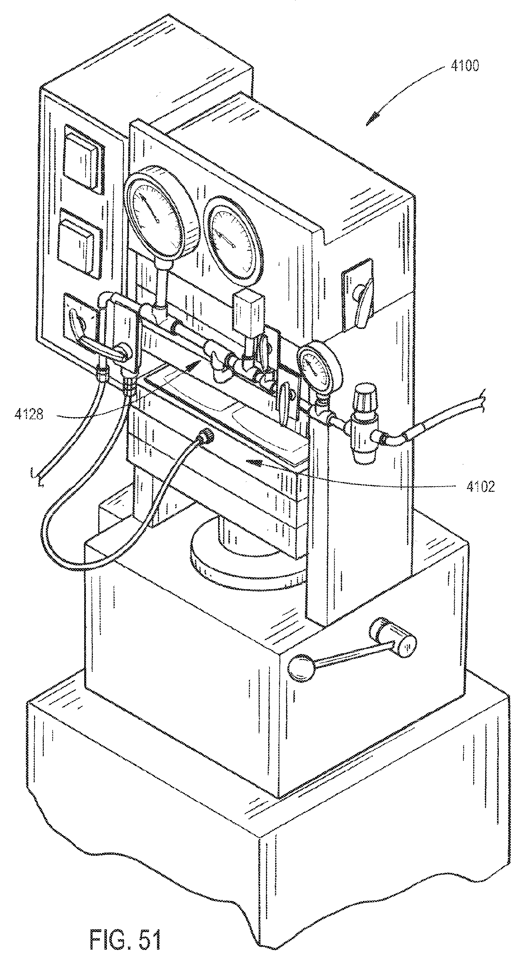

Referring now generally to FIGS. 51-56, a system for performing planarization treatment of pressure-sensitive adhesive (PSA), such as commercially available PSA (e.g., dry film pressure-sensitive adhesive, acrylic lamination material), is shown in accordance with an exemplary embodiment. The planarization process/treatment may be performed to promote increased suitability of the PSA for use in lamination processes, such as rigid-to-rigid lamination processes, in which rigid substrates may be joined/secured together via the PSA, said substrates being optical or non-optical substrates, or sheet-like assemblies (e.g., Liquid Crystal Displays (LCDs), Organic Light-Emitting Diodes (OLEDs), Circuit Boards, Heat Sinks, etc.), in such a manner as to avoid the appearance of undesirable optical effects or visual anomalies (e.g., blotches or voids on a display). The planarization process described herein promotes increased suitability of the PSA for rigid-to-rigid substrate lamination processes by flattening the PSA to a sufficient level of flatness and/or to a sufficient degree of uniformity of flatness to avoid the above-referenced undesirable optical effects/visual anomalies. In a current embodiment, the system 4100 includes a planarization tool 4102. The planarization tool 4102 includes a support portion 4104. For instance, the support portion 4104 may be a rectilinearly-shaped, tray-like apparatus. In an exemplary embodiment, the support portion 4104 includes a support surface 4106. The support surface 4106 is configured for supporting one or more PSA blocks 4108.

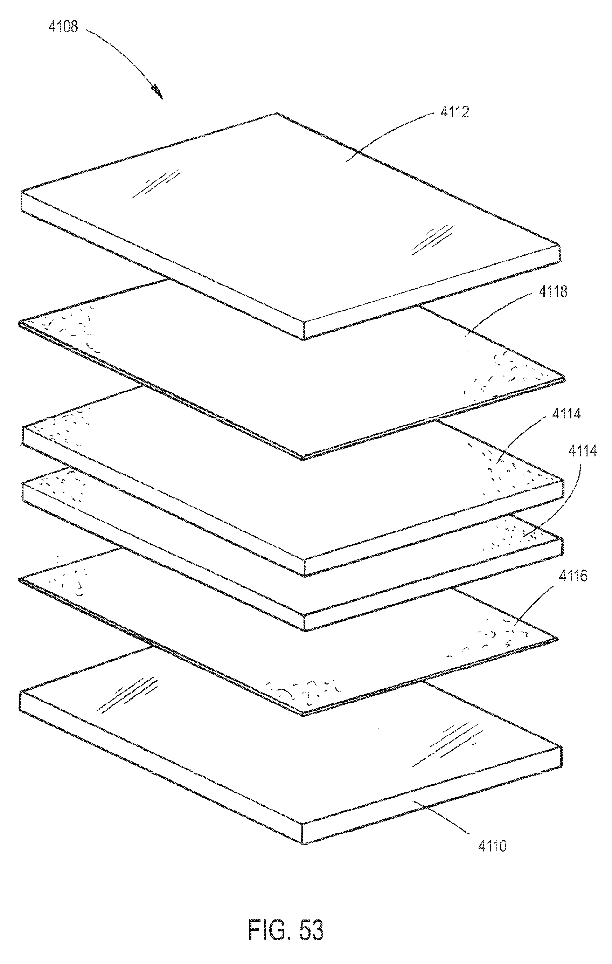

As shown in FIG. 53, one or more of the PSA blocks 4108 may include a first substrate 4110, a second substrate 4112 and one or more layers of PSA 4114, the one or more layers of PSA 4114 being positioned or "sandwiched" between the first substrate 4110 and the second substrate 4112. Preferably the first substrate 4110 and/or the second substrate 4112 may be formed of glass (e.g., may be glass plates). For example, the first substrate/glass plate 4110 may have a first thickness, while the second substrate/glass plate 4112 may have a second thickness, (e.g., 5 millimeters) the second thickness typically being greater than the first thickness (i.e., the first glass plate 4110 may be a "thin" glass plate, the second glass plate 4112 may be a "thick" glass plate). In alternative embodiments, the first substrate 4110 and/or the second substrate 4112 may be formed of plastic, metal, rubber or the like. In additional embodiments, the first substrate 4110 may be LCD coverglass or a touch panel, and the PSA layer(s) 4114 may be pre-adhered, pre-laminated, or pre-coated onto the first substrate 4110 prior to being "sandwiched" by the second substrate 4112 (e.g., top glass plate/flattening glass). In further embodiments, one or more of the PSA blocks 4108 may further include a first plastic film layer 4116, the first plastic film layer 4116 being positioned or "sandwiched" between the first substrate 4110 and the PSA layer(s) 4114. Still further, one or more of the PSA blocks 4108 may further include a second plastic film layer 4118, the second plastic film layer 4118 being positioned or "sandwiched" between the second substrate 4112 and the PSA layer(s) 4114. For instance, the first and second plastic film layers (4116, 4118) may be formed of polyethylene, polyester, polypropylene, or the like. Further, the first and second plastic film layers (4116, 4118) may be positioned as described above in order to prevent the PSA layer(s) 4114 from sticking/adhering to the first and second substrates (4110, 4112).

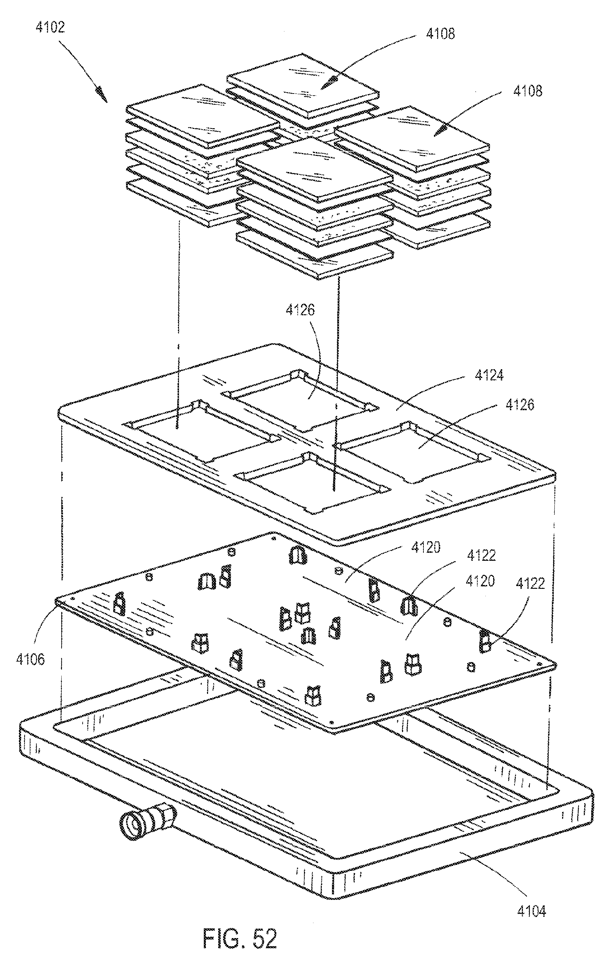

In an exemplary embodiment, as shown in FIG. 52, the support surface 4106 of the planarization tool 4102 is configured with one or more holders or pockets 4120. Each holder 4120 may be shaped and sized for receiving at least one PSA block 4108. For example, a holder 4120 may be rectilinearly-shaped for receiving a correspondingly rectilinearly-shaped PSA block 4108. Further, the holder 4120 may include a plurality of brackets 4122, such as corner brackets, for maintaining/securing the PSA block 4108 within the holder 4120. In alternative embodiments, the PSA block 4108 may be secured within/by the holder via various mechanisms, such as by using clips, fasteners, edging or the like.

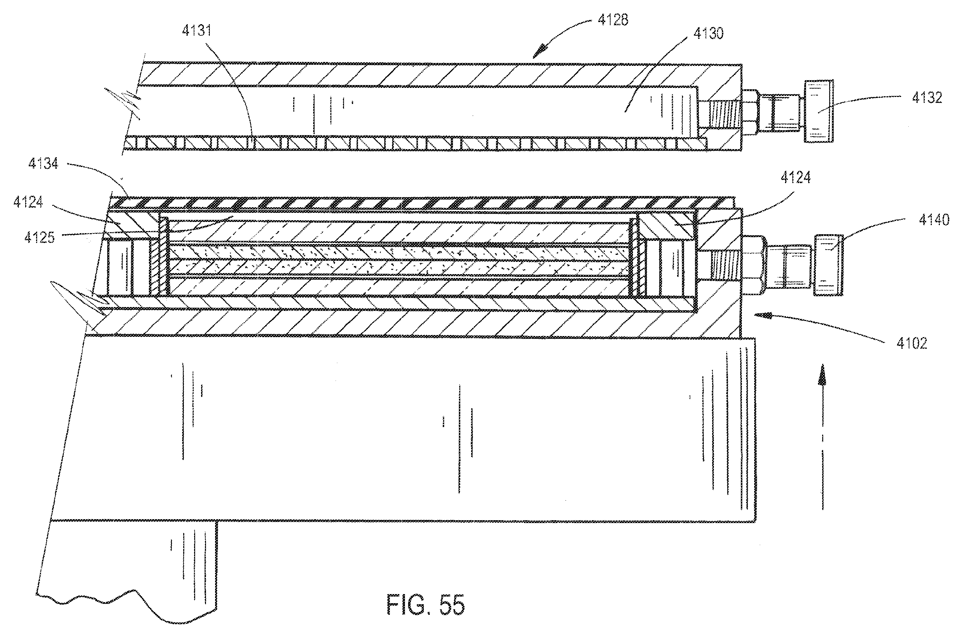

In some embodiments, the planarization tool 4102 may include a carriage, mask, or insert 4124. The carriage 4124 may be configured for being removably placed upon the support surface 4106 of the support portion 4104. For instance, the carriage 4124 may be a rectilinearly-shaped lid or cover-like structure which may be seated within a correspondingly-shaped/sized tray-like or pan-like support portion 4104 and upon the support surface 4106. In further embodiments, when the carriage 4124 is seated upon the support surface 4106, the carriage 4124 and the support portion 4104 form a partial enclosure 4125 (see FIG. 55).

In exemplary embodiments, a surface of the carriage 4124 may form one or more apertures 4126/may have one or more apertures 4126 formed therethrough. Further, the aperture(s) 4126 may be shaped/sized for allowing physical access to PSA block(s) 4108 positioned on the support surface 4106. For example, one or more PSA block(s) 4108 may be positioned within one or more holders 4120 on the support surface 4106 of the planarization tool 4102. Further, as previously discussed, when the carriage 4124 of the present invention is seated upon the support surface 4106 and within the tray-like support portion 4104, the support portion 4104 and the carriage 4124 form a partial enclosure 4125 (see FIG. 55). Still further, the apertures 4126 formed by the carriage 4124 allow physical access to the PSA block(s) (e.g., access to the second or top substrate 4112) positioned within the holders 4120 on the support surface 4106. For instance, the apertures 4126 may be formed such that when the carriage 4124 is positioned on the support surface 4106 and within the support portion 4104, said apertures 4126 may be aligned, shaped and sized so as to promote ease of physical access to PSA blocks 4108 positioned within the holders 4120 on the support surface 4106. Further the number of apertures 4126 of the carriage 4124 may be equivalent to the number of holders 4120 on the support surface 4106.

In additional embodiments, as shown in FIG. 51, the system 4100 includes a pressurization tool 4128, such as a vacuum press or hydraulic press (e.g., a 50 ton press). In exemplary embodiments, the pressurization tool 4128 may be configured as/may form a partial enclosure 4130, and may include a plenum or plenum diffuser screen 4131 to promote uniformity. In further embodiments, the partial enclosure 4130 may be configured with a port 4132, said port 4132 configured for being connected to a pressurizing source. In alternative embodiments, the pressurization tool 4128 may be a pressure vessel.

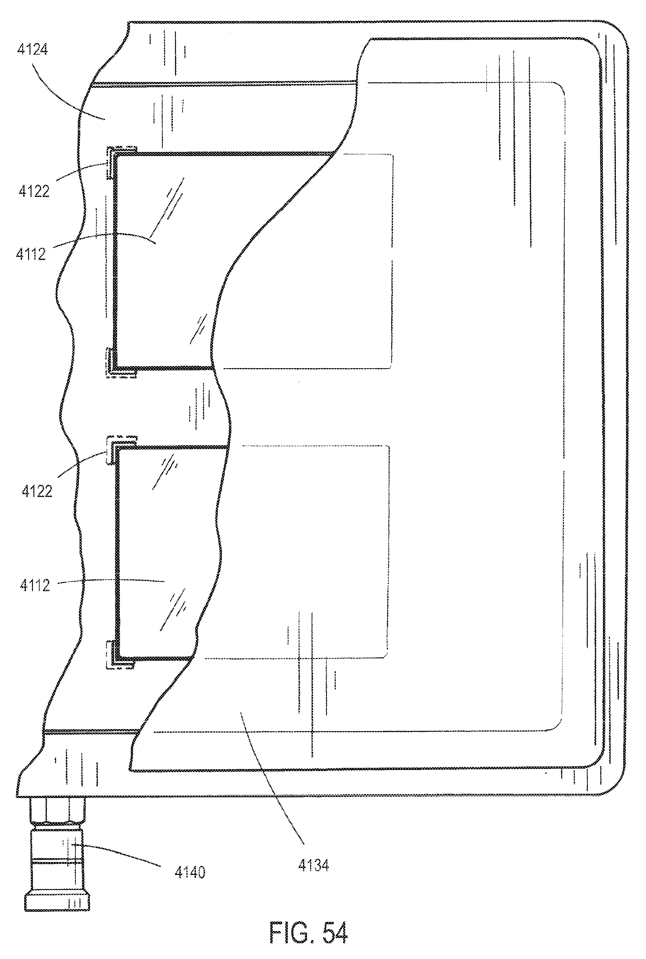

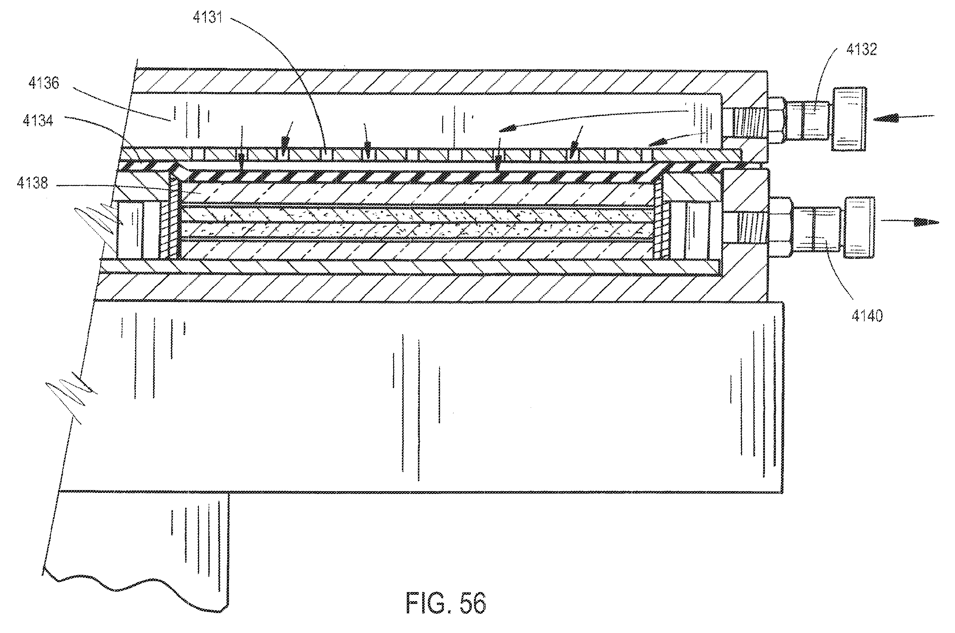

In some embodiments, as shown in FIGS. 54-56, the system 4100 may include a flexible membrane 4134. The flexible membrane 4134 may be configured for being positioned or "sandwiched" between the planarization tool 4102 and the pressurization tool 4128. (See FIG. 56). When positioned or "sandwiched" between the planarization tool 4102 and the pressurization tool 4128, the flexible membrane 4134 may further be configured for sealing the partial enclosure 4130 of the pressurization tool 4128 to create a first sealed cavity 4136. Additionally, when positioned or "sandwiched" between the planarization tool 4102 and the pressurization tool 4128, the flexible membrane 4134 may further be configured for sealing the partial enclosure 4125 of the planarization tool 4102 to create a second sealed cavity 4138. In further embodiments, the flexible membrane 4134 may be formed of an elastic material, such as silicone. Still further, the material forming the flexible membrane 4134 may be chosen based on properties such as electrostatic discharge (ESD) properties, tear strength, elongational properties, or the like. Further, the flexible membrane 4134 may be coated with one or more layers of plastic (e.g., polyethylene) or other like material, the surface of which won't hold an electric charge (e.g., an electric charge won't be created on its surface) when said material is peeled/pulled away/removed from another material/surface.

As discussed above, the partial enclosure 4130 may be configured with a port 4132, said port 4132 configured for being connected to a pressurizing source. The partial enclosure 4130 (see FIG. 55), including the plenum diffuser screen 4131, may be directed or positioned against the flexible membrane 4134 (see FIG. 56), said flexible membrane 4134 having been positioned upon the planarization tool 4102. When the flexible membrane 4134 is positioned or "sandwiched" between the planarization tool 4102 and the pressurization tool 4128, the pressurization tool 4128 is connected via the port 4132 to a pressurizing source. Once the pressurization tool 4128 is connected to the pressurizing source, the first sealed cavity 4136 formed by the pressurization tool 4128 (e.g., partial enclosure 4130 of the pressurization tool 4128) and the flexible membrane 4134 may be pressurized (e.g., a positive pressure may be created within the first sealed cavity 4136 as shown in FIG. 56). For example, the first sealed cavity 4136 may be pressurized to a pressure from five (5) to two hundred (200) pounds per square inch gauge (psig). Preferably, the first sealed cavity is pressurized to a pressure of fifty (50) psig. The flexible membrane 4134 may be configured for applying the pressure created within the first sealed cavity 4136 to the PSA block(s) 4108 positioned on the support surface 4106 of the planarization tool 4102. For instance, the positive pressure created within the first sealed cavity 4136 may cause the flexible membrane to expand and be directed through/via the aperture(s) 4126 of the carriage 4124 against the second substrate 4112 (e.g., cover glass layer) of the PSA block, thereby exerting the applied pressure against the PSA block.

In exemplary embodiments, as shown in FIG. 56, the carriage 4124 may be configured for causing the positive pressure applied by the flexible membrane 4134 against the PSA block(s) 4108 to be applied in a generally uniform, unidirectional, and localized manner, thereby avoiding the occurrence of isolated areas of pressure or areas of varying pressures being created around or proximal to the holder(s) 4120. The pressure applied to the second substrate 4112 of the PSA block 4108 causes the PSA layer(s) to be flattened between the first substrate 4110 and second substrate 4112. The first substrate 4110 and second substrate 4112 are selected and utilized for enhancing flatness of the PSA layer(s) 4114, the substrates (4110, 4112) also selected and utilized to provide for uniform squeezing of the PSA layer(s) 4114. This squeezing or flattening of the PSA layer(s) 4114 provides a PSA product (e.g., the planarized or flattened PSA 4114) which is suitable for use in rigid-to-rigid lamination processes, such as rigid-to-rigid lamination processes for ruggedization of displays/display products (e.g., lamination of rigid-to-rigid substrates, such as LCDs, OLEDs, Circuit Boards, Heat Sinks, etc.). In exemplary embodiments, the PSA product may have a suitable/desirable level of flatness or thickness and may also have a suitable/desirable degree of uniformity of flatness or thickness.

In some embodiments, the planarization tool 4102 may be configured with a port 4140, said port 4140 configured for allowing the planarization tool 4102 to be connected to a vacuum pump. In exemplary embodiments of the present invention, as shown in FIG. 56, a vacuum may be created and applied/pulled within the second sealed cavity 4138 formed by the planarization tool 4102 and the flexible membrane 4134. Preferably, the vacuum/vacuum pressure may be ten (10) Torr or less. In further embodiments, the vacuum may be applied within the second sealed cavity 4138 while the first sealed cavity 4136 is being pressurized and the flexible membrane 4134 may apply the pressure created in the first sealed cavity 4136 while the vacuum is being pulled in the second sealed cavity 4138, thereby enhancing flattening of the PSA 4114 during the planarization treatment or process.

In exemplary embodiments, the system 4100 may include one or more substitute support surfaces 4106 configured for being interchanged/substituted for the support surface 4106 of the planarization tool 4102. Further, the substitute support surface(s) 4106 may be configured with at least one PSA block holder 4120, the PSA block holder(s) 4120 of the substitute support surface(s) 4106 differing in size and/or number from the holder(s) 4120 of the support surface 4106 of the planarization tool 4102. For example, the system 4100 may be utilized for flattening PSA layers 4114 of various dimensions/sizes, such as to make them suitable for use in laminating/ruggedization processes for different sized displays. For instance, the support surface 4106 may have four holders 4120, each sized for receiving PSA layers 4114 for use in five-inch displays, while a substitute support surface 4106 may have one, larger holder 4120, sized for receiving larger PSA layers 4114 which may be used in creating larger, ruggedized, rigid-to-rigid laminated displays. In additional embodiments, the system 4100 of the present invention may also have one or more substitute carriages 4124 configured for being interchanged/substituted for the carriage 4124 of the planarization tool 4102. The substitute carriage 4124 may form at least one PSA block access aperture 4126 for allowing physical access to PSA block(s) 4108 positioned within PSA block holder(s) 4120 of the substitute support surface 4106. Further, the PSA block access aperture(s) of the substitute carriage 4124 may differ in size and/or number from the aperture(s) of the carriage 4124. For example, if the support surface 4106 includes four holders 4120, the carriage 4124 may have four apertures 4126 correspondingly sized with the holders 4120, while if the substitute support surface 4106 has one, larger holder 4120, the substitute carriage 4124 (which is used with the substitute support surface 4106) may have a single correspondingly-sized aperture to allow for physical access to the single, larger-sized PSA layer(s) 4114 supported on the substitute surface 4106. In alternative embodiments, the larger-size PSA layer(s) 4114 may be cut to size so as to be suitably sized for utilization with differently sized carriages 4124, support surfaces 4106 and/or holders 4120.

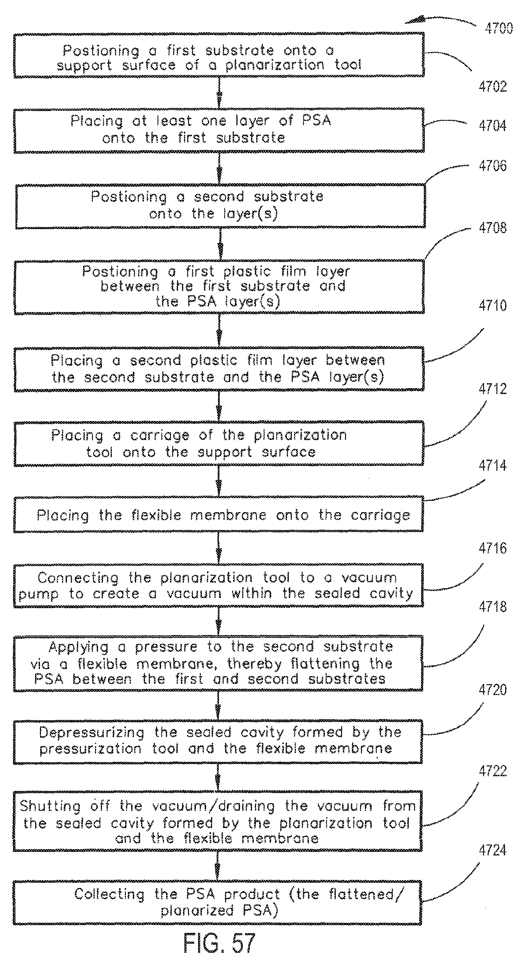

FIG. 57 illustrates a process for performing a planarization treatment of pressure-sensitive adhesive (PSA). The process 4700 may include the step of positioning a first substrate onto a support surface of a planarization tool 4702. For instance, the first substrate 4110 may be a glass plate positioned onto the support surface 4106 of the planarization tool 4102. The process 4700 may further include placing at least one layer of PSA onto the first substrate 4704. For example, one or multiple layers of commercially available PSA 4114 may be stacked onto the first substrate (e.g., glass plate 4110). The process 4700 may further include positioning a second substrate onto the layer(s) of PSA 4706. For instance, the second substrate 4112 may be a thick glass top plate placed onto the layer(s) of PSA 4114 for "sandwiching" the PSA 4114 between the first substrate 4110 and second substrate 4112.

In exemplary embodiments, the process 4700 may further include applying a pressure to the second substrate via a flexible membrane 4718. In further embodiments, the pressure is applied by the flexible membrane 4134 to the second substrate 4112 in a generally uniform, unidirectional and localized manner. The applied pressure may flatten the PSA 4114 between the first substrate 4110 and the second substrate 4112 for promoting suitability of the PSA 4114 for use in rigid-to-rigid lamination processes. The step of applying a pressure to the second substrate via the flexible membrane 4718 may include the sub-step of placing the planarization tool 4102 into a pressurization tool 4128, such as a press. The pressurization tool 4128 may be utilized to apply the pressure via the flexible membrane 4134 to the second substrate 4112/PSA block(s) 4108, as previously described above. The step of applying a pressure to the second substrate via the flexible membrane 4718 may further include the sub-step of directing a partial enclosure 4130 of the press 4128 against the flexible membrane 4134, said flexible membrane 4134 having been positioned upon the planarization tool 4102, thereby "sandwiching" the flexible membrane 4134 between the planarization tool 4102 and the pressurization tool/press 4128. The step of applying a pressure to the second substrate via the flexible membrane 4718 may further include connecting the port 4132 of the pressurization tool 4128 to a pressurization source for creating the applied pressure within the sealed cavity (e.g., for pressurizing the sealed cavity) 4136 formed by the flexible membrane 4134 and pressurization tool 4128. The flexible membrane 4134 may be configured for applying the pressure created within the first sealed cavity 4136 to the PSA block(s) 4108 positioned on the support surface 4106 of the planarization tool 4102. For instance, the positive pressure created within the first sealed cavity 4136 may cause the flexible membrane to expand and be directed through/via the aperture(s) 4126 of the carriage 4124 against the second substrate 4112 (e.g., cover glass layer) of the PSA block, thereby exerting the applied pressure against the PSA block.

In further embodiments, prior to applying the pressure, the process 4700 may further include positioning a first plastic film layer between the first substrate and the PSA layer(s) 4708. In additional embodiments, prior to applying the pressure, the process may further include placing a second plastic film layer between the second substrate and the PSA layer(s) 4710.

In some embodiments, prior to applying the pressure, the process 4700 may further include placing a carriage of the planarization tool onto the support surface 4712. For example, the carriage 4124 may be configured for allowing the applied pressure to be applied to the second substrate 4112 in a generally uniform, unidirectional and localized manner. In additional embodiments, prior to applying the pressure, the process 4700 may further include placing the flexible membrane onto the carriage 4714. For instance, the flexible membrane 4134 may be configured for forming a sealed cavity 4138 with the planarization tool 4102, the sealed cavity 4138 containing the PSA block(s) 4108, which may include the first substrate 4110, the PSA layer(s) 4114, the second substrate 4112, the first plastic film layer 4116 and the second plastic film layer 4118.

In exemplary embodiments, the process 4700 may further include, prior to applying the pressure, connecting the planarization tool to a vacuum pump to create a vacuum within the sealed cavity 4716. For example, the vacuum may be created within/applied to the sealed cavity 4138 formed by the planarization tool 4102 and the flexible membrane 4134, thereby applying a vacuum/negative pressure to the PSA block(s) 4108, said PSA block(s) may include the first substrate 4110, the PSA layer(s) 4114, the second substrate 4112, the first plastic film layer 4116 and the second plastic film layer 4118. Preferably, the vacuum/negative pressure and the applied (e.g., positive) pressure are concurrently applied to the PSA block(s) 4108 (e.g., the first substrate 4110, the PSA layer(s) 4114, the second substrate 4112, the first plastic film layer 4116 and the second plastic film layer 4118). In alternative embodiments of the present invention the positive pressure may be applied to the PSA block(s) 4108 prior to applying the vacuum (e.g., negative pressure) to the PSA block(s), or the positive pressure may be applied to the PSA block(s) 4108 without applying a vacuum/negative pressure to the PSA block(s) 4108.

In additional embodiments, once the PSA 4114 has been subjected to the applied pressure, the applied vacuum and/or an applied temperature for a desired duration of time (e.g., when a desired level of flatness/uniformity of flatness for the PSA has been reached) the process 4700 may further include depressurizing the sealed cavity formed by the pressurization tool and the flexible membrane 4720. In exemplary embodiments, the process 4700 may further include, shutting off the vacuum/draining the vacuum from the sealed cavity formed by the planarization tool and the flexible membrane 4722. In alternative embodiments of the process 4700 of the present invention, the vacuum may be drained from the second sealed cavity 4138 prior to depressurizing the first sealed cavity 4136 or, the first sealed cavity 4136 may be depressurized prior to draining the vacuum from the second sealed cavity 4138. In further embodiments, the process 4700 may further include collecting the PSA product (the flattened/planarized PSA 4114) 4724. For instance, the step of collecting the PSA product 4724 may include the sub-steps of: drawing the partial enclosure 4130 of the pressurization tool 4128 away from the planarization tool 4102; removing the flexible membrane 4134 from the carriage 4124; removing the carriage 4124 from the support portion 4104; removing the PSA block(s) 4108 from the holder(s) 4120; removing the second substrate 4112; removing the second plastic film layer 4118; and removing the PSA product (e.g., flattened PSA layer(s) 4114) from the first plastic film layer 4116 and the first substrate 4110.

In some embodiments, the process 4700 described above may be performed at various temperatures, such as ambient temperature. For example, the press 4128 may have selectable settings for establishing a desired temperature at which the process 4700 is to be performed. In further embodiments, PSA 4114 may be subjected to the applied pressure and vacuum for varying durations of time, such as a duration ranging from five minutes to twenty-four hours. Preferably, the pressure and vacuum may be concurrently applied to the PSA 4114 for at least fifteen minutes. In exemplary embodiments, the process 4700 (e.g., planarization treatment) of the present invention may implement controlled application of pressure, temperature and time for providing PSA product which is suitable for use in rigid-to-rigid lamination processes. For instance, said PSA product may be planarized (e.g., flattened) layers of PSA 4114 which are flattened to a suitable/desired level of flatness/thickness and/or to a suitable/desired level of uniformity, such that they may be used during rigid-to-rigid lamination processes to interface between an LCD and a coverglass or touchscreen of a display in a uniform manner for providing a uniform (e.g., blotch-free, visual anomaly-free) display. Further, said PSA product may be a cut-to-size component having exceptional edge quality for minimizing edge defects and facilitating automation of said rigid-to-rigid lamination processes for producing low-cost, ruggedized displays.

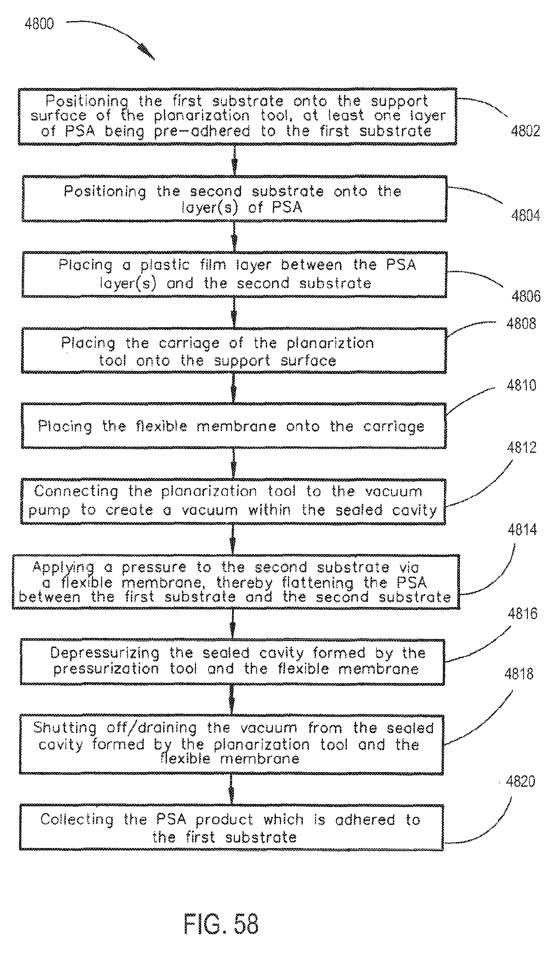

Referring to FIG. 58, for embodiments in which the PSA layer(s) 4114 are pre-adhered to the first substrate 4110, a process 4800 for performing a planarization treatment of pressure-sensitive adhesive (PSA) is shown. In exemplary embodiments, the process 4800 includes positioning the first substrate onto the support surface of the planarization tool, such that a first surface of the first substrate is in contact with the support surface and a second surface of the first substrate, generally opposite the first surface, is oriented away from the support surface 4802. Further, at least one layer of PSA may be pre-adhered to the first substrate.

In further embodiments, the process 4800 may further include positioning the second substrate onto the layer(s) of PSA 4804. Still further, the process 4800 may include applying a pressure to the second substrate via a flexible membrane, said pressure being applied in a generally uniform, unidirectional and localized manner, wherein the applied pressure flattens the PSA between the first substrate and the second substrate for promoting suitability of the PSA for use in rigid-to-rigid lamination processes 4814. The process 4800 may further include, prior to applying the pressure, placing a plastic film layer between the PSA layer(s) and the second substrate 4806. The process 4800 may further include, prior to applying the pressure, placing the carriage of the planarization tool onto the support surface 4808. The process 4800 may further include, prior to applying the pressure, placing the flexible membrane onto the carriage 4810. The process 4800 may further include, prior to applying the pressure, connecting the planarization tool to the vacuum pump to create a vacuum within the sealed cavity 4812. The process 4800 may further include, after applying the pressure, depressurizing the sealed cavity formed by the pressurization tool and the flexible membrane 4816. The process 4800 may further include shutting off/draining the vacuum from the sealed cavity formed by the planarization tool and the flexible membrane 4818. The process 4800 may further include collecting the PSA product (e.g., the flattened/planarized PSA which is adhered to the first substrate (e.g., LCD coverglass) 4820.

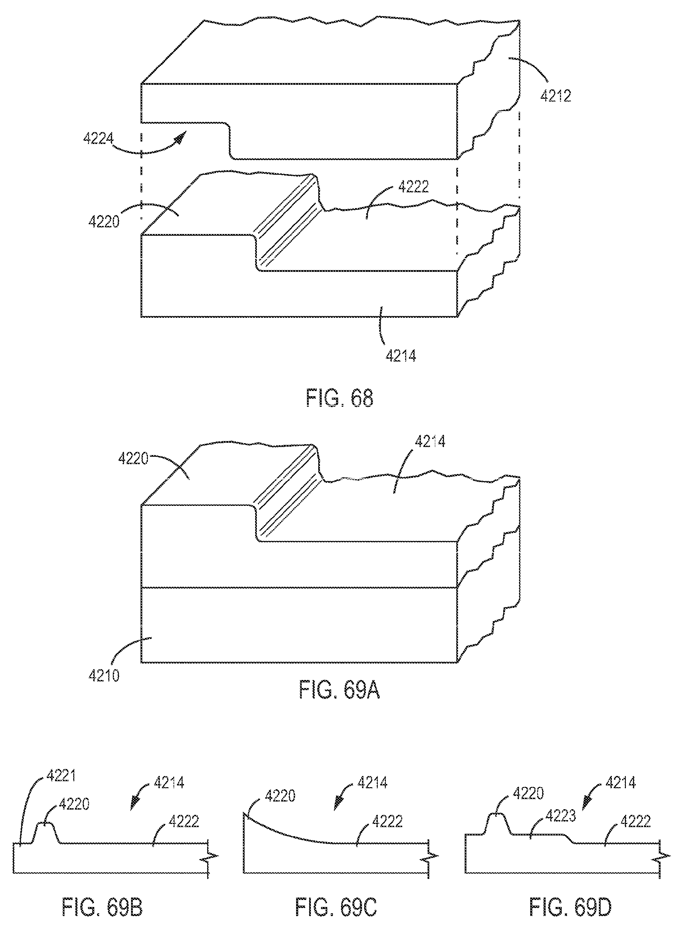

Referring to FIGS. 68-69D, a portion of a pressure sensitive adhesive (PSA) 4214 and corresponding insert 4212 (e.g., plate, mold tool, press, fixture, etc.) are shown according to an exemplary embodiment. As shown in FIG. 68, PSA 4214 may include a raised portion 4220 (e.g., a shim, thicker portion, step, etc.) that extends around all or a portion of the perimeter of PSA 4214. Raised portion 4220 may have a greater thickness than an inner portion 4222 (e.g. a remaining, lower, or bulk portion or area) of PSA 4214. Raised portion 4220 is intended to ensure a proper perimeter seal between laminated components (e.g., substrates such as LCD components, glass plates, etc.) and prevent air leakage into a laminates assembly, which may result in voids, bubbles, or other imperfections that may in turn adversely effect the performance of the laminated assembly. For example, because the lamination process may be performed within a vacuum environment (e.g., a vacuum chamber from which air has been evacuated), air may tend to leak back into the interior portion of the laminated assembly upon the laminated assembly being exposed to ambient air and pressure. Raised portion 4220 is intended to minimize such leakage.

According to an exemplary embodiment, raised portion may be formed (e.g., pressed, embossed, imprinted, etc.) during planarization of PSA 4214. For example, insert 4212 may include a recess 4224 (e.g., a formed portion, channel, depression, etc.) that has a shape corresponding to that of raised portion 4220 such that, by applying pressure to PSA 4214 via insert 4212, raised portion 4220 is formed (e.g., the thickness of inner portion 4222 is reduced such that inner portion 4222 has a lesser material thickness than raised portion 4220). Pressure may be applied to PSA 4214 via insert 4212 using, for example, a planarization tool such as planarization tool 4102 shown in FIG. 51 and in connection with a planarization process such as those described with respect to FIGS. 51-58.

Other means of providing a raised portion such as raised portion 4220 may be used according to various other embodiments. For example, referring to FIG. 69A, PSA 4214 may be bonded to a first substrate 4210 prior to raised portion 4220 being formed (e.g., during a repress operation subsequent to an intitial planarization process). Furthermore, in some embodiments, PSA 4214 may be processed (e.g., converted to an appropriate thickness) via a rolling process (e.g., in bulk form), and raised portion 4220 may be formed, embossed, etc. during a rolling process of PSA material.

According to one embodiment, raised portion 4220 may be continuous about the perimeter of PSA 4214, and may have a material thickness that is greater than the material thickness of inner potion 4222 by between approximately 5 microns and 10 microns, and may typically have a width of no greater then approximately. 125 inches (e.g., .125 inches, .066 inches, etc.), although raised portion 4220 may have other dimensions according to various other embodiments (e.g., a greater or lesser thickness and/or width than those discussed herein).

According to other exemplary embodiments, raised portion 4220 may be otherwise formed on PSA 4214. For example, as shown in FIG. 69B, raised portion 4220 may be provided as a bead or ridge that is bordered on one side by an inner portion 4222 and on the other side by an outer portion 4221, where both inner portion 4222 and outer portion 4221 have a thickness that is less than the thickness of raised portion 4220. As shown in FIG. 69C, the thickness of PSA 4214 may increase gradually from a minimum at inner portion 4222 to a maximum at raised portion 4220. As shown in FIG. 69D, PSA 4214 may have an area of intermediate thickness 4223 between raised portion 4220 and inner portion 4222.

PSA 4214 and raised portion 4220 may provide many advantages over a generally planar PSA material, including eliminating or minimizing microscopic non-uniformities in the PSA, preventing leakage of air into laminated assemblies, improving display uniformity over a greater temperature range, and so on, particularly when sensitive display components are used that may limit the pressure differentials that may be utilized during assembly of the laminated assembly.

PSA 4214 may be provided with a variety of peripheral configurations (e.g., PSA 4214 may have a perimeter that is generally square, rectangular, etc.), and a range of initial thickness (e.g., prior to formation of raised portion 4220). Furthermore, PSA 4214 may used in connection with any suitable lamination assembly or process described herein, and all such combinations of features are deemed to be within the scope of the present disclosure.

According to an exemplary embodiment, a laminated assembly (e.g., a stack, etc.) including two or more substrates (or laminated substrate sub-assemblies, etc.) may be laminated using one or more pressure sensitive adhesive layers such as PSA 4214, such that the pressure sensitive adhesive may have a raised portion that extends about the perimeter of the laminated assembly and between substrate layers. Any suitable substrates, substrate sub-assemblies, or adhesive materials may be utilized according to various alternative embodiments.

It is to be noted that one or more of the above-referenced systems or processes discussed herein may be adaptable for allowing rolls of PSA to be planarized. For example, one or more of the above-referenced systems may be adaptable to allow for roll-to-roll planarization of PSA, in which a roll of PSA is fed into the system and planarized. Further, one or more of the above-referenced processes may also be variable/adaptable to allow for roll-to-roll planarization. As discussed above, one or more raised portions such as raised portion 4220 may be formed during such a process.

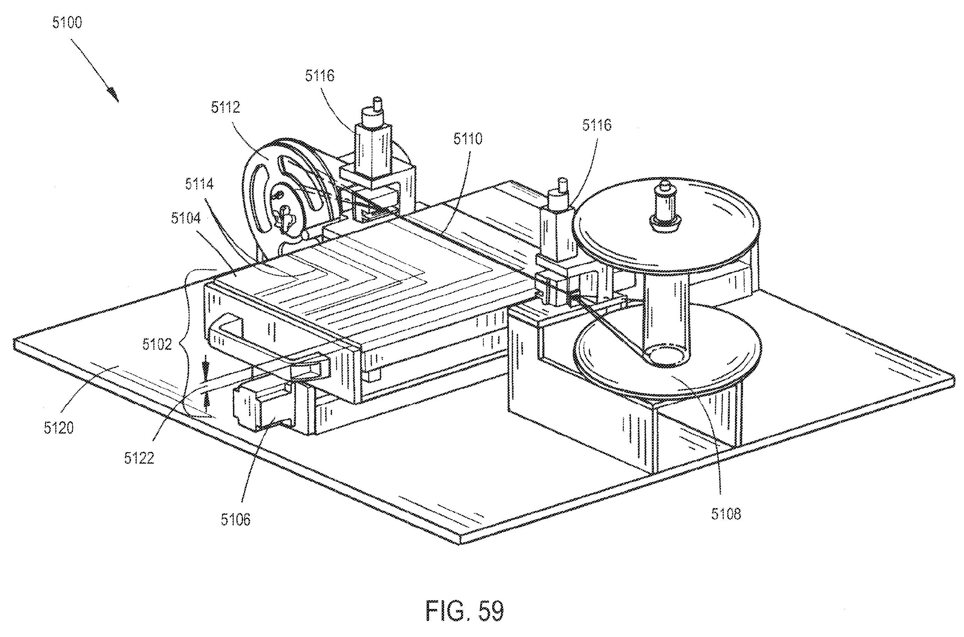

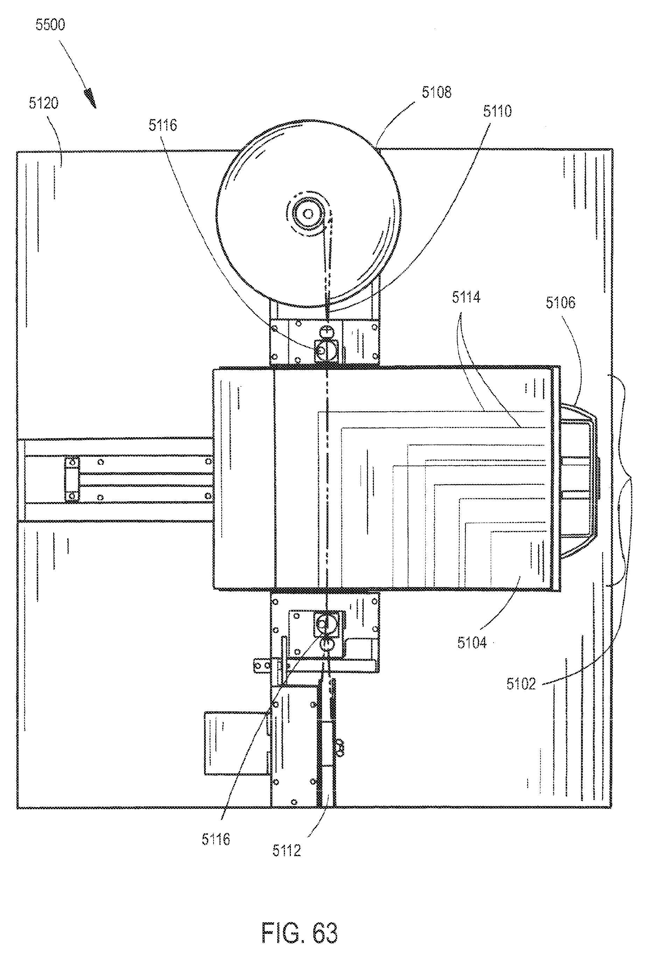

Referring now generally to FIGS. 59-63, an apparatus 5100 for separating laminated substrates is described. Laminated displays are generally constructed for deployment within potentially harsh environments. Features of these harsh environments are high and low ambient temperatures, dust, moisture, vibration, shock and the inevitable risk of abuse by users who are operating under pressure-packed conditions. These challenges can be especially difficult when designing the displays that provide critical user interface functions and also are exposed to a risk of damage. Furthermore, a display may acquire defects during the lamination process or may be damaged by the manufacturer, shipper or user during handling.

When a laminated display has been damaged, the display generally must be discarded and no component parts of the display may be re-utilized. This creates waste and increased expense in acquiring replacement laminated displays. Consequently, a system and method for separating laminated displays while minimizing the introduction of anomalies to the display is desired.

Apparatus 5100 may comprise a substantially planar assembly 5102, the substantially planar assembly 5102 comprising a plate assembly 5104 suitable for receiving a laminated substrate assembly and a guide assembly 5106 configured to guide the plate assembly 5104 in at least one direction, a cutting member housing assembly 5108 positioned on a first side of the substantially planar assembly 5102 suitable for containing an elongated cutting member 5110 and releasing an amount of the elongated cutting member 5110 and a cutting member receiving assembly 5112 positioned on a second side of the substantially planar assembly 5102, substantially opposite from the first side of the planar assembly 5102 suitable for receiving an amount of the elongated cutting member 5110. At least one of the cutting member housing assembly 5108 or the cutting member receiving assembly 5112 is configured to provide an amount of tension to the elongated cutting member 5110 as the elongated cutting member 5110 is released by the cutting member housing assembly 5108 or received by the cutting member receiving assembly 5112 and the elongated cutting member 5110 is configured to remove an amount of adhesive from an adhesive layer of the laminated substrate assembly positioned on the top surface of the plate assembly 5104 of the planar assembly 5102 as the amount of the elongated cutting member 5110 is transferred from the cutting member housing assembly 5108 to the cutting member receiving assembly 5112.

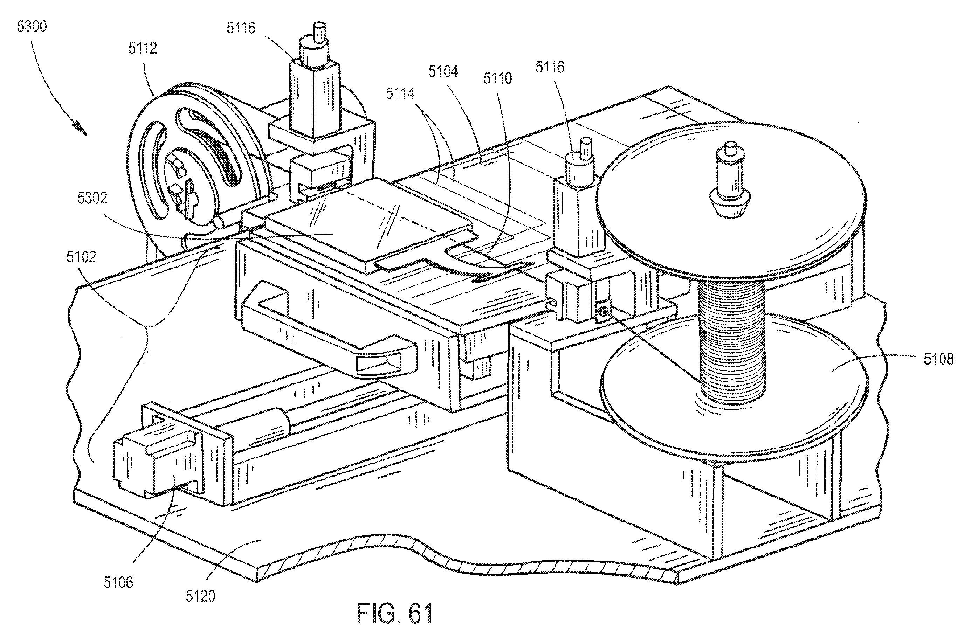

Referring to FIG. 61, an example of a laminated substrate assembly 302 is shown on an apparatus 5100 for separating a laminated substrate assembly. A "substrate" as used herein may further refer to any rigid or semi-rigid planar surface of glass, plastic, film, and/or metal coated with an adhesive. A laminated substrate assembly 302 may comprise an anti-reflective/anti-glare substrate, a touch panel, a glass substrate, a polarizing film substrate, an LCD, an electrode plane including a conductive coating (e.g., indium-tin oxide) substrate, another glass substrate, and/or another polarizing film substrate. Laminated substrate assembly 302 may be, for example, a conventional display comprising, for example, at least two substrates between which the liquid crystal material is disposed and a third substrate adhered to a top layer of the conventional display. Lines of electrodes may be patterned onto the first and second substrates. A third substrate may be an optically bonded safety/filter glass or touch screen. Adhesive layer may composed of pressure sensitive adhesive, or any adhesive that forms a bond when pressure is applied to marry the adhesive with the adherend. It is contemplated, however, that adhesive layer may be composed of a structural adhesive, i.e., any adhesive that hardens via processes such as evaporation of solvent or water (white glue), reaction with radiation (dental adhesives), chemical reaction (two part epoxy), or cooling, or any combination of structural and pressure sensitive adhesive. The adhesive layer may be composed of have a thickness, for example, from a range of about 20 microns to 3000 microns.

Pressure sensitive adhesive (PSA) may be any adhesive suitable for forming a bond when pressure is applied to engage the adhesive with the adherend. The pressure-sensitive adhesive may be a viscoelastic material utilized in this study, energy dissipation through large-scale bridging effects as well as time-dependent strain-rate effects must be considered.

In one embodiment, as illustrated in FIGS. 59-63, a plate assembly 5104 of the planar assembly 5102 may be a substantially horizontal surface (e.g., table top). However, it is contemplated that additional embodiments may include a planar assembly 5102 including a plate assembly 5104 that is substantially convexly or concavely curved (e.g., semispherical) or arced, may undulate (e.g., sinusoidally), may be configured to receive corner portions formed at any angle and/or may be customized to receive laminated substrate assemblies formed in any shape or abstract formation. Planar assembly 5102 may be composed substantially of metal, metal alloy, heat resistive plastic, ceramic, silicone or any other natural or synthetic material capable of forming a substantially smooth, flat surface. Planar assembly plate assembly 5104 may comprise at least one guide marker 5114 (e.g., a rectangular outline) formed on or imbedded into a top surface of the plate assembly 5104. Guide marker 5114 may provide placement or movement guidance for displays of known or predetermined size and shape. Plate assembly top surface may comprise a plurality of guide markers 5114 outlining a plurality of laminated substrate display sizes and/or shapes.

The plate assembly 5104 of the planar assembly 5102 may be configured to receive an amount of heat from a heat source. The heat source is a uniform heat source configured to uniformly heat a region of the plate assembly 5104 of the planar assembly 5102. For instance, the planar assembly 5102 may comprise a plurality of heating mechanisms configured provide substantially uniform heating of the plate assembly 5104 of the planar assembly 5102. A laminated substrate assembly 302 placed on the plate assembly 5104 of the planar assembly 5102 may receive heat from the heated plate assembly 5104. Heating of the plate assembly 5104 of the planar assembly 5102, and thus, the laminated substrate assembly 302 may be to a temperature not lower than the softening temperature of the adhesive utilized to bond the substrates.

Guide assembly 5106 may be a rail or post along which the plate assembly 5104 may glide or move along. Guide assembly 5106 may be manually operated or motorized as desired, and may provide substantially linear movement of the plate assembly 5104 of the planar assembly 5102. In additional embodiments, guide assembly 5106 may be configured to match the shape or path determined by the shape of the plate assembly 5104.

The elongated cutting member 5110 may be a wire or any other such cylindrical, flat and/or otherwise shaped, elongated string of drawn material such as metal, metal alloy, plastic, silicone or any other natural or synthetic material comprising an appropriate tensile strength and suitable to be elongated into string or wire form. The metals suitable for forming an elongated cutting member 5110 may include platinum, silver, iron, copper, aluminum and gold.

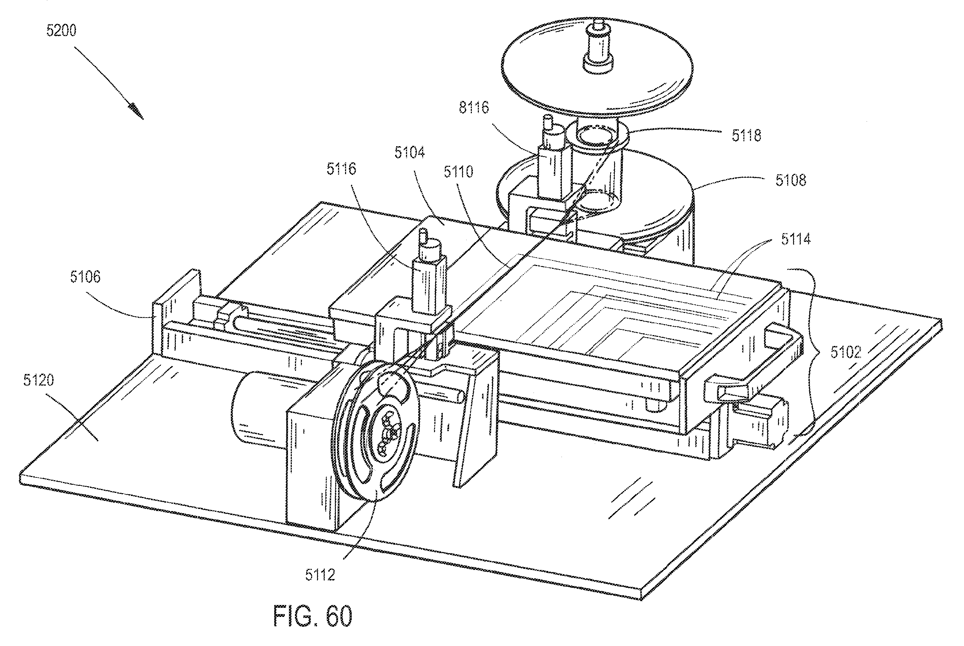

The cutting member housing assembly 5108 may be a first hub. In one embodiment, first hub may be substantially cylindrical. For instance, cutting member housing assembly 5108 may be a flanged cylinder, reel or other such housing for an amount of an elongated cutting member 5110 comprising a flange 5118 as shown in FIG. 60, or an unflanged cylinder, reel or other such housing for an amount of an elongated cutting member 5110 and on which the elongated cutting member 5110 may be wound. However, any shape may be utilized to form the first hub. According to at least one embodiment, at least a portion of the elongated cutting member 5110 may be wrapped substantially about the first hub. Cutting member housing assembly 5108 may be motorized or manually operated. Cutting member housing assembly 5108 may rotate along an axis to release an amount of the elongated cutting member 5110 as necessary to maintain elongated cutting member 5110 at a desired tautness.

The cutting member receiving assembly 5112 may be a second hub configured to receive at least a portion of the elongated cutting member 5110. In one embodiment, second hub may be substantially cylindrical. For instance, cutting member receiving assembly 5112 may be a flanged or unflanged cylinder or reel on which the elongated cutting member 5110 may be wound. However, any shape may be utilized to form the second hub. At least a portion of an elongated cutting member 5110 may be configured to wrap substantially about the second hub after at least a portion of the adhesive has been removed from the laminated substrate assembly 5302. Cutting member receiving assembly 5112 may be motorized or manually operated. Cutting member receiving assembly 5112 may rotate along an axis to receive an amount of the elongated cutting member 5110 as necessary to maintain elongated cutting member 5110 at a desired tautness.

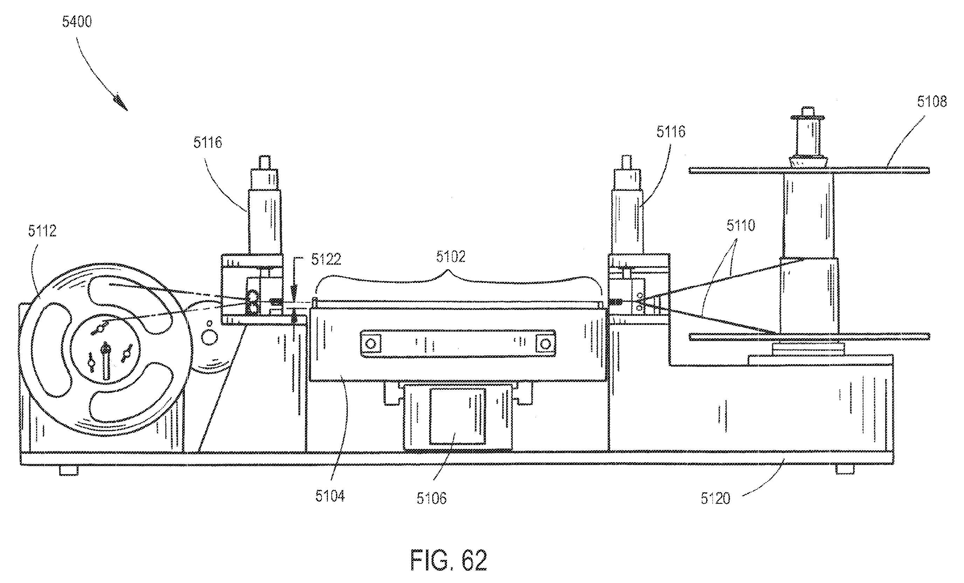

The apparatus 5100 may further comprise a calibration assembly 5116 configured to calibrate a zero point relative to a top surface of the plate assembly 5104 of the planar assembly 5102. It is contemplated that a laminated assembly adhesive joint may be at any height relative to a top surface of the plate assembly 5104 of the planar assembly 5102 when the laminated assembly 5302 (FIG. 61) is placed on the top surface of the plate assembly 5104 of the planar assembly 5102. A calibration assembly 5116 may be configured to mark the top surface of the plate assembly 5104 of the planar assembly 5102 as a zero distance point. Calibration assembly 5116 may also receive an input relating to a distance from the top surface of the plate assembly 5104 (e.g., the zero point) of the planar assembly 5102 to the adhesive layer of the laminated substrate assembly 5302. Distance input may be manually entered into, for example, a control of the calibration assembly 5116 via a keypad or other such device suitable for entering numeric values. The calibration assembly 5116 may also be connected to a database of known laminated substrate assembly thicknesses, including a thickness of any individual components of the laminated substrate assembly 5302. Calibration assembly 5116 may then determine a set point for the elongated cutting member 5110 above the top surface of the plate assembly 5104 of the planar assembly 5102. The set point may be, for example, at a distance above the zero point, designated by distance 5122 in FIG. 59 and FIG. 62, corresponding with the position of the adhesive layer of the laminated substrate assembly 5302 above the top surface of the plate assembly 5104 of the planar assembly 5102. Calibration assembly 5116 may be electrically connected to at least one of the cutting member housing assembly 5108 and the cutting member receiving assembly 5112, and thus may be comprised of at least two separate calibration components (each designated as 5116). Each of the calibration assembly 5116 components may raise or lower at least a portion of the elongated cutting member 5110. A database of known laminated substrate assembly component thicknesses may be utilized by the calibration assembly 5116 to determine a set point for the elongated cutting member 5110 at a distance above the zero point corresponding with the thickness of any laminated assembly components located below the adhesive layer of the laminated substrate assembly 5302 plus any additional amount as desired by an operator.

The apparatus 5100 may further comprise an edge assembly (not shown) configured to attach to a top surface of the plate assembly 5104 of the planar assembly 5102 and guide the laminated substrate in a direction substantially orthogonal to the elongated cutting member 5110. Edge assembly may facilitate the application of uniform force to the laminated substrate assembly 5302. For instance, as a laminated substrate assembly 5302 travels along the planar assembly 5102 in a direction orthogonal to the motion of the elongated cutting member 5110, the motion may be substantially uniform across the leading edge of the laminated substrate assembly 5302 by force applied to a trailing edge of the laminated substrate assembly via the edge assembly.

In an additional embodiment, apparatus 5100 may be configured to remove a vertically positioned display. For instance, a planar assembly may comprise a vertical stability assembly configured to apply an amount of pressure to at least two surfaces of a laminated substrate assembly 5302 to provide vertical stability for the laminated substrate assembly 5302. Cutting assembly may be configured to traverse through an adhesive layer while the laminated substrate assembly 5302 is vertically positioned and stationary. In this embodiment, a cutting member housing assembly and a cutting member receiving assembly may be as described above and with respect to FIGS. 59-63 configured to house and receive an elongated cutting member (e.g., a wire), and may further comprise a transport assembly configured to raise or lower the cutting member housing assembly and the cutting member receiving assembly as necessary to traverse through the laminated substrate along the adhesive layer. In some instances, transport assembly may be individually or simultaneously controlled. Transport mechanism may be manual, hydraulic, motorized or comprise any other functional elements necessary to provide movement of at least one of the cutting member housing assembly and/or the cutting member receiving assembly. Transport assembly may also comprise a controller configured to control at least one of speed, distance, elongated cutting member tension, or any other characteristics of the transport assembly. In a further additional embodiment, a planar assembly may comprise a groove or slot suitable for receiving an edge of a laminated substrate assembly 5302 to provide vertical stability. A calibration assembly may determine an initial position for the cutting assembly along an adhesive seam of a laminated substrate. Additionally, adhesive seam may be located manually, and cutting assembly may be positioned manually.

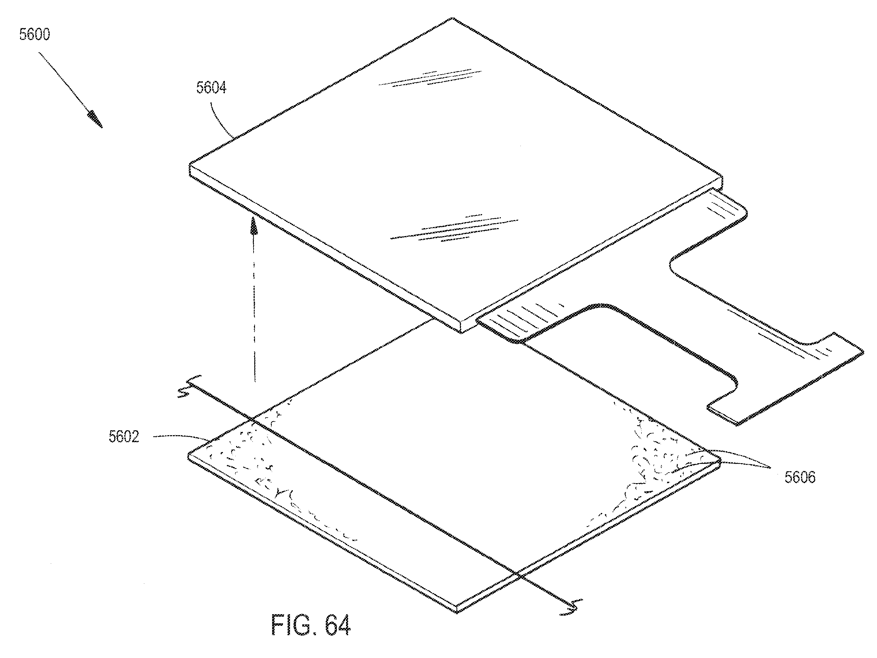

Referring to FIG. 64, an example of a delaminated substrate assembly 5600 that has been delaminated via apparatus 5100 is shown. Delaminated substrate assembly layers 5602, 5604, 5606 may be any rigid or semi-rigid planar surface of glass, plastic, film, metal, an anti-reflective/anti-glare substrate, a touch panel, a glass substrate, a polarizing film substrate, an LCD, an electrode plane including a conductive coating (e.g., indium-tin oxide) substrate, another glass substrate, and/or another polarizing film substrate. Substrate layers 5602, 5604 may be different materials, different shapes, different thickness, and/or different sizes. An adhesive layer 5606 may be substantially removed between at least two layers (e.g., 5602, 5604 of FIG. 64) of the delaminated laminated substrate assembly 5600. In some instances, at least a portion of an adhesive layer 5606 may remain after separation, as shown.

In additional embodiments, an amount of adhesive may be removed from one or more layers of the laminated substrate assembly 5302 upon separation. It is contemplated that one or more layers of the laminated substrate assembly 5302 may contain an amount of adhesive not removed by the elongated cutting member. Removal of adhesive may be accomplished with water, alcohol, solvent, or any other substance suitable for removing the adhesive from the substrate layer. The material utilized for cleaning the substrate layer may be selected from any appropriate cleaning materials.

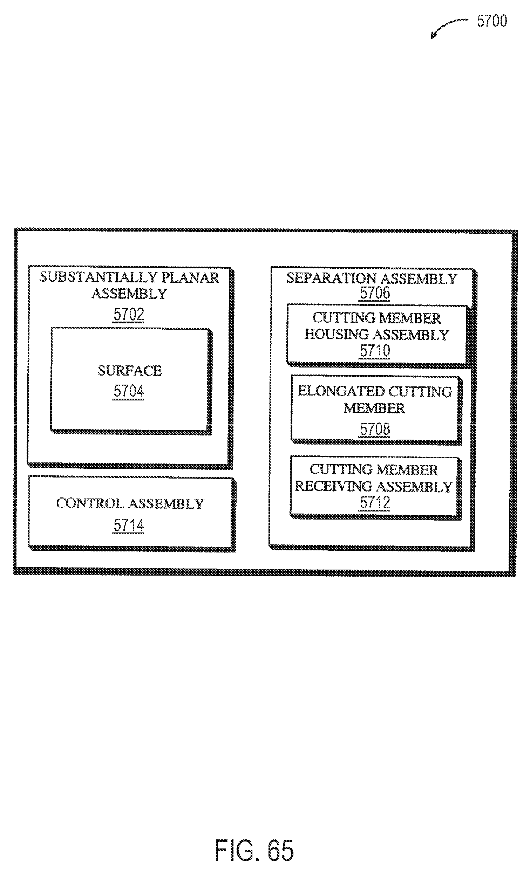

Referring to FIG. 65, a system 5700 for separating a laminated substrate assembly is shown. System 5700 may comprise a substantially planar assembly 5702. The substantially planar assembly may comprise a surface 5704 for receiving a laminated substrate assembly and a separation assembly 5706. The separation assembly 5706 may further comprise an elongated cutting member 5708, a cutting member housing assembly 5710 and a cutting member receiving assembly 5712 suitable for receiving the elongated cutting member. The cutting member housing assembly 5710 may be suitable for containing and releasing the elongated cutting member 5708 and the cutting member receiving assembly 5712 may be suitable for receiving the elongated cutting member 5708. System 5700 may further comprise a control assembly 5714 for controlling the separation assembly 5704.

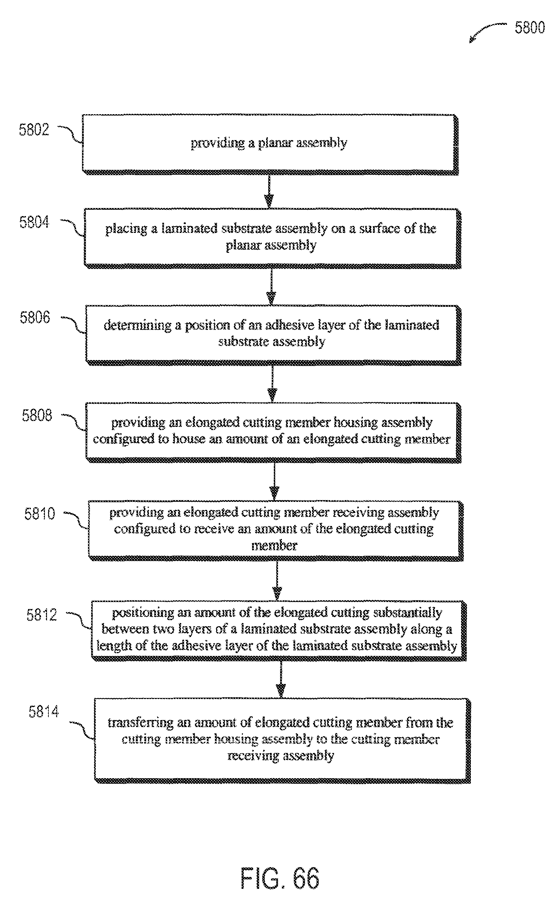

Referring to FIG. 66, a method 5800 for separating a laminated substrate assembly is shown. Method 5800 may comprise providing a planar assembly 5802 and placing a laminated substrate assembly on a surface of the planar assembly 5804. Method 5800 may also comprise determining a position of an adhesive layer of the laminated substrate assembly 5806. Method may further comprise providing an elongated cutting member housing assembly configured to house an amount of an elongated cutting member 5808 and providing an elongated cutting member receiving assembly configured to receive an amount of the elongated cutting member 5810. Method may comprise positioning an amount of the elongated cutting substantially between two layers of a laminated substrate assembly along a length of the adhesive layer of the laminated substrate assembly 5812 and transferring an amount of elongated cutting member from the cutting member housing assembly to the cutting member receiving assembly 5814. Transfer may be accomplished by rotating at least one of the cutting member housing assembly or the cutting member receiving assembly. Such rotation may draw the elongated cutting member along the length of the adhesive layer. The amount of elongated cutting member is configured to remove at least a portion of an adhesive as the amount of elongated cutting member is transferred from the cutting member housing assembly to the cutting member receiving assembly.

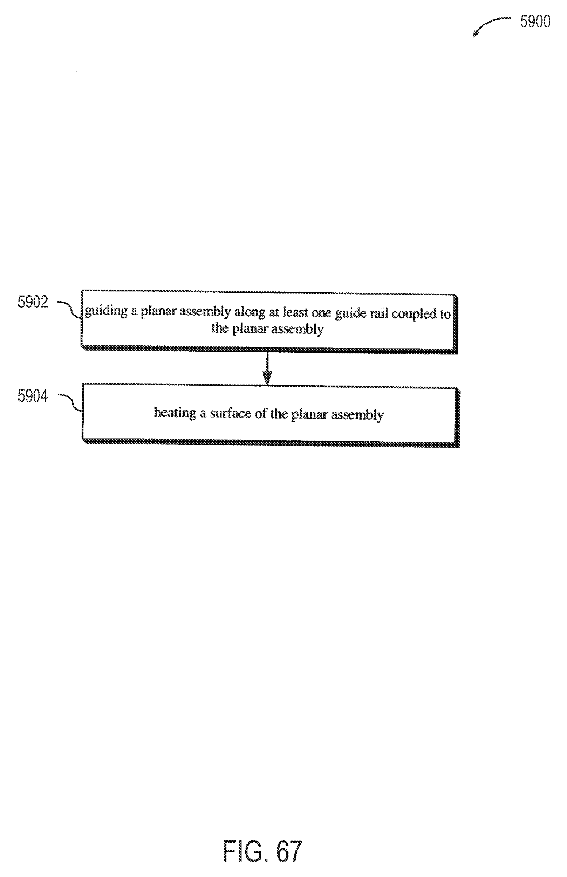

Referring to FIG. 67, a flow diagram representing an additional method 5900 for separating a laminated substrate assembly is shown. Method 5900 may comprise guiding a planar assembly along at least one guide rail coupled to the planar assembly 5902 and heating a surface of the planar assembly 5904. Heating of a surface of the planar assembly may occur before, during or after the laminated substrate assembly has been placed on the surface of the planar assembly 5904. Method may be implemented with method 5800 and one or more steps of method 5900 may be implemented before or after any step of method 5800.

Systems and apparatuses in accordance with various embodiments disclosed herein provide a system and method for laminating substrates and/or dissembling laminated substrates. In this regard, the various embodiments may be described herein in terms of functional block components and various processing steps. It should be appreciated that such functional blocks may be realized by any number of hardware, firmware, and/or software components configured to perform the specified functions. For example, certain embodiments may employ various integrated circuit components, e.g., memory elements, digital signal processing elements, look-up tables, and the like, which may carry out a variety of functions under the control of one or more microprocessors or other control devices. Such general techniques and components that are known to those skilled in the art are not described in detail herein. Furthermore, although the subject matter of the present disclosure is frequently described herein as pertaining to displays composed of one or more substrates, it will be appreciated that the systems and methods described herein could also be applied to any substrates adhered with any adhesive including, but not limited to, a pressure sensitive adhesive.

The methods disclosed may be implemented as sets of instructions, through a single production device, and/or through multiple production devices. Further, it is understood that the specific order or hierarchy of steps in the methods disclosed are examples of exemplary approaches. Based upon design preferences, it is understood that the specific order or hierarchy of steps in the method can be rearranged while remaining within the scope and spirit of the disclosure. The accompanying method claims present elements of the various steps in a sample order, and are not necessarily meant to be limited to the specific order or hierarchy presented.

Various embodiments include one or more techniques described below relating to separating laminated substrates. Each of these techniques may be implemented using standard user interface techniques, such as standard graphical software programming or the like. Of course any programming language or environment could be used to implement the techniques described herein. Furthermore, the foregoing described embodiments may be conveniently implemented using conventional general purpose digital computers programmed according to the teachings of the present specification, as will be apparent to those skilled in the computer art. Appropriate software coding may readily be prepared by skilled programmers based on the teachings of the present disclosure, as will be apparent to those skilled in the software art.

It is believed that the subject matter disclosed herein and many of its attendant advantages will be understood by the foregoing description, and it will be apparent that various changes may be made in the form, construction, and arrangement of the components thereof without departing from the scope and spirit of this disclosure or without sacrificing all of its material advantages. The form herein before described being merely an explanatory embodiment thereof, it is the intention of the following claims to encompass and include such changes.

It is to be understood that the subject matter disclosed herein may be conveniently implemented in forms of a software package. Such a software package may be a computer program product which employs a computer-readable storage medium including stored computer code which is used to program a computer to perform the disclosed function and process of the present invention. The computer-readable medium may include, but is not limited to, any type of conventional floppy disk, optical disk, CD-ROM, magnetic disk, hard disk drive, magneto-optical disk, ROM, RAM, EPROM, EEPROM, magnetic or optical card, or any other suitable media for storing electronic instructions.

## Claims

1. A process for laminating substrates, the process comprising the steps:
disposing (902) a sheet (103) of pressure-sensitive adhesive between a substantially planar surface of a first rigid substrate (101) and a substantially planar surface of a second rigid substrate (102);
disposing (820) the first substrate (101), pressure-sensitive adhesive layer (103) and second substrate (102) within a vacuum chamber (110);
disposing a mask member (150) within the vacuum chamber (110) with the first and second substrates (101, 102) over at least a portion of one of the first substrate (101) and the second substrate (102) to prevent contact between the portion and a flexible membrane (120);
evacuating (830) the vacuum chamber (110);
applying (840) pressure to at least one of the first substrate (101) and the second substrate (102) by expanding the flexible membrane (120);
wherein the first substrate (101) comprises a display monitor.

2. The process of claim 1, wherein the disposing the first substrate (101), pressure-sensitive adhesive layer (103) and second substrate (102) within a vacuum chamber (110) further comprises:
co-aligning (1002) a portion of the first substrate (101) with a portion of the second substrate (102) using an alignment insert (140).

3. The process of claim 1, wherein the disposing the first substrate (101), pressure-sensitive adhesive layer (103) and second substrate (102) within a vacuum chamber (110) further comprises:
maintaining (1102) at least a portion of at least one of the first substrate (101) and second substrate (102) in spatial separation from the pressure-sensitive adhesive layer (103).

4. The process of claim 3, wherein the maintaining at least a portion of at least one of the first substrate (101) and second substrate (102) in spatial separation from the pressure-sensitive adhesive layer (103) further comprises:
supporting (1104) at least one of the first substrate (101) and the second substrate (102) on a support pin (131).

5. The process of claim 4, wherein the supporting at least one of the first substrate (101) and the second substrate (102) on a support pin (131) further comprises:
supporting (1106) the at least one of the first substrate (101) and the second substrate (102) on a retractable support pin (131).

6. The process of claim 3, wherein the maintaining at least a portion of at least one of the first substrate (101) and second substrate (102) in spatial separation from the pressure-sensitive adhesive layer (103) further comprises:
supporting (1202) at least one of the first substrate (101) and the second substrate (102) on a deformable support (130).

7. The process of claim 3, wherein the maintaining at least a portion of at least one of the first substrate (101) and second substrate (102) in spatial separation from the pressure-sensitive adhesive layer (103) further comprises:
supporting (1204) at least one of the first substrate (101) and the second substrate (102) on an electromagnetic support (130).

8. The process of any of the preceding claims, wherein the evacuating the vacuum chamber (110) further comprises:
evacuating (1302) a first portion (121) of the vacuum chamber (110) to a first pressure; and
evacuating (1304) a second portion (122) of the vacuum chamber (110) to a second pressure.

9. The process of any of the preceding claims, wherein the applying pressure to at least one of the first substrate (101) and the second substrate (102) further comprises:
expanding (1402) the flexible membrane (120) by the application of pressure to a surface of the flexible membrane.

10. The process of claim 9, wherein the expanding the flexible membrane (120) by the application of pressure to a surface of the flexible membrane further comprises:
expanding (1404) the flexible membrane (120) by the application of air pressure to a surface of the flexible membrane.

11. The process of any of the preceding claims, further comprising:
heating (1710) at least one of the first substrate (101), pressure-sensitive adhesive layer (103), and second substrate (102).

12. The process of claim 11, further comprising:
pressurizing (1720) an environment containing the first substrate (101), pressure-sensitive adhesive layer (103), and second substrate (102).

13. The process of any of the preceding claims, further comprising:
contacting (1610) at least one of the substantially planar surface of the first substrate (101) and the substantially planar surface of the second substrate (102) to the pressure-sensitive adhesive layer (103).

14. The process of claim 13, wherein the contacting at least one of the substantially planar surface of the first substrate (101) and the substantially planar surface of the second substrate (102) to the pressure-sensitive adhesive layer (103) further comprises:
retracting (1612) a support pin (131).

## Patentansprüche

1. Verfahren zum Laminieren von Substraten, wobei das Verfahren die folgenden Schritte aufweist:
Anordnen (902) einer Schicht (103) Haftklebstoff zwischen einer im Wesentlichen ebenen Oberfläche eines ersten starren Substrats (101) und einer im Wesentlichen ebenen Oberfläche eines zweiten starren Substrats (102),
Anordnen (820) des ersten Substrats (101), des Haftklebstoffschicht (103) und des zweiten Substrats (102) in einer Vakuumkammer (110),
Anordnen eines Maskenelements (150) in der Vakuumkammer (110) dem ersten und dem zweiten Substrat (101, 102) über zumindest einem Teil von einem von dem ersten Substrat (101) und dem zweiten Substrat (102), um einen Kontakt zwischen dem Teil und einer flexiblen Membran (120) zu verhindern,
Evakuieren (830) der Vakuumkammer (110),
Ausüben (840) von Druck auf zumindest eines von dem ersten Substrat (101) und dem zweiten Substrat (102) durch Expandieren der flexiblen Membran (120),
wobei das erste Substrat (101) einen Anzeigemonitor aufweist.

2. Verfahren nach Anspruch 1, bei dem das Anordnen des ersten Substrats (101), des Haftklebstoffschicht (103) und des zweiten Substrats (102) in einer Vakuumkammer (110) ferner aufweist:
Ausrichten (1002) eines Teils des ersten Substrats (101) mit einem Teil des zweiten Substrats (102) unter Verwendung eines Ausrichteinsatzes (140).

3. Verfahren nach Anspruch 1, bei dem das Anordnen des ersten Substrats (101), des Haftklebstoffschicht (103) und des zweiten Substrats (102) in einer Vakuumkammer (110) ferner aufweist:
Halten (1102) von zumindest einem Teil von einem von dem ersten Substrat (101) und dem zweiten Substrat (102) in räumlicher Trennung von der Haftklebstoffschicht (103).

4. Verfahren nach Anspruch 3, bei dem das Halten von zumindest einem Teil von einem von dem ersten Substrat (101) und dem zweiten Substrat (102) in räumlicher Trennung von der Haftklebstoffschicht (103) ferner aufweist:
Abstützen (1104) von zumindest einem von dem ersten Substrat (101) und dem zweiten Substrat (102) an einem Abstützstift (131).

5. Verfahren nach Anspruch 4, bei dem das Abstützen von zumindest einem von dem ersten Substrat (101) und dem zweiten Substrat (102) an einem Abstützstift (131) ferner aufweist:
Abstützen (1106) von zumindest einem von dem ersten Substrat (101) und dem zweiten Substrat (102) an einem zurückziehbaren Abstützstift (131).

6. Verfahren nach Anspruch 3, bei dem das Halten von zumindest einem Teil von einem von dem ersten Substrat (101) und dem zweiten Substrat (102) in räumlicher Trennung von der Haftklebstoffschicht (103) ferner aufweist:
Abstützen (1202) von zumindest einem von dem ersten Substrat (101) und dem zweiten Substrat (102) an einer verformbaren Abstützeinrichtung (130).

7. Verfahren nach Anspruch 3, bei dem das Halten von zumindest einem Teil von einem von dem ersten Substrat (101) und dem zweiten Substrat (102) in räumlicher Trennung von der Haftklebstoffschicht (103) ferner aufweist:
Abstützen (1204) von zumindest einem von dem ersten Substrat (101) und dem zweiten Substrat (102) an einer elektromagnetischen Abstützeinrichtung (130).

8. Verfahren nach einem der vorhergehenden Ansprüche, bei dem das Evakuieren der Vakuumkammer (110) ferner aufweist:
Evakuieren (1302) eines ersten Teils (121) der Vakuumkammer (110) auf einen ersten Druck und
Evakuieren (1304) eines zweiten Teils (122) der Vakuumkammer (110) auf einen zweiten Druck.

9. Verfahren nach einem der vorhergehenden Ansprüche, bei dem das Ausüben von Druck auf zumindest eines von dem ersten Substrat (101) und dem zweiten Substrat (102) ferner aufweist:
Expandieren (1402) der flexiblen Membran (120) durch Ausüben von Druck auf eine Oberfläche der flexiblen Membran.

10. Verfahren nach Anspruch 9, bei dem das Expandieren der flexiblen Membran (120) durch Ausüben von Druck auf eine Oberfläche der flexiblen Membran ferner aufweist:
Expandieren (1404) der flexiblen Membran (120) durch Ausüben von Luftdruck auf eine Oberfläche der flexiblen Membran.

11. Verfahren nach einem der vorhergehenden Ansprüche, das ferner aufweist:
Erwärmen (1710) von zumindest einem bzw. einer von dem ersten Substrat (101), der Haftklebstoffschicht (103) und dem zweiten Substrat (102).

12. Verfahren nach Anspruch 11, das ferner aufweist:
Setzen (1720) einer Umgebung unter Druck, die das erste Substrat (101), die Haftklebstoffschicht (103) und das zweite Substrat (102) enthält.

13. Verfahren nach einem der vorhergehenden Ansprüche, das ferner aufweist:
Inkontaktbringen (1610) von zumindest einer von der im Wesentlichen ebenen Oberfläche des ersten Substrats (101) und der im Wesentlichen ebenen Oberfläche des zweiten Substrats (102) mit der Haftklebstoffschicht (103).

14. Verfahren nach Anspruch 13, bei dem das Inkontaktbringen von zumindest einer von der im Wesentlichen ebenen Oberfläche des ersten Substrats (101) und der im Wesentlichen ebenen Oberfläche des zweiten Substrats (102) mit der Haftklebstoffschicht (103)ferner aufweist:
Zurückziehen (1612) eines Abstützstiftes (131).

## Revendications

1. Procédé pour déposer des substrats en couche, le procédé comprenant les étapes consistant à :
disposer (902) une feuille (103) d'adhésif sensible à la pression entre une surface sensiblement plane d'un premier substrat rigide (101) et une surface sensiblement plane d'un second substrat rigide (102) ;
disposer (820) le premier substrat (101), la couche d'adhésif sensible à la pression (103) et le second substrat (102) à l'intérieur d'une chambre à vide (110) ;
disposer un élément de masque (150) à l'intérieur de la chambre à vide (110) avec les premier et second substrats (101,102) sur au moins une partie de l'un parmi le premier substrat (101) et le second substrat (102) pour empêcher le contact entre la partie et une membrane souple (120) ;
mettre sous vide (830) la chambre à vide (110) ;
appliquer (840) la pression sur au moins l'un parmi le premier substrat (101) et le second substrat (102) en faisant subir une expansion à la membrane souple (120) ;
dans lequel le premier substrat (101) comprend un écran d'affichage.

2. Procédé selon la revendication 1, dans lequel l'étape consistant à disposer le premier substrat (101), la couche d'adhésif sensible à la pression (103) et le second substrat (102) à l'intérieur d'une chambre à vide (110) comprend en outre l'étape consistant à :
co-aligner (1002) une partie du premier substrat (101) avec une partie du second substrat (102) en utilisant un insert d'alignement (140).

3. Procédé selon la revendication 1, dans lequel l'étape consistant à disposer le premier substrat (101), la couche d'adhésif sensible à la pression (103) et le second substrat (102) à l'intérieur d'une chambre à vide (110) comprend en outre l'étape consistant à :
maintenir (1102) au moins une partie d'au moins l'un parmi le premier substrat (101) et le second substrat (102) en séparation spatiale par rapport à la couche d'adhésif sensible à la pression (103).

4. Procédé selon la revendication 3, dans lequel l'étape consistant à maintenir au moins une partie d'au moins l'un parmi le premier substrat (101) et le second substrat (102) en séparation spatiale par rapport à la couche d'adhésif sensible à la pression (103) comprend en outre l'étape consistant à :
supporter (1104) au moins l'un parmi le premier substrat (101) et le second substrat (102) sur une broche de support (131).

5. Procédé selon la revendication 4, dans lequel l'étape consistant à supporter au moins l'un parmi le premier substrat (101) et le second substrat (102) sur une broche de support (131) comprend en outre l'étape consistant à :
supporter (1106) le au moins un parmi le premier substrat (101) et le second substrat (102) sur une broche de support rétractable (131).

6. Procédé selon la revendication 3, dans lequel l'étape consistant à maintenir au moins une partie d'au moins l'un parmi le premier substrat (101) et le second substrat (102) en séparation spatiale par rapport à la couche d'adhésif sensible à la pression (103) comprend en outre l'étape consistant à :
supporter (1202) au moins l'un parmi le premier substrat (101) et le second substrat (102) sur un support déformable (130).

7. Procédé selon la revendication 3, dans lequel l'étape consistant à maintenir au moins une partie d'au moins l'un parmi le premier substrat (101) et le second substrat (102) en séparation spatiale par rapport à la couche d'adhésif sensible à la pression (103) comprend en outre l'étape consistant à :
supporter (1204) au moins l'un parmi le premier substrat (101) et le second substrat (102) sur un support électromagnétique (130).

8. Procédé selon l'une quelconque des revendications précédentes, dans lequel l'étape consistant à mettre sous vide la chambre de vide (110) comprend en outre l'étape consistant à :
mettre sous vide (1302) une première partie (121) de la chambre à vide (110) à une première pression ; et
mettre sous vide (1304) une seconde partie (122) de la chambre à vide (110) à une seconde pression.

9. Procédé selon l'une quelconque des revendications précédentes, dans lequel l'étape consistant à appliquer la pression sur au moins l'un parmi le premier substrat (101) et le second substrat (102) comprend en outre l'étape consistant à :
faire subir une expansion (1402) à la membrane souple (120) par l'application de pression sur une surface de la membrane souple.

10. Procédé selon la revendication 9, dans lequel l'étape consistant à faire subir une expansion à la membrane souple (120) par l'application de pression sur une surface de la membrane souple comprend en outre l'étape consistant à :
faire subir une expansion (1404) à la membrane souple (120) par l'application de pression d'air sur une surface de la membrane souple.

11. Procédé selon l'une quelconque des revendications précédentes, comprenant en outre l'étape consistant à :
faire chauffer (1710) au moins l'un parmi le premier substrat (101), la couche d'adhésif sensible à la pression (103) et un second substrat (102).

12. Procédé selon la revendication 11, comprenant en outre l'étape consistant à :
mettre sous pression (1720) un environnement contenant le premier substrat (101), la couche d'adhésif sensible à la pression (103) et le second substrat (102).

13. Procédé selon l'une quelconque des revendications précédentes, comprenant en outre l'étape consistant à :
mettre en contact (1610) au moins l'une parmi la surface sensiblement plane du premier substrat (101) et la surface sensiblement plane du second substrat (102) avec la couche d'adhésif sensible à la pression (103).

14. Procédé selon la revendication 13, dans lequel l'étape consistant à mettre en contact au moins l'une parmi la surface sensiblement plane du premier substrat (101) et la surface sensiblement plane du second substrat (102) avec la couche d'adhésif sensible à la pression (103) comprend en outre l'étape consistant à :
rétracter (1612) une broche de support (131).
